# EUROPEAN PATENT APPLICATION

(11) **EP 3 451 059 A1**
(43) Date of publication of application: **06.03.2019**
(21) Application number: 17789732.9
(22) Date of filing: 28.04.2017
(51) Int. Cl.: G03F 7/11, C08G 8/04, G03F 7/26, H01L 21/027

(54) **COMPOSITION FOR FORMING RESIST UNDERLAYER FILM, UNDERLAYER FILM FOR LITHOGRAPHY, AND PATTERN-FORMING METHOD**

(30) Priority: 28.04.2016 JP 2016091797
(71) Applicant: Mitsubishi Gas Chemical Company, Inc., Tokyo 100-8324 (JP)
(72) Inventor: TOIDA, Takumi, Hiratsuka-shi Kanagawa 254-0016 (JP); MAKINOSHIMA, Takashi, Hiratsuka-shi Kanagawa 254-0016 (JP); SATO, Takashi, Hiratsuka-shi Kanagawa 254-0016 (JP); ECHIGO, Masatoshi, Tokyo 100-8324 (JP)
(74) Representative: Müller-Boré & Partner Patentanwälte PartG mbB
(86) International application number: PCT/JP2017/017091
(87) International publication number: WO 2017/188451

(57) **Abstract**

The present invention provides a composition for resist underlayer film formation comprising a tellurium-containing compound or a tellurium-containing resin.

## Description

### Technical Field

The present invention relates to a composition for resist underlayer film formation containing a compound and a resin having a specific structure, a resist underlayer film for lithography obtained from the composition, and a pattern formation method using the composition.

### Background Art

In the production of semiconductor devices, fine processing is practiced by lithography using photoresist materials. In recent years, further miniaturization based on pattern rules has been demanded along with increase in the integration and speed of LSI. Lithography using light exposure, which is currently used as a general purpose technique is approaching the limit of essential resolution derived from the wavelength of a light source.

The light source for lithography used upon forming resist patterns has been shifted to ArF excimer laser (193 nm) having a shorter wavelength from KrF excimer laser (248 nm). However, as the miniaturization of resist patterns proceeds, the problem of resolution or the problem of collapse of resist patterns after development arises. Against this backdrop, in recent years, resists have been desired to have a thinner film. However, if resists merely have a thinner film, it is difficult to obtain the film thicknesses of resist patterns sufficient for substrate processing. Therefore, there has been a need for a process of making a resist underlayer film between a resist and a semiconductor substrate to be processed, and imparting functions as a mask for substrate processing to this resist underlayer film in addition to a resist pattern.

Various resist underlayer films for such a process are currently known. For example, in order to achieve a resist underlayer film for lithography having the selectivity of a dry etching rate close to that of resists, unlike conventional resist underlayer films having a fast etching rate, an underlayer film forming material for a multilayer resist process containing a resin component having at least a substituent group that generates a sulfonic acid residue by eliminating a terminal group through the application of predetermined energy, and a solvent has been proposed (see, for example, Patent Literature 1). Also, in order to achieve a resist underlayer film for lithography having the selectivity of a dry etching rate smaller than that of resists, a resist underlayer film material comprising a polymer having a specific repeat unit has been proposed (see, for example, Patent Literature 2). Furthermore, in order to achieve a resist underlayer film for lithography having the selectivity of a dry etching rate smaller than that of semiconductor substrates, a resist underlayer film material comprising a polymer prepared by copolymerizing a repeat unit of an acenaphthylene and a repeat unit having a substituted or unsubstituted hydroxy group has been proposed (see, for example, Patent Literature 3).

Meanwhile, amorphous carbon underlayer films formed by CVD (chemical vapor deposition) using methane gas, ethane gas, acetylene gas, or the like as a raw material are well known as materials having high etching resistance for this kind of resist underlayer film. For such an amorphous carbon underlayer film, resist underlayer film materials that can form resist underlayer films by a wet process such as spin coating or screen printing have been demanded from the viewpoint of a process.

In addition, a resist underlayer film forming composition for lithography containing a naphthalene formaldehyde polymer comprising a specific constitutional unit, and an organic solvent has been proposed as a material that is excellent in optical properties and etching resistance and is also soluble in a solvent and applicable to a wet process (see, for example, Patent Literatures 4 and 5).

As for methods for forming an intermediate layer for use in the formation of a resist underlayer film in a three-layer process, for example, a method for forming a silicon nitride film (see Patent Literature 6) and a CVD formation method for a silicon nitride film (see Patent Literature 7) are known. Also, materials comprising a silsesquioxane based silicon compound are known as intermediate layer materials for a three-layer process (see Patent Literatures 8 and 9).

### Citation List

### Patent Literature

Patent Literature 1: Japanese Patent Application Laid-Open No. 2004-177668
Patent Literature 2: Japanese Patent Application Laid-Open No. 2004-271838
Patent Literature 3: Japanese Patent Application Laid-Open No. 2005-250434
Patent Literature 4: International Publication No. WO 2009/072465
Patent Literature 5: International Publication No. WO 2011/034062
Patent Literature 6: Japanese Patent Application Laid-Open No. 2002-334869
Patent Literature 7: International Publication No. WO 2004/066377
Patent Literature 8: Japanese Patent Application Laid-Open No. 2007-226170
Patent Literature 9: Japanese Patent Application Laid-Open No. 2007-226204

### Summary of Invention

### Technical Problem

For use in a wet process such as spin coating or screen printing, compositions for resist underlayer film formation are required to have high solvent solubility applicable to these processes. On the other hand, the compositions for resist underlayer film formation are desired to have not only solvent solubility but have excellent heat resistance or etching resistance. However, as mentioned above, a large number of compositions for resist underlayer film formation have heretofore been proposed for use in lithography. However, none of these materials not only have high solvent solubility that permits application of a wet process such as spin coating or screen printing but achieve both of heat resistance and etching resistance at high dimensions. Thus, the development of novel materials is demanded.

As the miniaturization of patterns has progressed in recent years, there has been a demand for step filling properties that allow the steps of an uneven substrate (particularly having fine space, hole pattern, etc.) to be filled thoroughly and uniformly, and the smoothness of formed films. This demand is particularly high for resist layers (resist underlayer films) to be disposed on the substrate side.

An object of the present invention is to solve the above problems and to provide a composition for resist underlayer film formation which is applicable to a wet process and is useful for forming a photoresist underlayer film excellent in heat resistance, etching resistance, filling properties for uneven substrates and film smoothness, a resist underlayer film for lithography obtained from the composition, and a pattern formation method using the composition.

### Solution to Problem

The inventors have, as a result of devoted examinations to solve the above problems, found out that the above problems can be solved by using a compound and a resin having a specific structure in a composition for an underlayer film, and reached the present invention. More specifically, the present invention is as follows.
<1> A composition for resist underlayer film formation comprising a tellurium-containing compound or a tellurium-containing resin.
<2> The composition for resist underlayer film formation according to <1>, wherein the tellurium-containing compound is represented by the following formula (A-1): 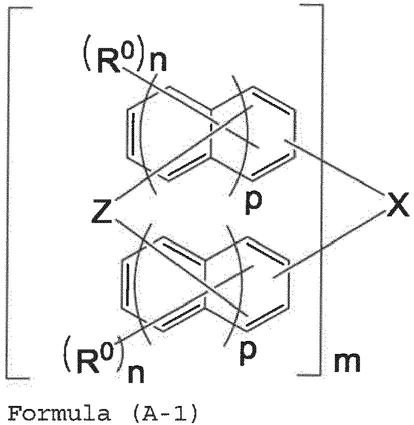 wherein X is a 2m-valent group of 0 to 60 carbon atoms containing tellurium; Z is an oxygen atom, a sulfur atom, or a non-crosslinked state; each R⁰ is independently a monovalent group containing an oxygen atom, a monovalent group containing a sulfur atom, a monovalent group containing a nitrogen atom, a hydrocarbon group, or a halogen atom; m is an integer of 1 to 4; each p is independently an integer of 0 to 2; and each n is independently an integer of 0 to (5 + 2 × p).
<3> The composition for resist underlayer film formation according to <2>, wherein the tellurium-containing compound is represented by the following formula (A-2): 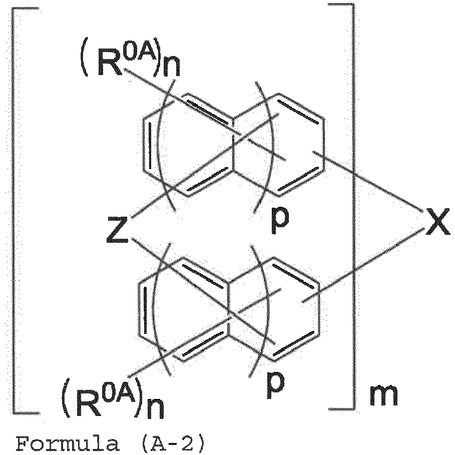 wherein X is a 2m-valent group of 0 to 60 carbon atoms containing tellurium; Z is an oxygen atom, a sulfur atom, a single bond, or a non-crosslinked state; each R^{0A} is independently selected from the group consisting of a hydrocarbon group, a halogen atom, a cyano group, a nitro group, an amino group, an alkyl group of 1 to 30 carbon atoms, an alkenyl group of 2 to 30 carbon atoms, an aryl group of 6 to 40 carbon atoms, a hydroxy group or a group in which a hydrogen atom of a hydroxy group is substituted with an acid crosslinking reactive group or an acid dissociation reactive group, and a combination thereof, wherein the alkyl group, the alkenyl group, and the aryl group each optionally have an ether bond, a ketone bond, or an ester bond; m is an integer of 1 to 4; each p is independently an integer of 0 to 2; and each n is independently an integer of 0 to (5 + 2 × p).
<4> The composition for resist underlayer film formation according to <2>, wherein the tellurium-containing compound is represented by the following formula (A-3): 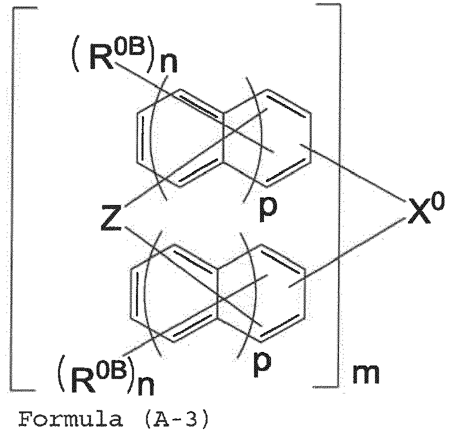 wherein X⁰ is a 2m-valent group of 0 to 30 carbon atoms containing tellurium; Z is an oxygen atom, a sulfur atom, or a non-crosslinked state; each R^{0B} is independently a monovalent group containing an oxygen atom, a monovalent group containing a sulfur atom, a monovalent group containing a nitrogen atom, a hydrocarbon group, or a halogen atom; m is an integer of 1 to 4; each p is independently an integer of 0 to 2; and each n is independently an integer of 0 to (5 + 2 × p).
<5> The composition for resist underlayer film formation according to <2>, wherein the tellurium-containing compound is represented by the following formula (1A): 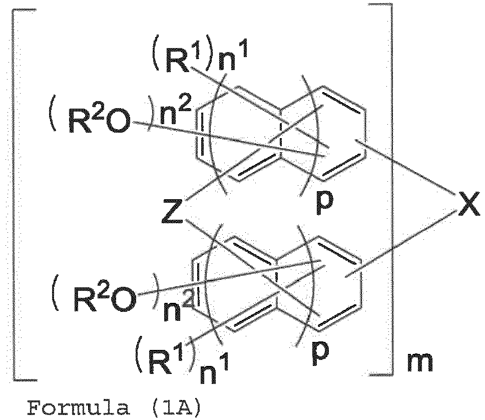 wherein X, Z, m, and p are as defined in the above formula (A-1); each R¹ is independently an alkyl group, an aryl group, an alkenyl group, or a halogen atom; each R² is independently a hydrogen atom or an acid dissociation reactive group; each n¹ is independently an integer of 0 to (5 + 2 × p) ; and each n² is independently an integer of 0 to (5 + 2 × p), provided that at least one n² is an integer of 1 to (5 + 2 × p).
<6> The composition for resist underlayer film formation according to <4>, wherein the tellurium-containing compound is represented by the following formula (1B): 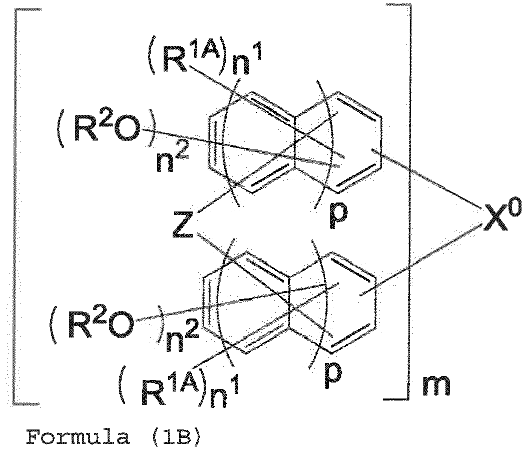 wherein X⁰, Z, m, and p are as defined in the above formula (A-3); each R^{1A} is independently an alkyl group, an aryl group, an alkenyl group, or a halogen atom; each R² is independently a hydrogen atom, an acid crosslinking reactive group, or an acid dissociation reactive group; each n¹ is independently an integer of 0 to (5 + 2 × p); and each n² is independently an integer of 0 to (5 + 2 × p), provided that at least one n² is an integer of 1 to (5 + 2 × p) .
<7> The composition for resist underlayer film formation according to <6>, wherein the tellurium-containing compound is represented by the following formula (2A): 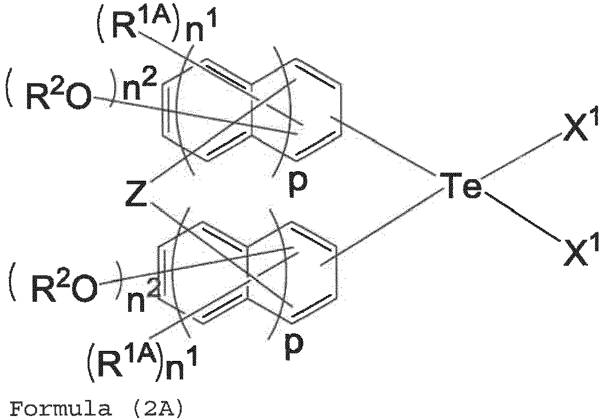 wherein Z, R^{1A}, R², p, n¹, and n² are as defined in the above formula (1B) ; and each X¹ is independently a monovalent group containing an oxygen atom, a monovalent group containing a sulfur atom, a monovalent group containing a nitrogen atom, a hydrocarbon group, a hydrogen atom, or a halogen atom.
<8> The composition for resist underlayer film formation according to <7>, wherein the tellurium-containing compound is represented by the following formula (2A'): 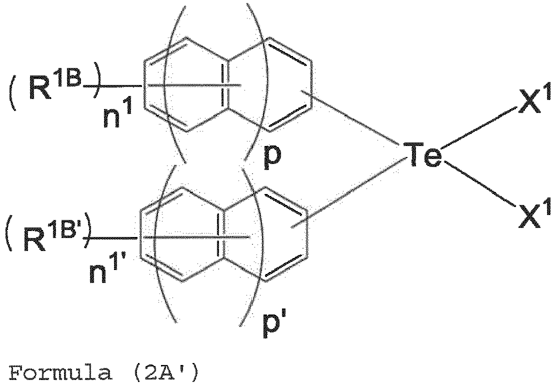 wherein R^{1B} and R^{1B'} are each independently an alkyl group, an aryl group, an alkenyl group, a halogen atom, a hydroxy group or a group in which a hydrogen atom of a hydroxy group is substituted with an acid crosslinking reactive group or an acid dissociation reactive group; X¹ is as defined as X¹ in the above formula (2A) ; n¹ and n^{1'} are as defined as n¹ in the above formula (2A) ; p and p' are as defined as p in the above formula (2A); and members in at least one combination selected from R^{1B} and R^{1B'}, n¹ and n^{1'}, p and p', and the substitution position of R^{1B} and the substitution position of R^{1B'} differ from each other.
<9> The composition for resist underlayer film formation according to <7>, wherein the tellurium-containing compound is represented by the following formula (3A): 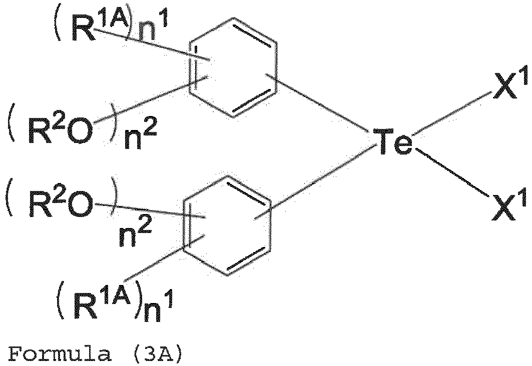 wherein R^{1A}, R², X¹, n¹, and n² are as defined in the above formula (2A).
<10> The composition for resist underlayer film formation according to <9>, wherein the tellurium-containing compound is represented by the following formula (4A): 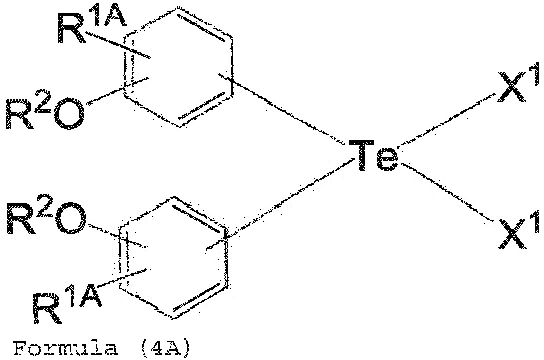 wherein R^{1A}, R², and X¹ are as defined in the above formula (3A).
<11> The composition for resist underlayer film formation according to <6>, wherein the tellurium-containing compound is represented by the following formula (2B): 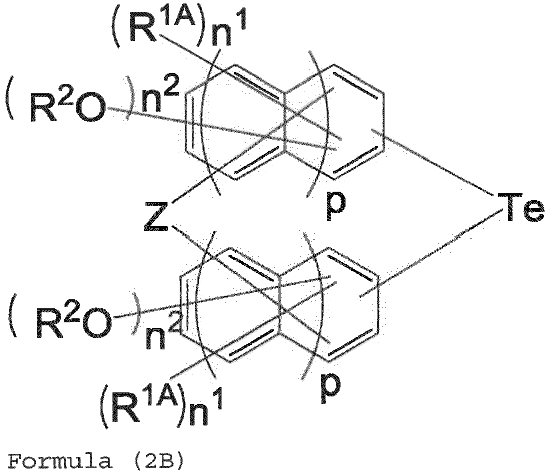 wherein Z, R^{1A}, R², p, n¹, and n² are as defined in the above formula (1B).
<12> The composition for resist underlayer film formation according to <10>, wherein the tellurium-containing compound is represented by the following formula (2B'): 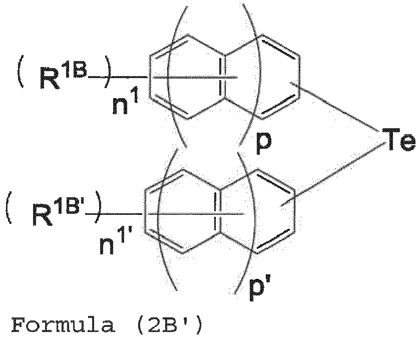 wherein R^{1B} and R^{1B'} are each independently an alkyl group, an aryl group, an alkenyl group, a halogen atom, a hydroxy group or a group in which a hydrogen atom of a hydroxy group is substituted with an acid crosslinking reactive group or an acid dissociation reactive group; n¹ and n^{1'} are as defined as n¹ in the above formula (2B) ; p and p' are as defined as p in the above formula (2B); and members in at least one combination selected from R^{1B} and R^{1B'}, n¹ and n^{1'}, p and p', and the substitution position of R^{1B} and the substitution position of R^{1B'} differ from each other.
<13> The composition for resist underlayer film formation according to <11>, wherein the tellurium-containing compound is represented by the following formula (3B): 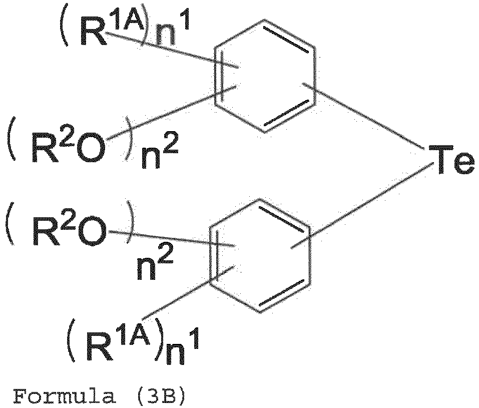 wherein R^{1A}, R², n¹, and n² are as defined in the above formula (2B).
<14> The composition for resist underlayer film formation according to <13>, wherein the tellurium-containing compound is represented by the following formula (4B): 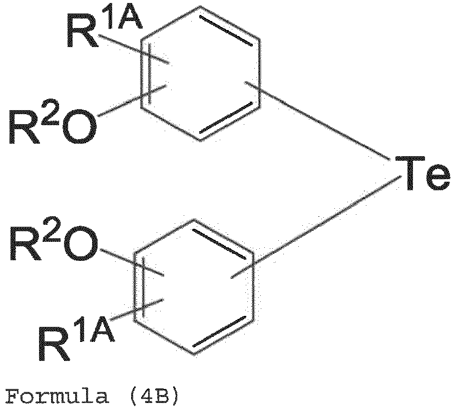 wherein R¹, R², and X¹ are as defined in the above formula (3B).
<15> The composition for resist underlayer film formation according to any one of <5> to <7>, <9> to <11>, <13>, and <14>, wherein the tellurium-containing compound has at least one acid dissociation reactive group as R² in the above formula.
<16> The composition for resist underlayer film formation according to any one of <5> to <7>, <9> to <11>, <13>, and <14>, wherein all of R² in the above formula in the tellurium-containing compound are hydrogen atoms.
<17> The composition for resist underlayer film formation according to <1>, wherein the tellurium-containing resin is a resin comprising a constitutional unit derived from a compound represented by the following formula (A-1): 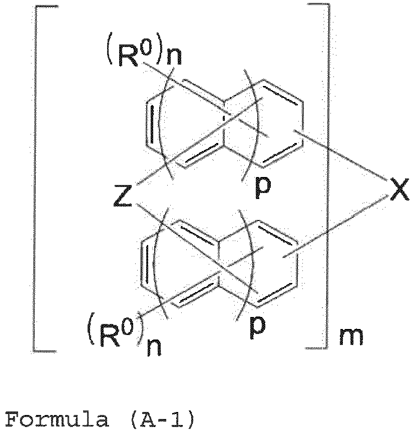 wherein X is a 2m-valent group of 0 to 60 carbon atoms containing tellurium; Z is an oxygen atom, a sulfur atom, or a non-crosslinked state; each R⁰ is independently selected from the group consisting of a monovalent group containing an oxygen atom, a monovalent group containing a sulfur atom, a monovalent group containing a nitrogen atom, a hydrocarbon group, a halogen atom, and a combination thereof; m is an integer of 1 to 4; each p is independently an integer of 0 to 2; and each n is independently an integer of 0 to (5 + 2 × p).
<18> The composition for resist underlayer film formation according to <1>, wherein the tellurium-containing resin is a resin comprising a constitutional unit derived from a compound represented by the following formula (A-2): 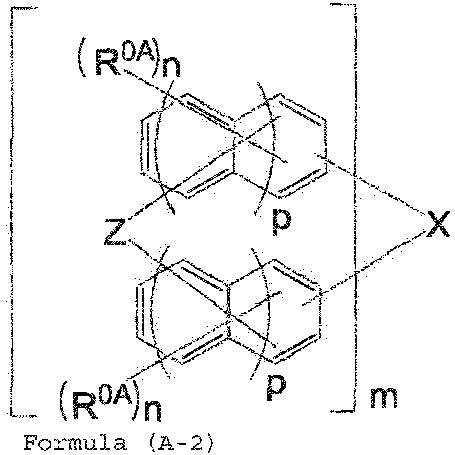 wherein X is a 2m-valent group of 0 to 60 carbon atoms containing tellurium; Z is an oxygen atom, a sulfur atom, a single bond, or a non-crosslinked state; each R^{0A} is independently selected from the group consisting of a hydrocarbon group, a halogen atom, a cyano group, a nitro group, an amino group, an alkyl group of 1 to 30 carbon atoms, an alkenyl group of 2 to 30 carbon atoms, an aryl group of 6 to 40 carbon atoms, a hydroxy group or a group in which a hydrogen atom of a hydroxy group is substituted with an acid crosslinking reactive group or an acid dissociation reactive group, and a combination thereof, wherein the alkyl group, the alkenyl group, and the aryl group each optionally have an ether bond, a ketone bond, or an ester bond; m is an integer of 1 to 4; each p is independently an integer of 0 to 2; and each n is independently an integer of 0 to (5 + 2 × p).
<19> The composition for resist underlayer film formation according to <1>, wherein the tellurium-containing resin is a resin comprising a constitutional unit derived from a compound represented by the following formula (A-3): 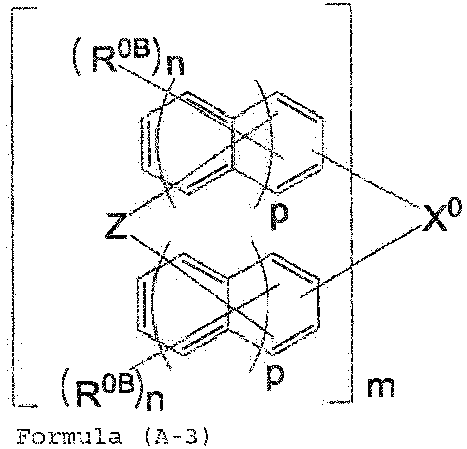 wherein X⁰ is a 2m-valent group of 0 to 30 carbon atoms containing tellurium; Z is an oxygen atom, a sulfur atom, or a non-crosslinked state; each R^{0B} is independently a monovalent group containing an oxygen atom, a monovalent group containing a sulfur atom, a monovalent group containing a nitrogen atom, a hydrocarbon group, or a halogen atom; m is an integer of 1 to 4; each p is independently an integer of 0 to 2; and each n is independently an integer of 0 to (5 + 2 × p).
<20> The composition for resist underlayer film formation according to <1>, wherein the tellurium-containing resin is a resin comprising a constitutional unit represented by the following formula (B1-M) : 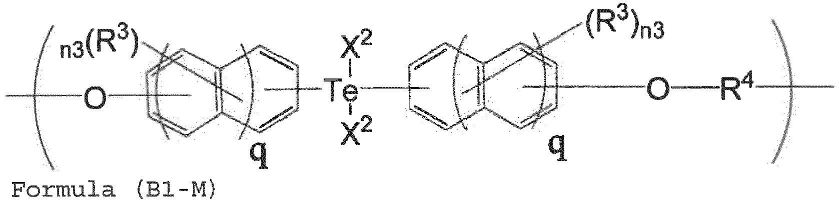 wherein each X² is independently a monovalent group containing an oxygen atom, a monovalent group containing a sulfur atom, a monovalent group containing a nitrogen atom, a hydrocarbon group, a hydrogen atom, or a halogen atom; each R³ is independently a monovalent group containing an oxygen atom, a monovalent group containing a sulfur atom, a monovalent group containing a nitrogen atom, a hydrocarbon group, or a halogen atom; q is an integer of 0 to 2; n³ is an integer of 0 to (4 + 2 × q); and R⁴ is a single bond or any structure represented by the following general formula (5): 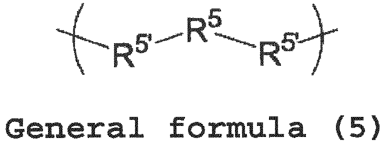 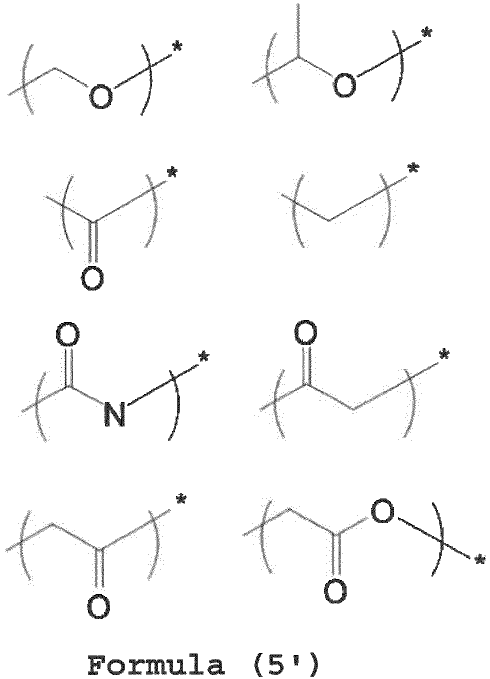 wherein R⁵ is a substituted or unsubstituted linear alkylene group of 1 to 20 carbon atoms, branched alkylene group of 3 to 20 carbon atoms, or cyclic alkylene group of 3 to 20 carbon atoms, or a substituted or unsubstituted arylene group of 6 to 20 carbon atoms; and each R^{5'} is independently any structure of the above formula (5') wherein * indicates that this portion is connected to R⁵.
<21> The composition for resist underlayer film formation according to <20>, wherein the R⁴ in the tellurium-containing resin is any structure represented by the above general formula (5).
<22> The composition for resist underlayer film formation according to <20>, wherein the tellurium-containing resin is a resin comprising a constitutional unit represented by the following formula (B2-M'): 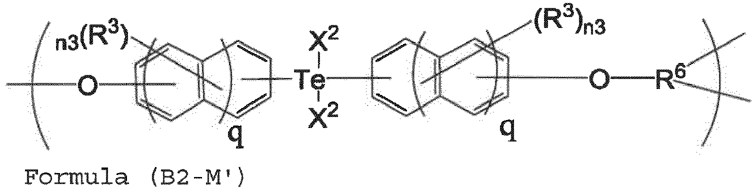 wherein X², R³, q, and n³ are as defined in the formula (B1-M) ; and R⁶ is any structure represented by the following general formula (6): 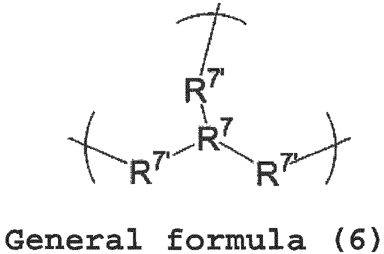 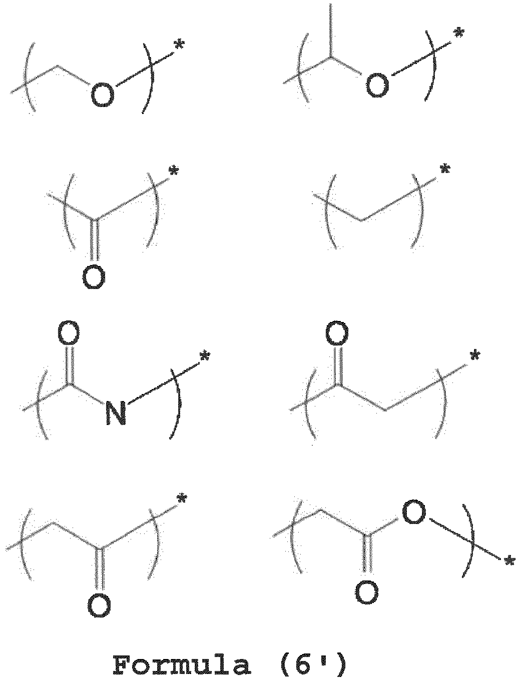 wherein R⁷ is a substituted or unsubstituted linear alkylene group of 1 to 20 carbon atoms, branched alkylene group of 3 to 20 carbon atoms, or cyclic alkylene group of 3 to 20 carbon atoms, or a substituted or unsubstituted arylene group of 6 to 20 carbon atoms; each R^{7'} is independently any structure of the above formula (6') wherein * indicates that this portion is connected to R⁷.
<23> The composition for resist underlayer film formation according to <1>, wherein the tellurium-containing resin is a resin comprising a constitutional unit represented by the following formula (C1): 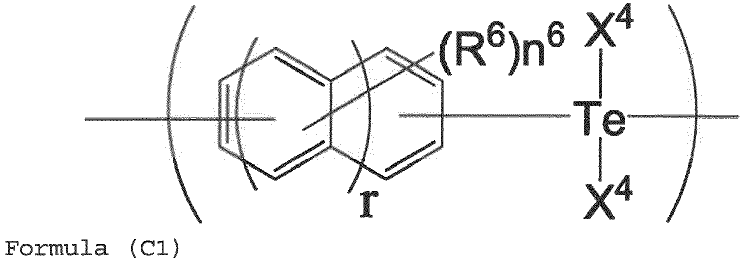 wherein each X⁴ is independently a monovalent group containing an oxygen atom, a monovalent group containing a sulfur atom, a monovalent group containing a nitrogen atom, a hydrocarbon group, a hydrogen atom, or a halogen atom; each R⁶ is independently a monovalent group containing an oxygen atom, a monovalent group containing a sulfur atom, a monovalent group containing a nitrogen atom, a hydrocarbon group, or a halogen atom; r is an integer of 0 to 2; and n⁶ is an integer of 2 to (4 + 2 × r) .
<24> The composition for resist underlayer film formation according to <1>, wherein the tellurium-containing resin is a resin comprising a constitutional unit represented by the following formula (B3-M): 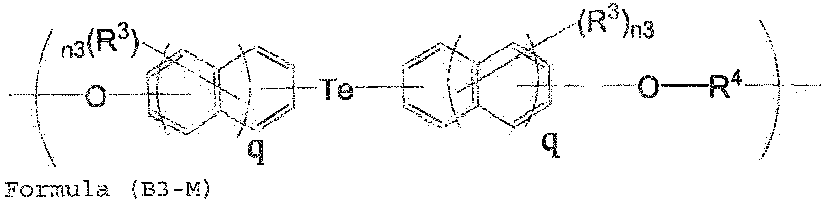 wherein each R³ is independently a monovalent group containing an oxygen atom, a monovalent group containing a sulfur atom, a monovalent group containing a nitrogen atom, a hydrocarbon group, or a halogen atom; q is an integer of 0 to 2; n³ is an integer of 0 to (4 + 2 × q); and R⁴ is a single bond or any structure represented by the following general formula (5): 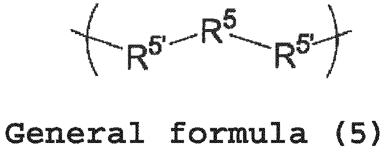 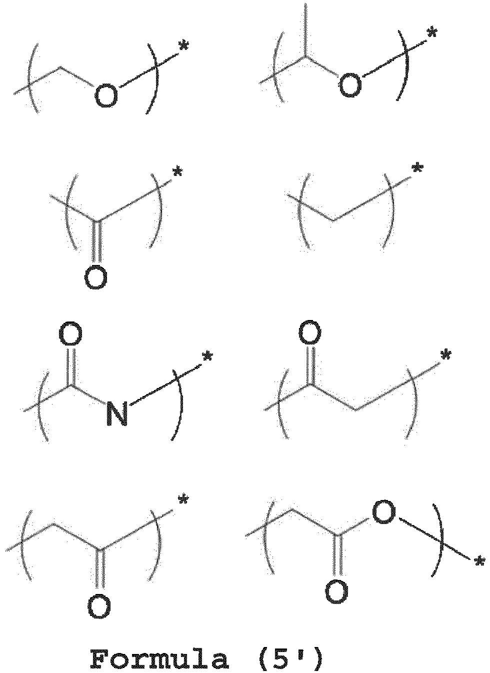 wherein R⁵ is a substituted or unsubstituted linear alkylene group of 1 to 20 carbon atoms, branched alkylene group of 3 to 20 carbon atoms, or cyclic alkylene group of 3 to 20 carbon atoms, or a substituted or unsubstituted arylene group of 6 to 20 carbon atoms; each R^{5'} is independently any structure of the above formula (5') wherein * indicates that this portion is connected to R⁵.
<25> The composition for resist underlayer film formation according to <24>, wherein the R⁴ in the tellurium-containing resin is any structure represented by the above general formula (5).
<26> The composition for resist underlayer film formation according to <24>, wherein the tellurium-containing resin is a resin comprising a constitutional unit represented by the following formula (B4-M'): 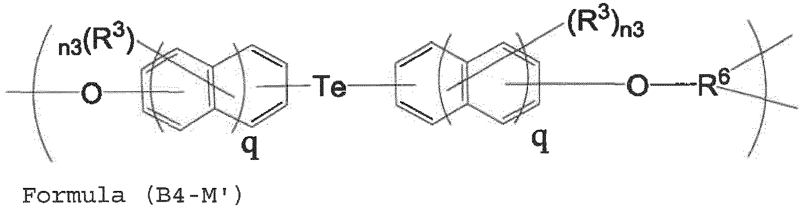 wherein R³, q, and n³ are as defined in the formula (B3-M); and R⁶ is any structure represented by the following general formula (6): 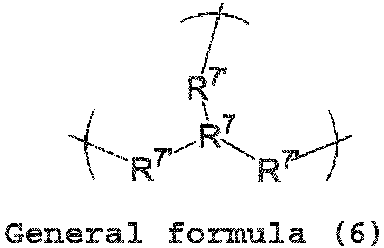 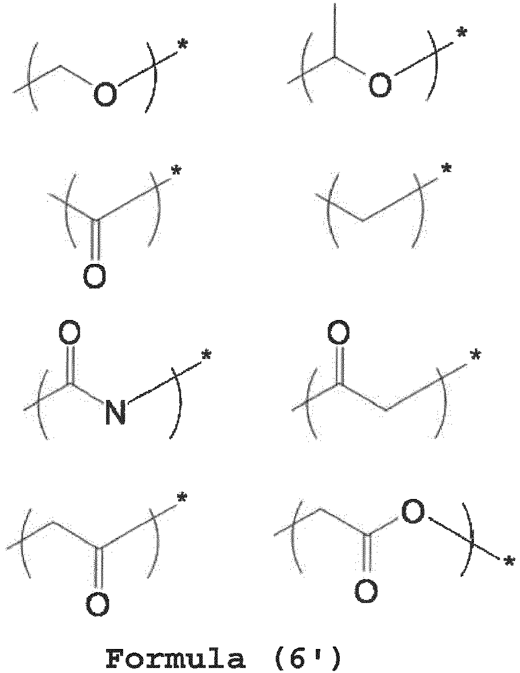 wherein R⁷ is a substituted or unsubstituted linear alkylene group of 1 to 20 carbon atoms, branched alkylene group of 3 to 20 carbon atoms, or cyclic alkylene group of 3 to 20 carbon atoms, or a substituted or unsubstituted arylene group of 6 to 20 carbon atoms; and each R^{7'} is independently any structure of the above formula (6') wherein * indicates that this portion is connected to R⁷.
<27> The composition for resist underlayer film formation according to <1>, wherein the tellurium-containing resin is a resin comprising a constitutional unit represented by the following formula (C2): 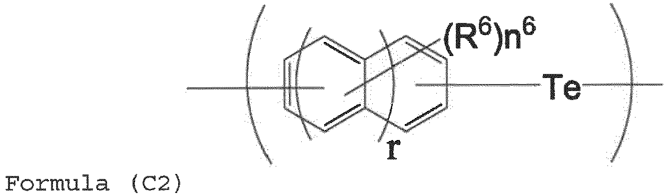 wherein each R⁶ is independently a monovalent group containing an oxygen atom, a monovalent group containing a sulfur atom, a monovalent group containing a nitrogen atom, a hydrocarbon group, or a halogen atom; r is an integer of 0 to 2; and n⁶ is an integer of 2 to (4 + 2 × r) .
<28> A method for producing the composition for resist underlayer film formation according to any one of <1> to <27>, comprising the step of reacting a tellurium halide with a substituted or unsubstituted phenol derivative in the presence of a basic catalyst to synthesize the tellurium-containing compound.
<29> The composition for resist underlayer film formation according to any one of <1> to <27>, further comprising a solvent.
<30> The composition for resist underlayer film formation according to any one of <1> to <29>, further comprising an acid generating agent.
<31> The composition for resist underlayer film formation according to any one of <1> to <30>, further comprising an acid crosslinking agent.
<32> A resist underlayer film for lithography formed using the composition for resist underlayer film formation according to any one of <1> to <31>.
<33> A method for forming a pattern, comprising: forming a resist underlayer film on a substrate using the composition for resist underlayer film formation according to any one of <1> to <31>; forming at least one photoresist layer on the resist underlayer film; and then irradiating a predetermined region of the photoresist layer with radiation for development.
<34> A method for forming a pattern, comprising: forming a resist underlayer film on a substrate using the composition for resist underlayer film formation according to any one of <1> to <31>; forming a resist intermediate layer film on the resist underlayer film using a resist intermediate layer film material; forming at least one photoresist layer on the resist intermediate layer film; then irradiating a predetermined region of the photoresist layer with radiation for development, thereby forming a resist pattern; then etching the resist intermediate layer film with the resist pattern as a mask; etching the resist underlayer film with the obtained intermediate layer film pattern as an etching mask; and etching the substrate with the obtained underlayer film pattern as an etching mask, thereby forming a pattern on the substrate.

### Advantageous Effects of Invention

The present invention can provide a composition for resist underlayer film formation which is applicable to a wet process and is useful for forming a photoresist underlayer film excellent in heat resistance, etching resistance, filling properties for uneven substrates and film smoothness, a resist underlayer film for lithography obtained from the composition, and a pattern formation method using the composition.

### Description of Embodiments

Hereinafter, an embodiment of the present invention will be described. The following embodiment is given in order to illustrate the present invention. The present invention is not limited to only the embodiment.

### [Composition for Resist Underlayer Film Formation]

The composition for resist underlayer film formation of the present invention is a composition for resist underlayer film formation containing a tellurium-containing compound or a tellurium-containing resin.

The composition for resist underlayer film formation of the present invention is applicable to a wet process and can achieve a composition for resist underlayer film formation useful for forming a photoresist underlayer film excellent in heat resistance, step filling properties and smoothness. Furthermore, this composition for resist underlayer film formation employs a compound or a resin having a relatively high carbon concentration, a relatively low oxygen concentration, also high solvent solubility, and a specific structure and can therefore form an underlayer film that is prevented from deteriorating during baking and is also excellent in etching resistance to fluorine gas based plasma etching or the like. Moreover, an excellent resist pattern can also be formed because of excellent adhesiveness to a resist layer. The composition for resist underlayer film formation of the present invention is excellent, particularly, in heat resistance, step filling properties and smoothness and can therefore be used as a composition for resist underlayer film formation that is disposed in a lowermost layer among a plurality of resist layers. However, a resist underlayer film formed using the composition for resist underlayer film formation of the present invention may further comprise an additional resist underlayer between the resist underlayer film and a substrate.

The composition for resist underlayer film formation contains one or more selected from, for example, a compound represented by the formula (A-1) mentioned later and a resin obtained using this compound as a monomer (i.e., comprising a constitutional unit derived from the compound represented by the formula (A-1)).

### (Tellurium-Containing Compound Represented by Formula (A-1))

The composition for resist underlayer film formation of the present embodiment can contain a tellurium-containing compound represented by the following formula (A-1) : 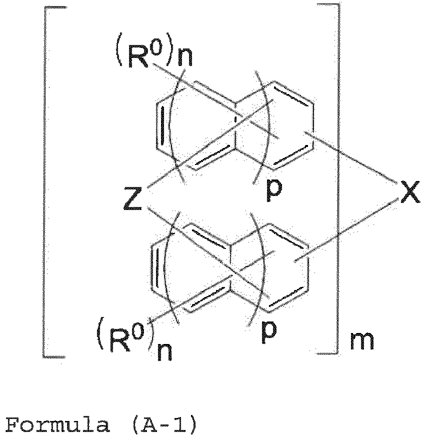 wherein X is a 2m-valent group of 0 to 60 carbon atoms containing tellurium; Z is an oxygen atom, a sulfur atom, or a non-crosslinked state; each R⁰ is independently selected from the group consisting of a monovalent group containing an oxygen atom, a monovalent group containing a sulfur atom, a monovalent group containing a nitrogen atom, a hydrocarbon group, a halogen atom, and a combination thereof; m is an integer of 1 to 4; each p is independently an integer of 0 to 2; and each n is independently an integer of 0 to (5 + 2 × p).

The compound contained in the composition for resist underlayer film formation of the present embodiment contains tellurium as shown in the above formula (A-1) and can therefore be expected to produce a sensitizing effect, particularly, in lithography with EUV (extreme ultraviolet). Also, the compound has a benzene skeleton or a naphthalene skeleton or the like and is therefore excellent in heat resistance.

Furthermore, the compound has a relatively low molecular weight and a low viscosity and therefore facilitates thoroughly and uniformly filling even the steps of an uneven substrate (particularly having fine space, hole pattern, etc.). As a result, the composition for resist underlayer film formation containing this compound is capable of relatively advantageously enhancing filling properties. Also, the compound has a relatively high carbon concentration and therefore confers even high etching resistance.

In the above formula (A-1), m is an integer of 1 to 4. When m is an integer of 2 or larger, the structural formulae of m repeat units may be the same or different. In the above formula (A-1), m is preferably 1 to 3 from the viewpoint of resist properties such as heat resistance, resolution, and roughness.

Although the compound of the present embodiment is not a polymer, the structure indicated within the parentheses [ ] bonded to X in the above formula (A-1) is referred to as "structural formula of a repeat unit" (the same holds true for formulae given below) for the sake of convenience.

In the above formula (A-1), each p is independently an integer of 0 to 2 and is a value that determines the structure of the accompanying ring structure (a ring structure represented by naphthalene in the formula (A-1) (hereinafter, the ring structure is also simply referred to as "ring structure A")). Specifically, as shown below, in the formula (A-1), the ring structure A refers to a benzene structure (p = 0), a naphthalene structure (p = 1), or a tricyclic structure such as anthracene or phenanthrene (p = 2). The ring structure A is not particularly limited, but is preferably a benzene structure or a naphthalene structure from the viewpoint of solubility. In the formula (A-1), X, Z, and R⁰ are bonded to any possible site on the ring structure A. 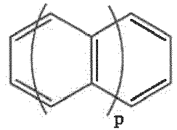 Ring structure A

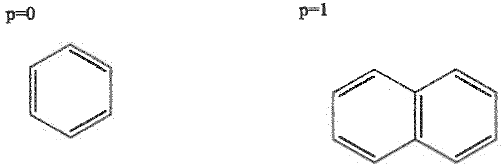

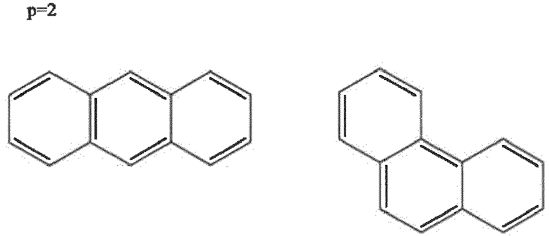

In the above formula (A-1), X is a 2m-valent group of 0 to 60 carbon atoms containing tellurium. X is a single bond containing tellurium or a 2m-valent hydrocarbon group of 0 to 60 carbon atoms containing tellurium.

The 2m-valent group refers to an alkylene group of 1 to 60 carbon atoms (m = 1), an alkanetetrayl group of 1 to 60 carbon atoms (m = 2), an alkanehexayl group of 2 to 60 carbon atoms (m = 3), or an alkaneoctayl group of 3 to 60 carbon atoms (m = 4). Examples of the 2m-valent group include groups having a linear, branched, or cyclic structure.

Also, the 2m-valent hydrocarbon group may have an alicyclic hydrocarbon group, a double bond, a hetero atom, or an aromatic group of 6 to 60 carbon atoms. Herein, the alicyclic hydrocarbon group also includes bridged alicyclic hydrocarbon groups.

X preferably has a condensed polycyclic aromatic group (particularly, a bicyclic to tetracyclic condensed ring structure) from the viewpoint of heat resistance and preferably has a polyphenyl group such as a biphenyl group from the viewpoint of solubility in a safe solvent and heat resistance.

Specific examples of the 2m-valent group of 0 to 60 carbon atoms containing tellurium, represented by X include the following groups:

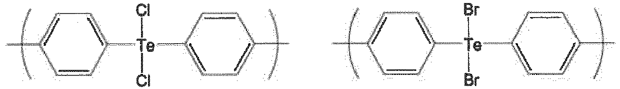

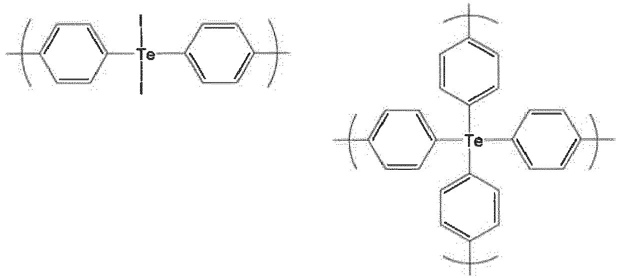

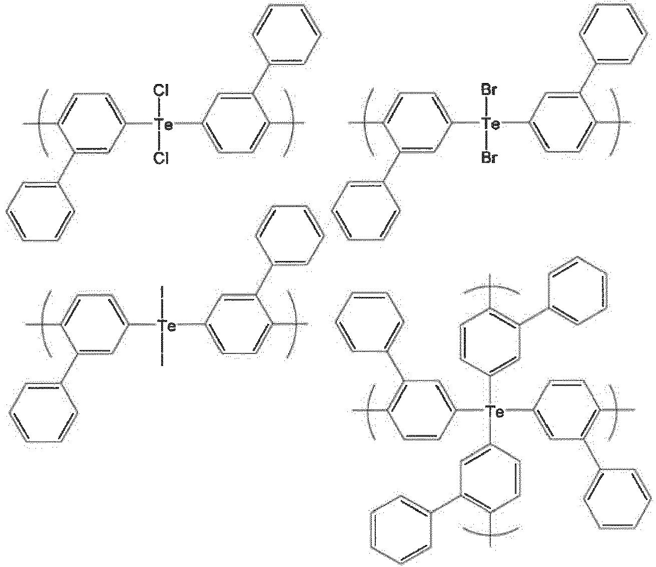

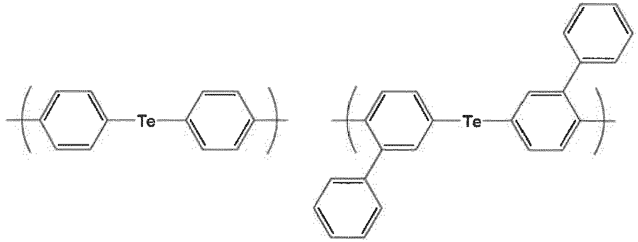

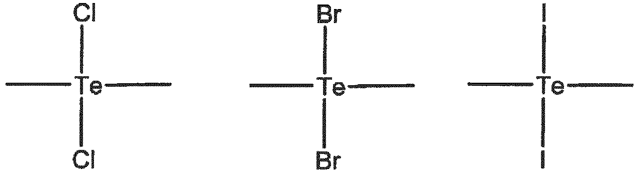

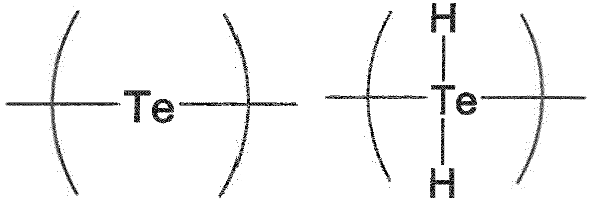

In the above formula (A-1), Z is an oxygen atom, a sulfur atom, or a non-crosslinked state. When m is 2 or larger, Z may be the same or different. Also, when m is 2 or larger, the structural formulae of different repeat units may be bonded via Z. For example, when m is 2 or larger, the structural formulae of different repeat units may be bonded via Z and the structural formulae of a plurality of repeat units may constitute a cup like structure or the like. Z is not particularly limited, but is preferably an oxygen atom or a sulfur atom from the viewpoint of heat resistance.

In the above formula (A-1), R⁰ is a monovalent group containing an oxygen atom, a monovalent group containing a sulfur atom, a monovalent group containing a nitrogen atom, a halogen atom, or a combination thereof.

Herein, examples of the monovalent group containing an oxygen atom include, but not limited to, acyl groups of 1 to 20 carbon atoms, alkoxycarbonyl groups of 2 to 20 carbon atoms, linear alkyloxy groups of 1 to 6 carbon atoms, branched alkyloxy groups of 3 to 20 carbon atoms, cyclic alkyloxy groups of 3 to 20 carbon atoms, linear alkenyloxy groups of 2 to 6 carbon atoms, branched alkenyloxy groups of 3 to 6 carbon atoms, cyclic alkenyloxy groups of 3 to 10 carbon atoms, aryloxy groups of 6 to 10 carbon atoms, acyloxy groups of 1 to 20 carbon atoms, alkoxycarbonyloxy groups of 2 to 20 carbon atoms, alkoxycarbonylalkyl groups of 2 to 20 carbon atoms, 1-substituted alkoxymethyl groups of 2 to 20 carbon atoms, cyclic ether oxy groups of 2 to 20 carbon atoms, alkoxyalkyloxy groups of 2 to 20 carbon atoms, a glycidyloxy group, allyloxy groups, (meth)acryl groups, a glycidyl acrylate group, a glycidyl methacrylate group, and a hydroxy group.

Examples of the acyl groups of 1 to 20 carbon atoms include, but not limited to, a methanoyl group (a formyl group), an ethanoyl group (an acetyl group), a propanoyl group, a butanoyl group, a pentanoyl group, a hexanoyl group, an octanoyl group, a decanoyl group, and a benzoyl group.

Examples of the alkoxycarbonyl groups of 2 to 20 carbon atoms include, but not limited to, a methoxycarbonyl group, an ethoxycarbonyl group, a propoxycarbonyl group, a butoxycarbonyl group, a pentyloxycarbonyl group, a hexyloxycarbonyl group, an octyloxycarbonyl group, and a decyloxycarbonyl group.

Examples of the linear alkyloxy groups of 1 to 6 carbon atoms include, but not limited to, a methoxy group, an ethoxy group, a n-propoxy group, a n-butoxy group, a n-pentyloxy group, and a n-hexyloxy group.

Examples of the branched alkyloxy groups of 3 to 20 carbon atoms include, but not limited to, an isopropoxy group, an isobutoxy group, and a tert-butoxy group.

Examples of the cyclic alkyloxy groups of 3 to 20 carbon atoms include, but not limited to, a cyclopropoxy group, a cyclobutoxy group, a cyclopentyloxy group, a cyclohexyloxy group, a cyclooctyloxy group, and a cyclodecyloxy group.

Examples of the linear alkenyloxy groups of 2 to 6 carbon atoms include, but not limited to, a vinyloxy group, a 1-propenyloxy group, a 2-propenyloxy group, a 1-butenyloxy group, and a 2-butenyloxy group.

Examples of the branched alkenyloxy groups of 3 to 6 carbon atoms include, but not limited to, an isopropenyloxy group, an isobutenyloxy group, an isopentenyloxy group, and an isohexenyloxy group.

Examples of the cyclic alkenyloxy groups of 3 to 10 carbon atoms include, but not limited to, a cyclopropenyloxy group, a cyclobutenyloxy group, a cyclopentenyloxy group, a cyclohexenyloxy group, a cyclooctenyloxy group, and a cyclodecynyloxy group.

Examples of the aryloxy groups of 6 to 10 carbon atoms include, but not limited to, a phenyloxy group (a phenoxy group), a 1-naphthyloxy group, and a 2-naphthyloxy group.

Examples of the acyloxy groups of 1 to 20 carbon atoms include, but not limited to, a formyloxy group, an acetyloxy group, a propionyloxy group, a butyryloxy group, an isobutyryloxy group, and a benzoyloxy group.

Examples of the alkoxycarbonyloxy groups of 2 to 20 carbon atoms include, but not limited to, a methoxycarbonyloxy group, an ethoxycarbonyloxy group, a propoxycarbonyloxy group, a butoxycarbonyloxy group, an octyloxycarbonyloxy group, and a decyloxycarbonyloxy group.

Examples of the alkoxycarbonylalkyl groups of 2 to 20 carbon atoms include, but not limited to, a methoxycarbonylmethyl group, an ethoxycarbonylmethyl group, a n-propoxycarbonylmethyl group, an isopropoxycarbonylmethyl group, and a n-butoxycarbonylmethyl group.

Examples of the 1-substituted alkoxymethyl groups of 2 to 20 carbon atoms include, but not limited to, a 1-cyclopentylmethoxymethyl group, a 1-cyclopentylethoxymethyl group, a 1-cyclohexylmethoxymethyl group, a 1-cyclohexylethoxymethyl group, a 1-cyclooctylmethoxymethyl group, and a 1-adamantylmethoxymethyl group.

Examples of the cyclic ether oxy groups of 2 to 20 carbon atoms include, but not limited to, a tetrahydropyranyloxy group, a tetrahydrofuranyloxy group, a tetrahydrothiopyranyloxy group, a tetrahydrothiofuranyloxy group, a 4-methoxytetrahydropyranyloxy group, and a 4-methoxytetrahydrothiopyranyloxy group.

Examples of the alkoxyalkyloxy groups of 2 to 20 carbon atoms include, but not limited to, a methoxymethoxy group, an ethoxyethoxy group, a cyclohexyloxymethoxy group, a cyclohexyloxyethoxy group, a phenoxymethoxy group, and a phenoxyethoxy group.

Examples of the (meth)acryl groups include, but not limited to, an acryloyloxy group and a methacryloyloxy group. The glycidyl acrylate group is not particularly limited as long as it can be obtained by reacting a glycidyloxy group with acrylic acid. The glycidyl methacrylate group is not particularly limited as long as it can be obtained by reacting a glycidyloxy group with methacrylic acid.

Examples of the monovalent group containing a sulfur atom include, but not limited to, a thiol group. The monovalent group containing a sulfur atom is preferably a group in which a sulfur atom is directly bonded to a carbon atom constituting the ring structure (A) in the formula (A-1).

Examples of the monovalent group containing a nitrogen atom include, but not limited to, a nitro group, an amino group, and a diazo group. The monovalent group containing a nitrogen atom is preferably a group in which a nitrogen atom is directly bonded to a carbon atom constituting the ring structure (A) in the formula (A-1).

Examples of the hydrocarbon group include, but not limited to, linear alkyl groups of 1 to 6 carbon atoms, branched alkyl groups of 3 to 6 carbon atoms, cyclic alkyl groups of 3 to 10 carbon atoms, linear alkenyl groups of 2 to 6 carbon atoms, branched alkenyl groups of 3 to 6 carbon atoms, cyclic alkenyl groups of 3 to 10 carbon atoms, and aryl groups of 6 to 10 carbon atoms.

Examples of the linear alkyl groups of 1 to 6 carbon atoms include, but not limited to, a methyl group, an ethyl group, a n-propyl group, a n-butyl group, a n-pentyl group, and a n-hexyl group.

Examples of the branched alkyl groups of 3 to 6 carbon atoms include, but not limited to, an isopropyl group, an isobutyl group, a tert-butyl group, a neopentyl group, and a 2-hexyl group.

Examples of the cyclic alkyl groups of 3 to 10 carbon atoms include, but not limited to, a cyclopropyl group, a cyclobutyl group, a cyclopentyl group, a cyclohexyl group, a cyclooctyl group, and a cyclodecyl group.

Examples of the linear alkenyl groups of 2 to 6 carbon atoms include, but not limited to, a vinyl group, a 1-propenyl group, a 2-propenyl group (an allyl group), a 1-butenyl group, a 2-butenyl group, a 2-pentenyl group, and a 2-hexenyl group.

Examples of the branched alkenyl groups of 3 to 6 carbon atoms include, but not limited to, an isopropenyl group, an isobutenyl group, an isopentenyl group, and an isohexenyl group.

Examples of the cyclic alkenyl groups of 3 to 10 carbon atoms include, but not limited to, a cyclopropenyl group, a cyclobutenyl group, a cyclopentenyl group, a cyclohexenyl group, a cyclohexenyl group, a cyclooctenyl group, and a cyclodecynyl group.

Examples of the aryl groups of 6 to 10 carbon atoms include, but not limited to, a phenyl group and a naphthyl group.

Examples of the halogen atom include, but not limited to, a fluorine atom, a chlorine atom, a bromine atom, and an iodine atom.

In the above formula (A-1), each n is independently an integer of 0 to (5 + 2 × p). In the present embodiment, at least one n in the above formula (A-1) is preferably an integer of 1 to 4 from the viewpoint of solubility in a solvent.

In the present embodiment, at least one R⁰ in the above formula (A-1) is preferably a monovalent group containing an oxygen atom from the viewpoint of solubility in a solvent and the introduction of crosslinkability.

The tellurium-containing compound represented by the above formula (A-1) is preferably a tellurium-containing compound represented by the following formula (A-2) from the viewpoint of curability:

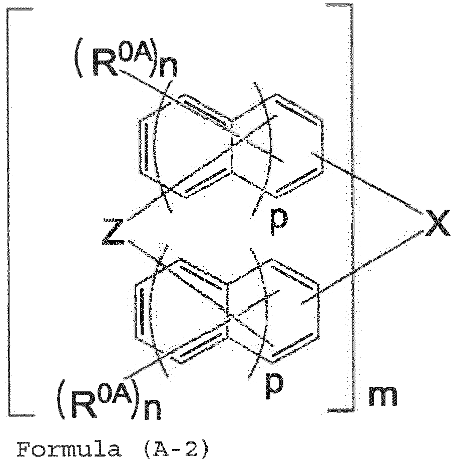

(In the formula (A-2), X is a 2m-valent group of 0 to 60 carbon atoms containing tellurium; Z is an oxygen atom, a sulfur atom, a single bond, or a non-crosslinked state; each R^{0A} is independently selected from the group consisting of a hydrocarbon group, a halogen atom, a cyano group, a nitro group, an amino group, an alkyl group of 1 to 30 carbon atoms, an alkenyl group of 2 to 30 carbon atoms, an aryl group of 6 to 40 carbon atoms, a hydroxy group or a group in which a hydrogen atom of a hydroxy group is substituted with an acid crosslinking reactive group or an acid dissociation reactive group, and a combination thereof, wherein the alkyl group, the alkenyl group, and the aryl group each optionally have an ether bond, a ketone bond, or an ester bond; m is an integer of 1 to 4; each p is independently an integer of 0 to 2; and each n is independently an integer of 0 to (5 + 2 × p).)

The "acid crosslinking reactive group" and the "acid dissociation reactive group" in R^{0A} will be mentioned later.

The tellurium-containing compound represented by the above formula (A-1) is preferably a tellurium-containing compound represented by the following formula (A-3) from the viewpoint of solubility in a safe solvent:

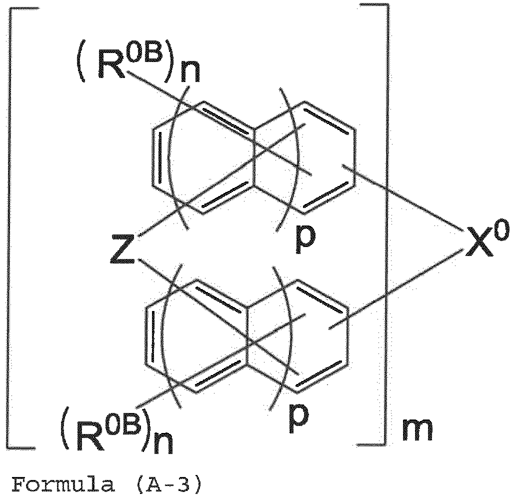

(In the formula (A-3), X⁰ is a 2m-valent group of 0 to 30 carbon atoms containing tellurium; Z is an oxygen atom, a sulfur atom, or a non-crosslinked state; each R^{0B} is independently a monovalent group containing an oxygen atom, a monovalent group containing a sulfur atom, a monovalent group containing a nitrogen atom, a hydrocarbon group, or a halogen atom; m is an integer of 1 to 4; each p is independently an integer of 0 to 2; and each n is independently an integer of 0 to (5 + 2 × p).)

In the present embodiment, the tellurium-containing compound represented by the above formula (A-1) is preferably a compound other than BMPT, BHPT, and TDP mentioned later from the viewpoint of the pattern shape of the resulting resist.

### - Tellurium-Containing Compound Represented by Formula (1A) -

The tellurium-containing compound represented by the above formula (A-1) is preferably a tellurium-containing compound represented by the following formula (1A):

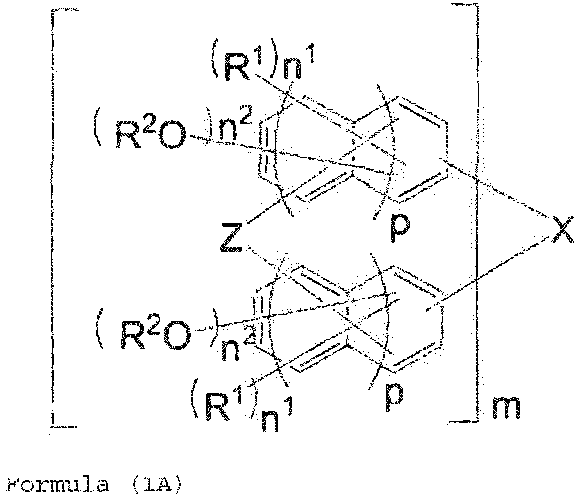

(In the formula (1A), X, Z, m, and p are as defined in the above formula (A-1); each R¹ is independently selected from the group consisting of a hydrocarbon group, a halogen atom, a cyano group, a nitro group, an amino group, an alkyl group of 1 to 30 carbon atoms, an alkenyl group of 2 to 30 carbon atoms, an aryl group of 6 to 40 carbon atoms, and a combination thereof, wherein the alkyl group, the alkenyl group, and the aryl group each optionally have an ether bond, a ketone bond, or an ester bond; each R² is independently a hydrogen atom, an acid crosslinking reactive group, or an acid dissociation reactive group; each n¹ is independently an integer of 0 to (5 + 2 × p); and each n² is independently an integer of 0 to (5 + 2 × p), provided that at least one n² is an integer of 1 to (5 + 2 × p).)

In the formula (1A), each n¹ is independently an integer of 0 to (5 + 2 × p), and each n² is independently an integer of 0 to (5 + 2 × p). At least one n² is an integer of 1 to (5 + 2 × p). Specifically, the tellurium-containing compound of the general formula (1A) has at least one "-OR²" per ring structure A. In the formula (1A), X, Z, R¹, and -OR² are bonded to any possible site on the ring structure A. Therefore, the upper limit of n¹ + n² in one ring structure A corresponds to the upper limit of the number of possible bonding sites on the ring structure A also taking X and Z and the bonding sites into consideration.

Each R¹ is independently selected from the group consisting of a hydrocarbon group, a halogen atom, a cyano group, a nitro group, an amino group, an alkyl group of 1 to 30 carbon atoms, an alkenyl group of 2 to 30 carbon atoms, an aryl group of 6 to 40 carbon atoms, and a combination thereof. Herein, the alkyl group, the alkenyl group, and the aryl group each optionally have an ether bond, a ketone bond, or an ester bond.

As mentioned above, the hydrocarbon group represented by R¹ is a substituted or unsubstituted linear, substituted or unsubstituted branched, or substituted or unsubstituted cyclic hydrocarbon group.

Examples of the linear, branched, or cyclic hydrocarbon group include, but not limited to, linear alkyl groups of 1 to 30 carbon atoms, branched alkyl groups of 3 to 30 carbon atoms, and cyclic alkyl groups of 3 to 30 carbon atoms.

Examples of the linear alkyl groups of 1 to 30 carbon atoms include, but not limited to, a methyl group, an ethyl group, a n-propyl group, a n-butyl group, a n-pentyl group, and a n-hexyl group.

Examples of the branched alkyl groups of 3 to 30 carbon atoms include, but not limited to, an isopropyl group, an isobutyl group, a tert-butyl group, a neopentyl group, and a 2-hexyl group.

Examples of the cyclic alkyl groups of 3 to 30 carbon atoms include, but not limited to, a cyclopropyl group, a cyclobutyl group, a cyclopentyl group, a cyclohexyl group, a cyclooctyl group, and a cyclodecyl group.

As mentioned above, the aryl group represented by R¹ is, but not limited to, an aryl group of 6 to 40 carbon atoms. Examples thereof include a phenyl group and a naphthyl group.

As mentioned above, the alkenyl group represented by R¹ is, but not limited to a substituted or unsubstituted alkenyl group. Examples thereof include linear alkenyl groups of 2 to 30 carbon atoms, branched alkenyl groups of 3 to 30 carbon atoms, and cyclic alkenyl groups of 3 to 30 carbon atoms.

Examples of the linear alkenyl groups of 2 to 30 carbon atoms include, but not limited to, a vinyl group, a 1-propenyl group, a 2-propenyl group (an allyl group), a 1-butenyl group, a 2-butenyl group, a 2-pentenyl group, and a 2-hexenyl group.

Examples of the branched alkenyl groups of 3 to 30 carbon atoms include, but not limited to, an isopropenyl group, an isobutenyl group, an isopentenyl group, and an isohexenyl group.

Examples of the cyclic alkenyl groups of 3 to 30 carbon atoms include, but not limited to, a cyclopropenyl group, a cyclobutenyl group, a cyclopentenyl group, a cyclohexenyl group, a cyclohexenyl group, a cyclooctenyl group, and a cyclodecynyl group.

Examples of the halogen atom include a fluorine atom, a chlorine atom, a bromine atom, and an iodine atom.

In the present specification, the term "substituted" means that one or more hydrogen atoms in a functional group are substituted with a halogen atom, a hydroxy group, a cyano group, a nitro group, a heterocyclic group, a linear aliphatic hydrocarbon group of 1 to 20 carbon atoms, a branched aliphatic hydrocarbon group of 3 to 20 carbon atoms, a cyclic aliphatic hydrocarbon group of 3 to 20 carbon atoms, an aryl group of 6 to 20 carbon atoms, an aralkyl group of 7 to 30 carbon atoms, an alkoxy group of 1 to 20 carbon atoms, an amino group of 0 to 20 carbon atoms, an alkenyl group of 2 to 20 carbon atoms, an acyl group of 1 to 20 carbon atoms, an alkoxycarbonyl group of 2 to 20 carbon atoms, an alkyloyloxy group of 1 to 20 carbon atoms, an aryloyloxy group of 7 to 30 carbon atoms, or an alkylsilyl group of 1 to 20 carbon atoms, unless otherwise defined.

Examples of the unsubstituted linear aliphatic hydrocarbon group of 1 to 20 carbon atoms include a methyl group, an ethyl group, a propyl group, a butyl group, a pentyl group, a hexyl group, an octyl group, a decyl group, a dodecyl group, a hexadecyl group, and an octadecyl group.

Examples of the substituted linear aliphatic hydrocarbon group of 1 to 20 carbon atoms include a fluoromethyl group, a 2-hydroxyethyl group, a 3-cyanopropyl group, and a 20-nitrooctadecyl group.

Examples of the unsubstituted branched aliphatic hydrocarbon group of 3 to 20 carbon atoms include an isopropyl group, an isobutyl group, a tertiary butyl group, a neopentyl group, a 2-hexyl group, a 2-octyl group, a 2-decyl group, a 2-dodecyl group, a 2-hexadecyl group, and a 2-octadecyl group.

Examples of the substituted branched aliphatic hydrocarbon group of 3 to 20 carbon atoms include a 1-fluoroisopropyl group and a 1-hydroxy-2-octadecyl group.

Examples of the unsubstituted cyclic aliphatic hydrocarbon group of 3 to 20 carbon atoms include a cyclopropyl group, a cyclobutyl group, a cyclopentyl group, a cyclohexyl group, a cyclooctyl group, a cyclodecyl group, a cyclododecyl group, a cyclohexadecyl group, and a cyclooctadecyl group.

Examples of the substituted cyclic aliphatic hydrocarbon group of 3 to 20 carbon atoms include a 2-fluorocyclopropyl group and a 4-cyanocyclohexyl group.

Examples of the unsubstituted aryl group of 6 to 20 carbon atoms include a phenyl group and a naphthyl group.

Examples of the substituted aryl group of 6 to 20 carbon atoms include a 4-isopropylphenyl group, a 4-cyclohexylphenyl group, a 4-methylphenyl group, and a 6-fluoronaphthyl group.

Examples of the unsubstituted alkenyl group of 2 to 20 carbon atoms include a vinyl group, a propynyl group, a butynyl group, a pentynyl group, a hexynyl group, an octynyl group, a decynyl group, a dodecynyl group, a hexadecynyl group, and an octadecynyl group.

Examples of the substituted alkenyl group of 2 to 20 carbon atoms include a chloropropynyl group.

Examples of the halogen atom include a fluorine atom, a chlorine atom, a bromine atom, and an iodine atom.

In the formula (1A), each R² is independently a hydrogen atom, an acid crosslinking reactive group, or an acid dissociation reactive group.

In the present embodiment, the "acid crosslinking reactive group" refers to a characteristic group that reacts in the presence of a radical or an acid or an alkali and varies in solubility in an acid, an alkali, or an organic solvent for use in a coating solvent or a developing solution. Examples of the acid crosslinking reactive group include allyl groups, (meth)acryloyl groups, a vinyl group, an epoxy group, alkoxymethyl groups, and a cyanato group. The acid crosslinking reactive group is not limited thereto as long as it reacts in the presence of a radical or an acid or an alkali. The acid crosslinking reactive group preferably has the property of causing chained cleavage reaction in the presence of an acid, from the viewpoint of improvement in productivity.

In the present embodiment, the "acid dissociation reactive group" refers to a characteristic group that is cleaved in the presence of an acid to cause a change such as an alkali soluble group. Examples of the alkali soluble group include, but not particularly limited to, a phenolic hydroxy group, a carboxyl group, a sulfonic acid group, and a hexafluoroisopropanol group. A phenolic hydroxy group and a carboxyl group are preferable, and a phenolic hydroxy group is particularly preferable. The acid dissociation reactive group is not particularly limited, but can be arbitrarily selected for use from among, for example, those proposed in hydroxystyrene based resins, (meth)acrylic acid based resins, and the like for use in chemically amplified resist compositions for KrF or ArF.

Preferable examples of the acid dissociation reactive group include a group selected from the group consisting of a substituted methyl group, a 1-substituted ethyl group, a 1-substituted n-propyl group, a 1-branched alkyl group, a silyl group, an acyl group, a 1-substituted alkoxymethyl group, a cyclic ether group, an alkoxycarbonyl group, and an alkoxycarbonylalkyl group which have the property of being dissociated by an acid. It is preferable that the acid dissociation reactive group has no crosslinkable functional group.

The substituted methyl group is not particularly limited, but can be usually a substituted methyl group of 2 to 20 carbon atoms and is preferably a substituted methyl group of 4 to 18 carbon atoms and more preferably a substituted methyl group of 6 to 16 carbon atoms. Specific examples of the substituted methyl group can include, but not limited to, a methoxymethyl group, a methylthiomethyl group, an ethoxymethyl group, a n-propoxymethyl group, an isopropoxymethyl group, a n-butoxymethyl group, a t-butoxymethyl group, a 2-methylpropoxymethyl group, an ethylthiomethyl group, a methoxyethoxymethyl group, a phenyloxymethyl group, a 1-cyclopentyloxymethyl group, a 1-cyclohexyloxymethyl group, a benzylthiomethyl group, a phenacyl group, a 4-bromophenacyl group, a 4-methoxyphenacyl group, a piperonyl group, and a substituent group represented by the following formula (13-1). Specific examples of R² in the following formula (13-1) include, but not limited to, a methyl group, an ethyl group, an isopropyl group, a n-propyl group, a t-butyl group, and a n-butyl group.

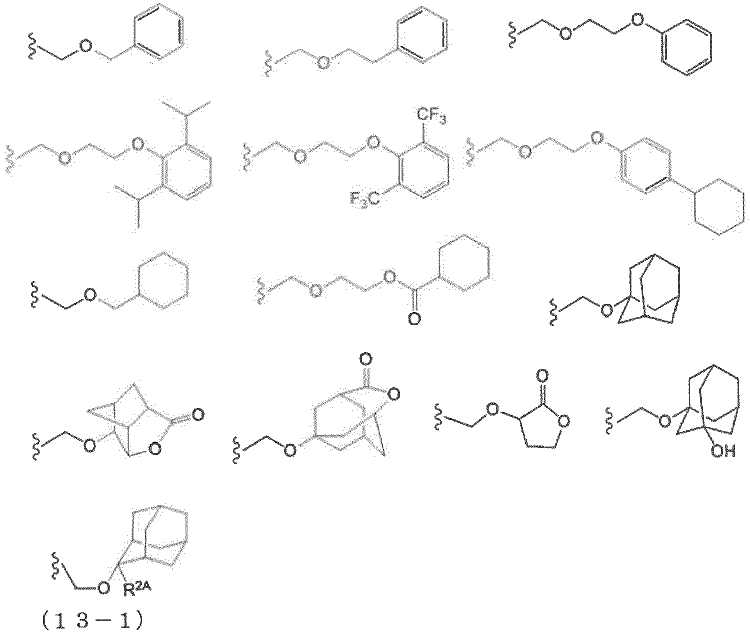

In the above formula (13-1), R^{2A} is an alkyl group of 1 to 4 carbon atoms.

The 1-substituted ethyl group is not particularly limited, but can be usually a 1-substituted ethyl group of 3 to 20 carbon atoms and is preferably a 1-substituted ethyl group of 5 to 18 carbon atoms and more preferably a substituted ethyl group of 7 to 16 carbon atoms. Specific examples of the 1-substituted ethyl group can include, but not limited to, a 1-methoxyethyl group, 1-methylthioethyl group, a 1,1-dimethoxyethyl group, a 1-ethoxyethyl group, a 1-ethylthioethyl group, a 1,1-diethoxyethyl group, a n-propoxyethyl group, an isopropoxyethyl group, a n-butoxyethyl group, a t-butoxyethyl group, a 2-methylpropoxyethyl group, a 1-phenoxyethyl group, a 1-phenylthioethyl group, a 1,1-diphenoxyethyl group, a 1-cyclopentyloxyethyl group, a 1-cyclohexyloxyethyl group, a 1-phenylethyl group, a 1,1-diphenylethyl group, and a substituent group represented by the following formula (13-2):

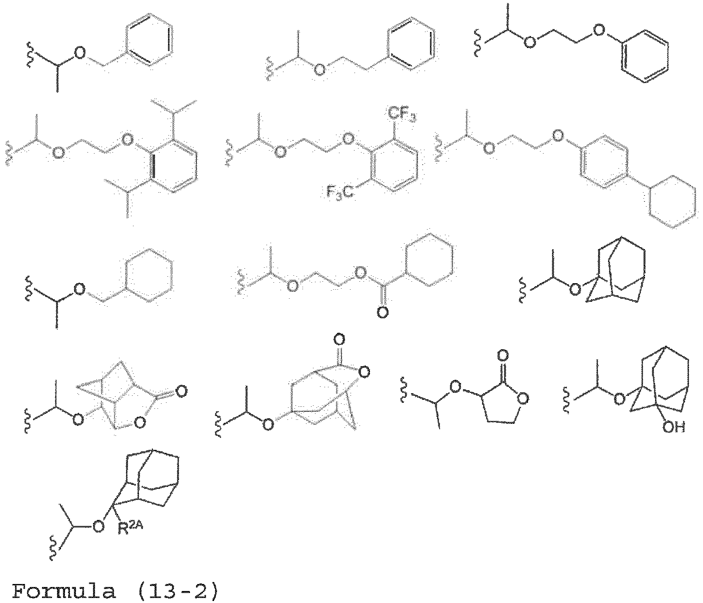

In the above formula (13-2), R^{2A} is as defined in the above formula (13-1).

The 1-substituted n-propyl group is not particularly limited, but can be usually a 1-substituted n-propyl group of 4 to 20 carbon atoms and is preferably a 1-substituted n-propyl group of 6 to 18 carbon atoms and more preferably a 1-substituted n-propyl group of 8 to 16 carbon atoms. Specific examples of the 1-substituted n-propyl group can include, but not limited to, a 1-methoxy-n-propyl group and a 1-ethoxy-n-propyl group.

The 1-branched alkyl group is not particularly limited, but can be usually a 1-branched alkyl group of 3 to 20 carbon atoms and is preferably a 1-branched alkyl group of 5 to 18 carbon atoms and more preferably a branched alkyl group of 7 to 16 carbon atoms. Specific examples of the 1-branched alkyl group can include, but not limited to, an isopropyl group, a sec-butyl group, a tert-butyl group, a 1,1-dimethylpropyl group, a 1-methylbutyl group, a 1,1-dimethylbutyl group, a 2-methyladamantyl group, and a 2-ethyladamantyl group.

The silyl group is not particularly limited, but can be usually a silyl group of 1 to 20 carbon atoms and is preferably a silyl group of 3 to 18 carbon atoms and more preferably a silyl group of 5 to 16 carbon atoms. Specific examples of the silyl group can include, but not limited to, a trimethylsilyl group, an ethyldimethylsilyl group, a methyldiethylsilyl group, a triethylsilyl group, a tert-butyldimethylsilyl group, a tert-butyldiethylsilyl group, a tert-butyldiphenylsilyl group, a tri-tert-butylsilyl group, and a triphenylsilyl group.

The acyl group is not particularly limited, but can be usually an acyl group of 2 to 20 carbon atoms and is preferably an acyl group of 4 to 18 carbon atoms and more preferably an acyl group of 6 to 16 carbon atoms. Specific examples of the acyl group can include, but not limited to, an acetyl group, a phenoxyacetyl group, a propionyl group, a butyryl group, a heptanoyl group, a hexanoyl group, a valeryl group, a pivaloyl group, an isovaleryl group, a lauroyl group, an adamantylcarbonyl group, a benzoyl group, and a naphthoyl group.

The 1-substituted alkoxymethyl group is not particularly limited, but can be usually a 1-substituted alkoxymethyl group of 2 to 20 carbon atoms and is preferably a 1-substituted alkoxymethyl group of 4 to 18 carbon atoms and more preferably a 1-substituted alkoxymethyl group of 6 to 16 carbon atoms. Specific examples of the 1-substituted alkoxymethyl group can include, but not limited to, a 1-cyclopentylmethoxymethyl group, a 1-cyclopentylethoxymethyl group, a 1-cyclohexylmethoxymethyl group, a 1-cyclohexylethoxymethyl group, a 1-cyclooctylmethoxymethyl group, and a 1-adamantylmethoxymethyl group.

The cyclic ether group is not particularly limited, but can be usually a cyclic ether group of 2 to 20 carbon atoms and is preferably a cyclic ether group of 4 to 18 carbon atoms and more preferably a cyclic ether group of 6 to 16 carbon atoms. Specific examples of the cyclic ether group can include, but not limited to, a tetrahydropyranyl group, a tetrahydrofuranyl group, a tetrahydrothiopyranyl group, a tetrahydrothiofuranyl group, a 4-methoxytetrahydropyranyl group, and a 4-methoxytetrahydrothiopyranyl group.

The alkoxycarbonyl group can be usually an alkoxycarbonyl group of 2 to 20 carbon atoms and is preferably an alkoxycarbonyl group of 4 to 18 carbon atoms and more preferably an alkoxycarbonyl group of 6 to 16 carbon atoms. Specific examples of the alkoxycarbonyl group can include, but not limited to, a methoxycarbonyl group, an ethoxycarbonyl group, a n-propoxycarbonyl group, an isopropoxycarbonyl group, a n-butoxycarbonyl group, a tert-butoxycarbonyl group, and a group of acid dissociation reactive groups represented by the following formula (13-3) wherein n = 0.

The alkoxycarbonylalkyl group is not particularly limited, but can be usually an alkoxycarbonylalkyl group of 2 to 20 carbon atoms and is preferably an alkoxycarbonylalkyl group of 4 to 18 carbon atoms and more preferably an alkoxycarbonylalkyl group of 6 to 16 carbon atoms. Specific examples of the alkoxycarbonylalkyl group can include, but not limited to, a methoxycarbonylmethyl group, an ethoxycarbonylmethyl group, a n-propoxycarbonylmethyl group, an isopropoxycarbonylmethyl group, a n-butoxycarbonylmethyl group, and a group of acid dissociation reactive groups represented by the following formula (13-3) wherein n = 1 to 4:

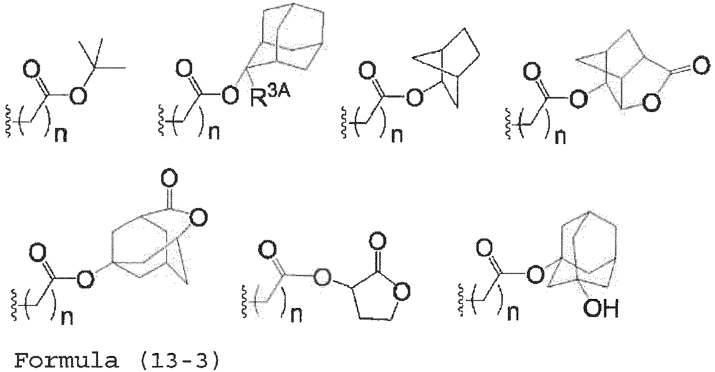

In the above formula (13-3), R^{3A} is a hydrogen atom or a linear or branched alkyl group of 1 to 4 carbon atoms; and n is an integer of 0 to 4.

Among these acid dissociation reactive groups, a substituted methyl group, a 1-substituted ethyl group, a 1-substituted alkoxymethyl group, a cyclic ether group, an alkoxycarbonyl group, and an alkoxycarbonylalkyl group are preferable. From the viewpoint of exerting higher sensitivity, a substituted methyl group, a 1-substituted ethyl group, an alkoxycarbonyl group, and an alkoxycarbonylalkyl group are more preferable, and an acid dissociation reactive group having a structure selected from a cycloalkane of 3 to 12 carbon atoms, a lactone, and an aromatic ring of 6 to 12 carbon atoms is further preferable. The cycloalkane of 3 to 12 carbon atoms may be monocyclic or polycyclic and is preferably polycyclic. Specific examples of the cycloalkane of 3 to 12 carbon atoms include, but not limited to, monocycloalkanes, bicycloalkanes, tricycloalkanes, and tetracycloalkanes. More specific examples thereof include, but not limited to: monocycloalkanes such as cyclopropane, cyclobutane, cyclopentane, and cyclohexane; and polycycloalkanes such as adamantane, norbornane, isobornane, tricyclodecane, and tetracyclodecane. Among them, adamantane, tricyclodecane, and tetracyclodecane are preferable, and adamantane and tricyclodecane are more preferable. The cycloalkane of 3 to 12 carbon atoms may have a substituent group. Examples of the lactone include, but not limited to, cycloalkane groups of 3 to 12 carbon atoms having a butyrolactone or lactone group. Examples of the aromatic ring of 6 to 12 carbon atoms include, but not limited to, a benzene ring, a naphthalene ring, an anthracene ring, a phenanthrene ring, and a pyrene ring. A benzene ring and a naphthalene ring are preferable, and a naphthalene ring is more preferable.

Particularly, a group of acid dissociation reactive groups selected from the group consisting of groups represented by the following formula (13-4) is preferable because of high resolution:

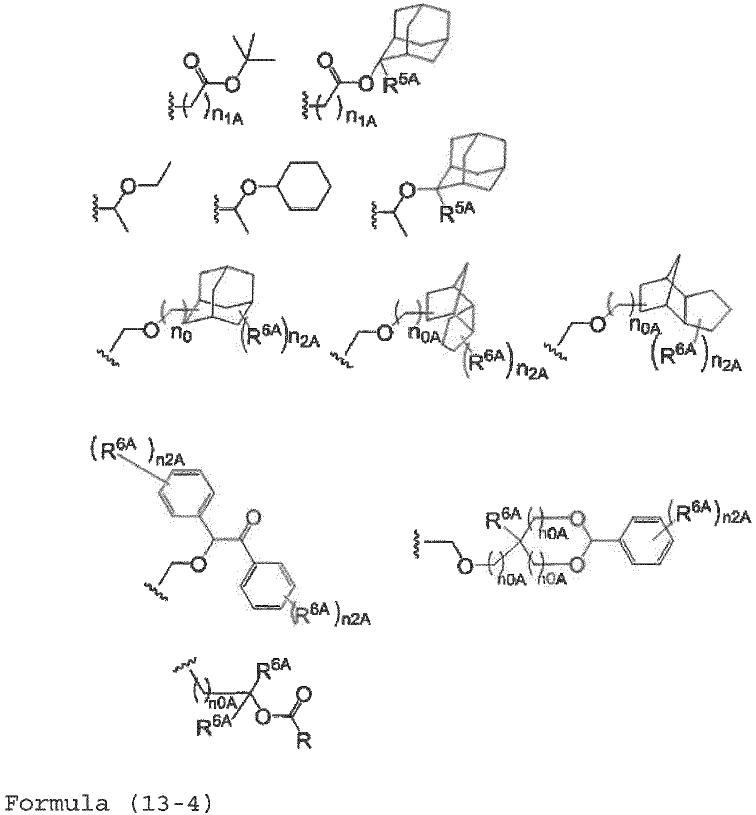

In the above formula (13-4), R^{5A} is a hydrogen atom or a linear or branched alkyl group of 1 to 4 carbon atoms; R^{6A} is a hydrogen atom, a linear or branched alkyl group of 1 to 4 carbon atoms, a cyano group, a nitro group, a heterocyclic group, a halogen atom, or a carboxyl group; n_{1A} is an integer of 0 to 4; n_{2A} is an integer of 1 to 5; and n_{0A} is an integer of 0 to 4.

Owing to the structural features mentioned above, the compound represented by the above formula (1A) has high heat resistance attributed to its rigidity despite a low molecular weight and can be used even under high temperature baking conditions. Also, the composition for resist underlayer film formation of the present embodiment has such a low molecular weight and can be baked at a high temperature, while the material for lithography of the present embodiment has high sensitivity and can further impart a good shape to a resist pattern, because of comprising the tellurium-containing compound.

In the present embodiment, the compound represented by the above formula (1A) is preferably a compound represented by the following formula (1B) from the viewpoint of solubility in a safe solvent:

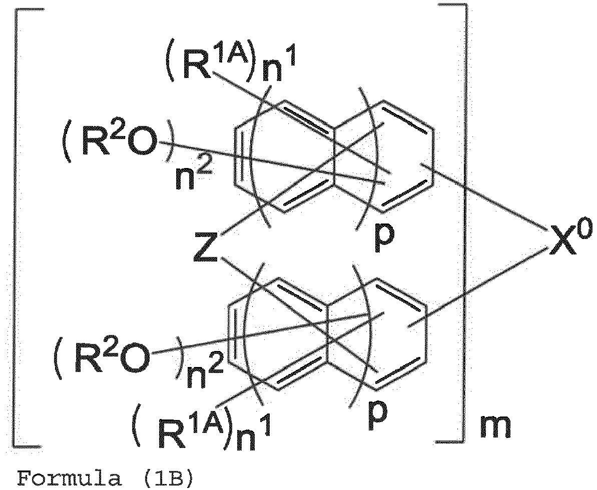

(In the formula (1B), X⁰, Z, m, and p are as defined in the above formula (A-3); each R^{1A} is independently an alkyl group, an aryl group, an alkenyl group, or a halogen atom; each R² is independently a hydrogen atom, an acid crosslinking reactive group, or an acid dissociation reactive group; each n¹ is independently an integer of 0 to (5 + 2 × p); and each n² is independently an integer of 0 to (5 + 2 × p), provided that at least one n² is an integer of 1 to (5 + 2 × p).)

In the present embodiment, the compound represented by the above formula (1B) is preferably a compound represented by the following formula (2A) from the viewpoint of solubility in a safe solvent and the properties of a resist pattern:

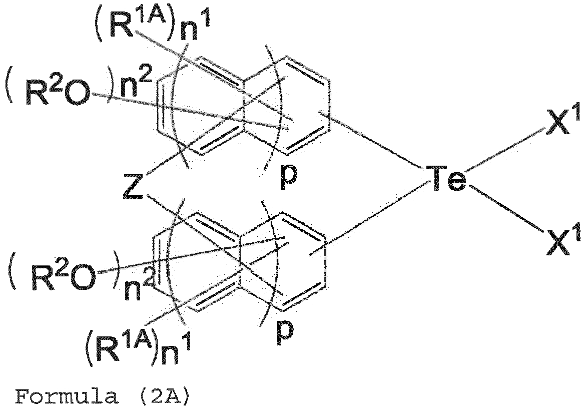

(In the formula (2A) , Z, R¹, R², p, n¹, and n² are as defined in the above formula (1B); and each X¹ is independently a monovalent group containing an oxygen atom, a monovalent group containing a sulfur atom, a monovalent group containing a nitrogen atom, a hydrocarbon group, a hydrogen atom, or a halogen atom.)

In the present embodiment, the compound represented by the above formula (2A) is preferably a compound represented by the formula (2A') given below from the viewpoint of easy physical property control. The compound represented by the above formula (2A') is an asymmetric compound, and members in at least one of the combinations R^{1B} and R^{1B'}, n¹ and n^{1'}, p and p', and the substitution position of R^{1B} and the substitution position of R^{1B'} differ from each other.

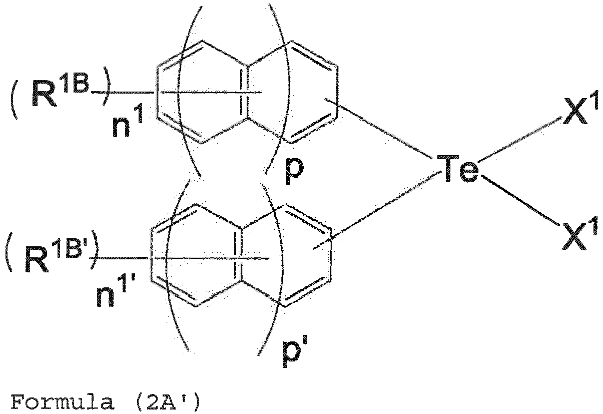

(In the formula (2A'), R^{1B} and R^{1B'} are each independently an alkyl group, an aryl group, an alkenyl group, a halogen atom, a hydroxy group or a group in which a hydrogen atom of a hydroxy group is substituted with an acid crosslinking reactive group or an acid dissociation reactive group; X¹ is as defined as X¹ in the above formula (2A); n¹ and n^{1'} are as defined as n¹ in the above formula (2A); p and p' are as defined as p in the above formula (2A) (i.e., each X¹ is independently a monovalent group containing an oxygen atom, a monovalent group containing a sulfur atom, a monovalent group containing a nitrogen atom, a hydrocarbon group, a hydrogen atom, or a halogen atom); and members in at least one combination selected from R^{1B} and R^{1B'}, n¹ and n^{1'}, p and p', and the substitution position of R^{1B} and the substitution position of R^{1B'} differ from each other.)

In the present embodiment, the compound represented by the above formula (2A) is preferably a compound represented by the following formula (3A) from the viewpoint of heat resistance:

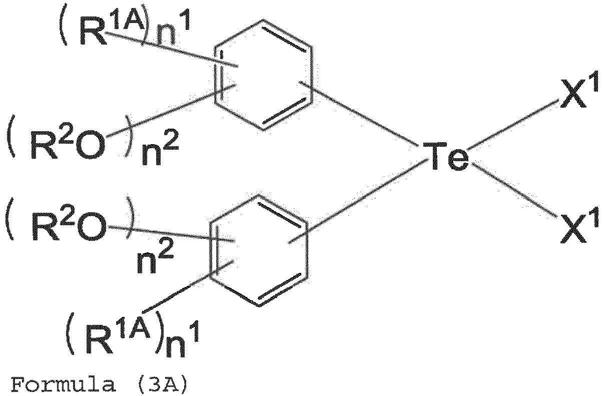

(In the formula (3A), R^{1A}, R², X¹, n¹, and n² are as defined in the above formula (2A).)

In the present embodiment, the compound represented by the above formula (3A) is preferably a compound represented by the following general formula (4A) from the viewpoint of easy production:

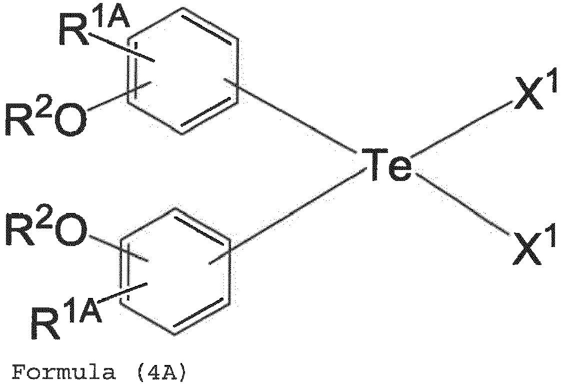

(In the formula (4A), R¹, R², and X¹ are as defined above.)

In the present embodiment, X¹ in the formulae (2A), (2A'), (3A), and (4A) is more preferably a halogen atom from the viewpoint of easy production.

In the present embodiment, the compound represented by the above formula (1B) is preferably a compound represented by the following formula (2B) from the viewpoint of solubility in a safe solvent and the properties of a resist pattern:

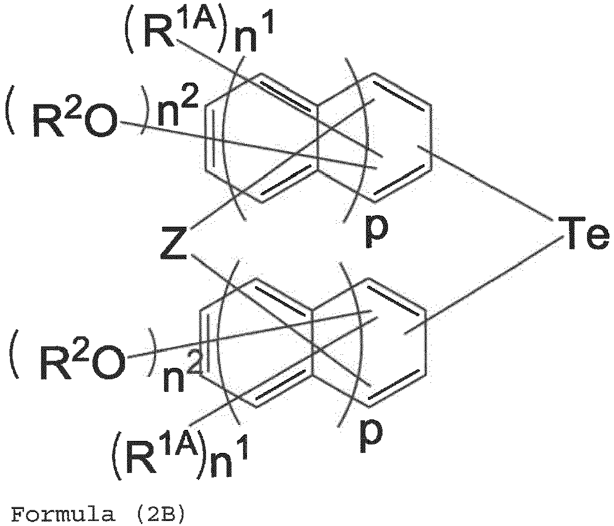

(In the formula (2B), Z, R^{1A}, R², p, n¹, and n² are as defined in the above formula (1B).)

In the present embodiment, the compound represented by the above formula (2B) is preferably a compound represented by the formula (2B') given below from the viewpoint of easy physical property control. The compound represented by the above formula (2B') is an asymmetric compound, and members in at least one of the combinations R^{1B} and R^{1B'}, n¹ and n^{1'}, p and p', and the substitution position of R^{1B} and the substitution position of R^{1B'} differ from each other.

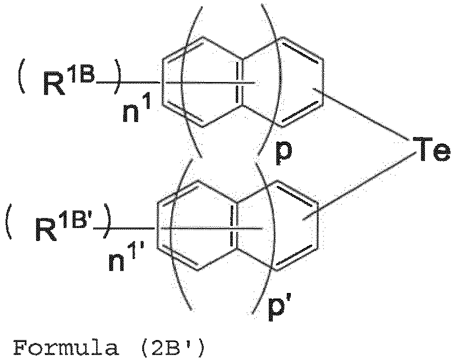

(In the formula (2B'), R^{1B} and R^{1B'} are each independently an alkyl group, an aryl group, an alkenyl group, a halogen atom, a hydroxy group or a group in which a hydrogen atom of a hydroxy group is substituted with an acid crosslinking reactive group or an acid dissociation reactive group; n¹ and n^{1'} are as defined as n¹ in the above formula (2B); p and p' are as defined as p in the above formula (2B) (i.e., p and p' are each independently an integer of 0 to 2, and n¹ and n^{1'} are each independently an integer of 0 to (5 + 2 × p) or 0 to (5 + 2 × p')); and members in at least one combination selected from R^{1B} and R^{1B'}, n¹ and n^{1'}, p and p', and the substitution position of R^{1B} and the substitution position of R^{1B'} differ from each other.)

In the present embodiment, the compound represented by the above formula (2B) is preferably a compound represented by the following formula (3B) from the viewpoint of heat resistance:

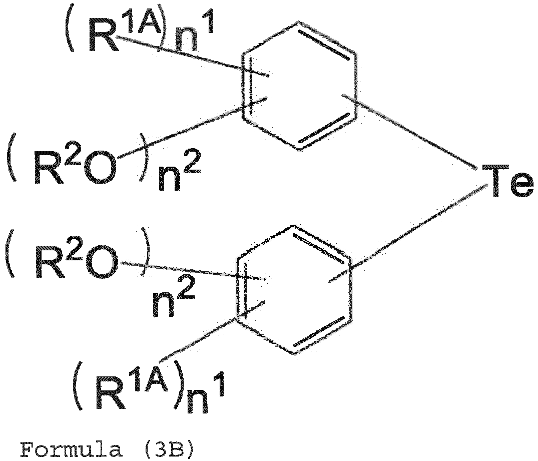

(In the formula (3B), R^{1A}, R², n¹, and n² are as defined in the above formula (2B).)

In the present embodiment, the compound represented by the above formula (3B) is preferably a compound represented by the following general formula (4B) from the viewpoint of easy production:

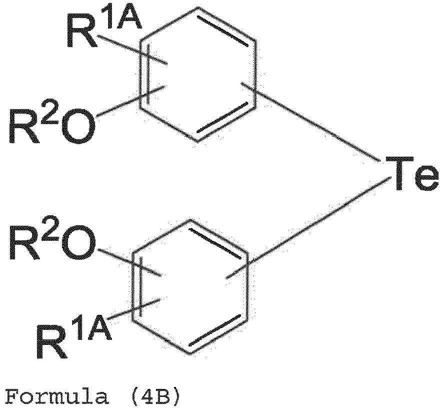

(In the formula (4B), R¹, R², and X¹ are as defined in the above formula (3B).)

In the present embodiment, in the case of forming a positive type pattern by alkaline development or in the case of forming a negative type pattern by organic development, the compound represented by the above formula (1A) preferably has at least one acid dissociation reactive group as R^{2'}. Such a tellurium-containing compound having at least one acid dissociation reactive group can be a tellurium-containing compound represented by the following formula (1A'):

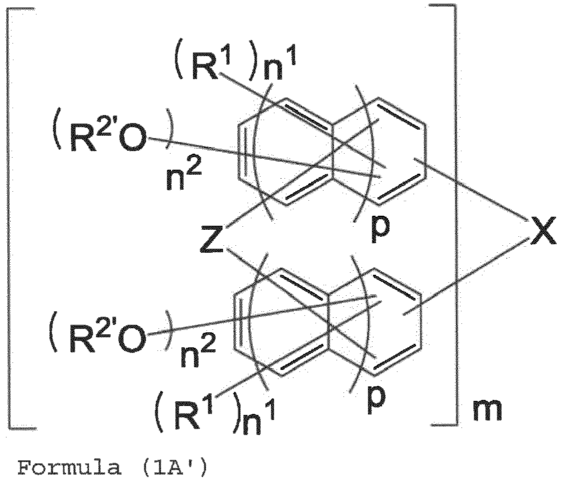

(In the formula (1A'), X, Z, m, p, R¹, n¹, and n² are as defined in the above formula (1A); and each R^{2'} is independently a hydrogen atom, an acid crosslinking reactive group, or an acid dissociation reactive group, and at least one R^{2'} is an acid dissociation reactive group.)

In the present embodiment, in the case of forming a negative type pattern by alkaline development, a tellurium-containing compound wherein all of R² are hydrogen atoms can be used as the compound represented by the above formula (1A). Such a compound can be a compound represented by the following general formula (1A").

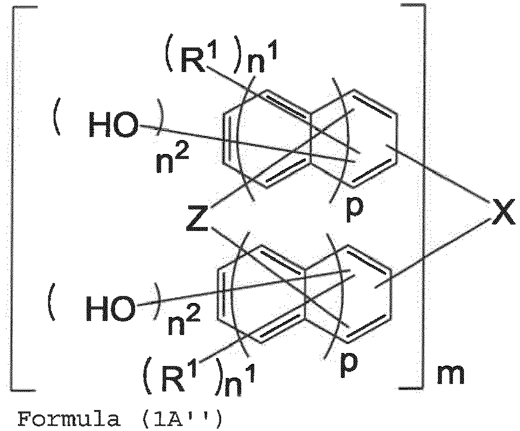

(In the above formula (1A"), X, Z, R¹, m, p, n¹, and n² are as defined in the formula (1A).)

In the present embodiment, in the case of forming a positive type pattern by alkaline development or in the case of forming a negative type pattern by organic development, the compound represented by the above formula (1B) preferably has at least one acid dissociation reactive group as R^{2'}. Such a tellurium-containing compound having at least one acid dissociation reactive group can be a tellurium-containing compound represented by the following formula (1B'):

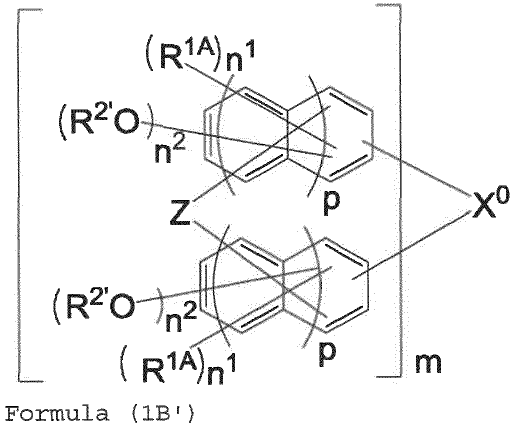

(In the formula (1B'), X⁰, Z, m, p, R^{1A}, n¹, and n² are as defined in the above formula (1B); and each R^{2'} is independently a hydrogen atom or an acid dissociation reactive group, and at least one R^{2'} is an acid dissociation reactive group.)

In the present embodiment, in the case of forming a negative type pattern by alkaline development, a tellurium-containing compound wherein all of R² are hydrogen atoms can be used as the compound represented by the above formula (1B). Such a compound can be a compound represented by the following general formula (1B"):

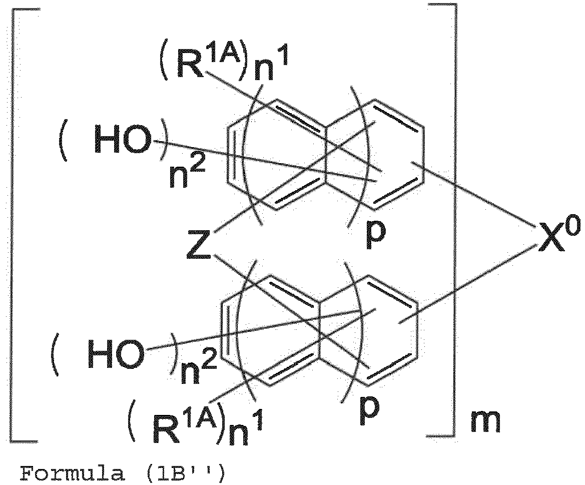

(In the formula (1B''), X⁰, Z, m, p, R^{1A}, n¹, and n² are as defined in the above formula (1B)).

In the present embodiment, a method for producing the compound represented by the above formula (A-1) is not particularly limited, and the compound represented by the above formula (A-1) can be obtained, for example, by reacting an alkoxybenzene with a corresponding tellurium halide to obtain a polyalkoxybenzene compound, subsequently performing reduction reaction with a reducing agent such as boron tribromide to obtain a polyphenol compound, and introducing an acid dissociation reactive group to at least one phenolic hydroxy group of the obtained polyphenol compound by a publicly known method.

Also, the compound represented by the above formula (A-1) can be obtained by reacting a phenol or a thiophenol with a corresponding tellurium halide to obtain a polyphenol compound, and introducing an acid dissociation reactive group to at least one phenolic hydroxy group of the obtained polyphenol compound by a publicly known method.

Further, the compound represented by the above formula (A-1) can be obtained by reacting a phenol or a thiophenol with a corresponding aldehyde containing tellurium or ketone containing tellurium in the presence of an acid or basic catalyst to obtain a polyphenol compound, and introducing an acid dissociation reactive group to at least one phenolic hydroxy group of the obtained polyphenol compound by a publicly known method.

The tellurium-containing compound can be synthesized, for example, by reacting a tellurium halide such as tellurium tetrachloride (tellurium(IV) tetrachloride) with a substituted or unsubstituted phenol derivative in the presence of a basic catalyst, as mentioned later, though the synthesis method is not particularly limited thereto. Specifically, the composition for resist underlayer film formation of the present embodiment can be produced by a method for producing the composition for resist underlayer film formation, comprising the step of reacting a tellurium halide with a substituted or unsubstituted phenol derivative in the presence of a basic catalyst to synthesize the tellurium-containing compound.

Upon synthesizing the compound represented by the formula (A-1), etc. by reacting a tellurium halide with a phenol, for example, a method of reacting the tellurium halide with the phenol and additionally reacting the phenol after the reaction terminates may be used. According to this method, a highly pure polyphenol compound can be obtained because a polyalkoxybenzene compound is bypassed.

In this method, for example, the tellurium halide and the phenol are reacted in an amount of 0.4 to 1.2 mol of the phenol based on 1 mol of the tellurium halide, and the phenol can be additionally reacted after the reaction terminates, from the viewpoint of obtaining the target polyphenol compound at a high yield.

Such a method can also be a method of reacting the tellurium halide with a phenol [I] and additionally reacting a phenol [II] after the reaction terminates, the phenol [I] and the phenol [II] used being different phenols, from the viewpoint of increasing the type of the polyphenol compound that can be obtained by reacting different phenols.

For such a method, it is desirable to separate a reaction intermediate after the reaction of the tellurium halide with the phenol terminates, and using only the reaction intermediate in the reaction with the phenol, from the viewpoint of obtaining a polyphenol compound with high purity. The reaction intermediate can be separated by a publicly known method. The method for separating the reaction intermediate is not particularly limited, and the intermediate can be separated by, for example, filtration.

In reaction to obtain a tellurium-containing resin from a tellurium halide and a phenol, 3 mol or more of the phenol based on 1 mol of the tellurium halide may be used from the viewpoint of improvement in yield. In the reaction to obtain a tellurium-containing resin from a tellurium halide and a phenol, a production method using 3 mol or more of the phenol based on 1 mol of the tellurium halide is particularly preferable as a method for producing the compounds represented by the formula (C1) and the formula (C2), though the production method is not limited thereto

Examples of the tellurium halide include, but not particularly limited to, tellurium(IV) tetrafluoride, tellurium(IV) tetrachloride, tellurium(IV) tetrabromide, and tellurium(IV) tetraiodide.

Examples of the alkoxybenzene include, but not particularly limited to, methoxybenzene, dimethoxybenzene, methylmethoxybenzene, methyldimethoxybenzene, phenylmethoxybenzene, phenyldimethoxybenzene, methoxynaphthalene, dimethoxynaphthalene, ethoxybenzene, diethoxybenzene, methylethoxybenzene, methyldiethoxybenzene, phenylethoxybenzene, phenyldiethoxybenzene, ethoxynaphthalene, and diethoxynaphthalene.

Upon producing the polyalkoxybenzene compound, a reaction solvent may be used. The reaction solvent is not particularly limited as long as the reaction of the alkoxybenzene used with the corresponding tellurium halide proceeds. For example, water, methylene chloride, methanol, ethanol, propanol, butanol, tetrahydrofuran, dioxane, dimethylacetamide, N-methylpyrrolidone, or a mixed solvent thereof can be used.

The amount of the solvent is not particularly limited and can be in the range of, for example, 0 to 2000 parts by mass based on 100 parts by mass of the reaction raw materials.

Upon producing the polyphenol compound containing tellurium, the reaction temperature is not particularly limited and can be arbitrarily selected according to the reactivity of the reaction raw materials, but is preferably in the range of 10 to 200°C.

Examples of a method for producing the polyalkoxybenzene include, but not particularly limited to, a method of charging the alkoxybenzene and the corresponding tellurium halide in one portion, and a method of dropping the alkoxybenzene and the corresponding tellurium halide. After the reaction terminates, the temperature of the reaction vessel can be elevated to 130 to 230°C in order to remove unreacted raw materials, etc. present in the system, and volatile portions can be removed at about 1 to 50 mmHg.

The amounts of the raw materials upon producing the polyalkoxybenzene compound are not particularly limited. The reaction can be proceeded by using, for example, 1 mol to an excess of the alkoxybenzene based on 1 mol of the tellurium halide, and reacting them at 20 to 150°C at normal pressure for about 20 minutes to 100 hours.

Upon producing the polyalkoxybenzene compound, the target component can be isolated by a publicly known method after the reaction terminates. Examples of the method for isolating the target component include, but not particularly limited to, a method which involves concentrating the reaction solution, precipitating the reaction product by the addition of pure water, cooling the reaction solution to room temperature, then separating the precipitates by filtration, filtering and drying the obtained solid matter, then separating and purifying the solid matter from by-products by column chromatography, and distilling off the solvent, followed by filtration and drying to obtain the target compound.

The polyphenol compound can be obtained by reducing the polyalkoxybenzene compound. The reduction reaction can be performed using a reducing agent such as boron tribromide. Upon producing the polyphenol compound, a reaction solvent may be used. The reaction time, the reaction temperature, the amounts of raw materials, and an isolation method are not particularly limited as long as the polyphenol compound is obtained.

Examples of the phenol include, but are not particularly limited to, phenol, dihydroxybenzenes, trihydroxybenzenes, naphthols, dihydroxynaphthalenes, trihydroxyanthracenes, hydroxybiphenols, dihydroxybiphenols, phenols having an alkyl group having 1 to 4 carbon atoms and/or a phenyl group at their side chains, and naphthols having an alkyl group having 1 to 4 carbon atoms and/or a phenyl group at their side chains.

A publicly known method can be used as a method for introducing an acid dissociation reactive group to at least one phenolic hydroxy group of the polyphenol compound. An acid dissociation reactive group can be introduced to at least one phenolic hydroxy group of the polyphenol compound, for example, as described below. A compound for introducing the acid dissociation reactive group can be synthesized by a publicly known method or easily obtained. Examples thereof include, but not particularly limited to, acid chlorides, acid anhydrides, active carboxylic acid derivative compounds such as dicarbonate, alkyl halides, vinyl alkyl ethers, dihydropyran, and halocarboxylic acid alkyl esters.

For example, the polyphenol compound is dissolved or suspended in an aprotic solvent such as acetone, tetrahydrofuran (THF), propylene glycol monomethyl ether acetate, dimethylacetamide, or N-methylpyrrolidone. Subsequently, a vinyl alkyl ether such as ethyl vinyl ether, or dihydropyran is added to the solution or the suspension, and the mixture is reacted at 20 to 60°C at normal pressure for 6 to 72 hours in the presence of an acid catalyst such as pyridinium p-toluenesulfonate. The reaction solution is neutralized with an alkali compound and added to distilled water to precipitate a white solid. Then, the separated white solid can be washed with distilled water and dried to obtain the compound represented by the above formula (A-1).

The acid catalyst is not particularly limited. Inorganic acids and organic acids are widely known as well-known acid catalysts, and examples include, but not particularly limited to, inorganic acids such as hydrochloric acid, sulfuric acid, phosphoric acid, hydrobromic acid, and hydrofluoric acid; organic acids such as oxalic acid, malonic acid, succinic acid, adipic acid, sebacic acid, citric acid, fumaric acid, maleic acid, formic acid, p-toluenesulfonic acid, methanesulfonic acid, trifluoroacetic acid, dichloroacetic acid, trichloroacetic acid, trifluoromethanesulfonic acid, benzenesulfonic acid, naphthalenesulfonic acid, and naphthalenedisulfonic acid; Lewis acids such as zinc chloride, aluminum chloride, iron chloride, and boron trifluoride; and solid acids such as tungstosilicic acid, tungstophosphoric acid, silicomolybdic acid, and phosphomolybdic acid. Among them, organic acids and solid acids are preferable from the viewpoint of production, and hydrochloric acid or sulfuric acid is preferably used from the viewpoint of production such as easy availability and handleability. The acid catalysts can be used alone as one kind, or can be used in combination of two or more kinds.

Also, for example, the polyphenol compound is dissolved or suspended in an aprotic solvent such as acetone, THF, propylene glycol monomethyl ether acetate, dimethylacetamide, or N-methylpyrrolidone. Subsequently, an alkyl halide such as ethyl chloromethyl ether or a halocarboxylic acid alkyl ester such as methyladamantyl bromoacetate is added to the solution or the suspension, and the mixture is reacted at 20 to 110°C at normal pressure for 6 hours to 72 hours in the presence of an alkali catalyst such as potassium carbonate. The reaction solution is neutralized with an acid such as hydrochloric acid and added to distilled water to precipitate a white solid. Then, the separated white solid can be washed with distilled water and dried to obtain the compound represented by the above formula (A-1) .

The basic catalyst is not particularly limited and can be arbitrarily selected from well-known basic catalysts, and examples include: inorganic bases such as metal hydrides (alkali metal hydrides such as sodium hydride and potassium hydride, etc.), metal alcohol salts (alcohol salts of alkali metals such as sodium methoxide and potassium ethoxide), metal hydroxides (alkali metal or alkaline earth metal hydroxides such as sodium hydroxide and potassium hydroxide, etc.), metal carbonates (alkali metal or alkaline earth metal carbonates such as sodium carbonate and potassium carbonate, etc.), and alkali metal or alkaline earth metal bicarbonates such as sodium bicarbonate and potassium bicarbonate; and organic bases such as amines (for example, tertiary amines (trialkylamines such as triethylamine, aromatic tertiary amines such as N,N-dimethylaniline, and heterocyclic tertiary amines such as 1-methylimidazole), and carboxylic acid metal salts (acetic acid alkali metal or alkaline earth metal salts such as sodium acetate and calcium acetate, etc.). Sodium carbonate or potassium carbonate is preferable from the viewpoint of production such as easy availability and handleability. One kind or two or more kinds of the basic catalysts can be used.

The acid dissociation reactive group preferably has the property of causing chained cleavage reaction in the presence of an acid, for achieving pattern formation with higher sensitivity and higher resolution.

Specific examples of the tellurium-containing compound represented by the formula (A-1) can include the following:

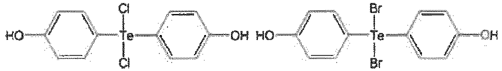

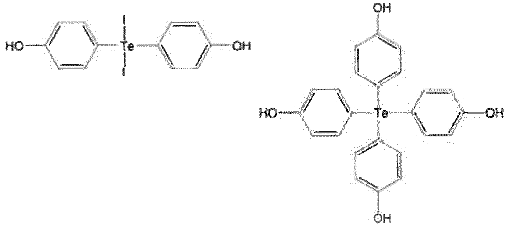

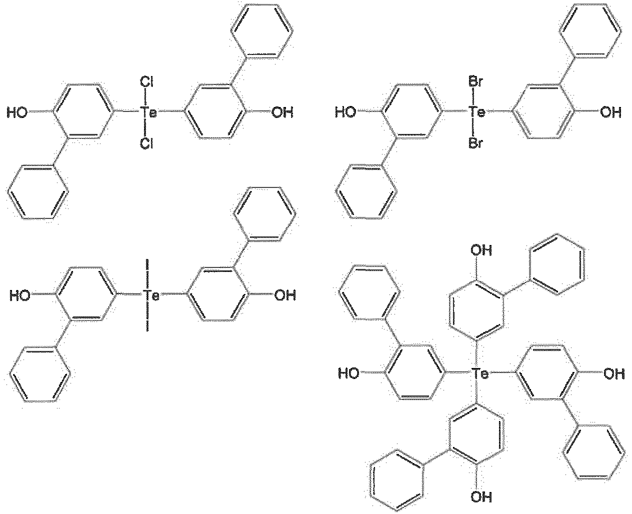

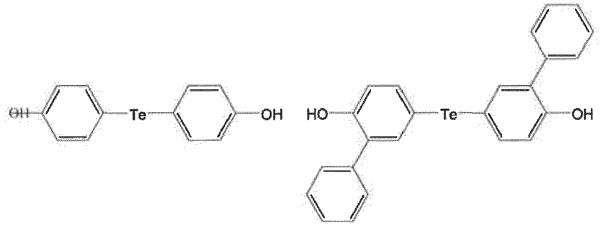

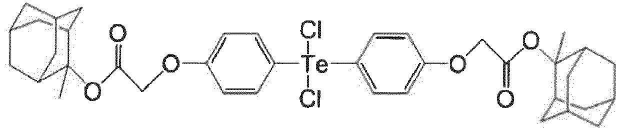

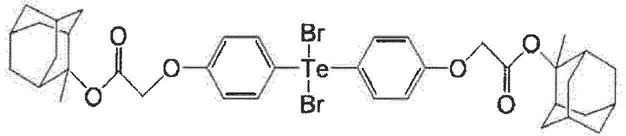

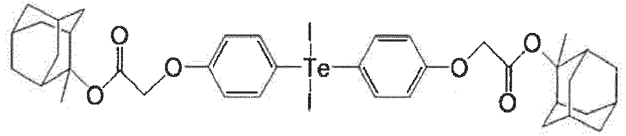

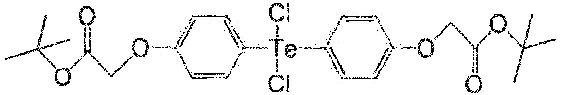

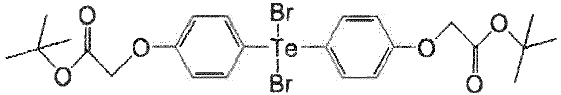

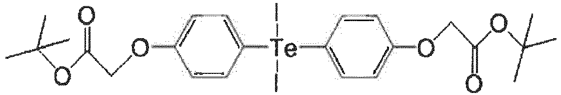

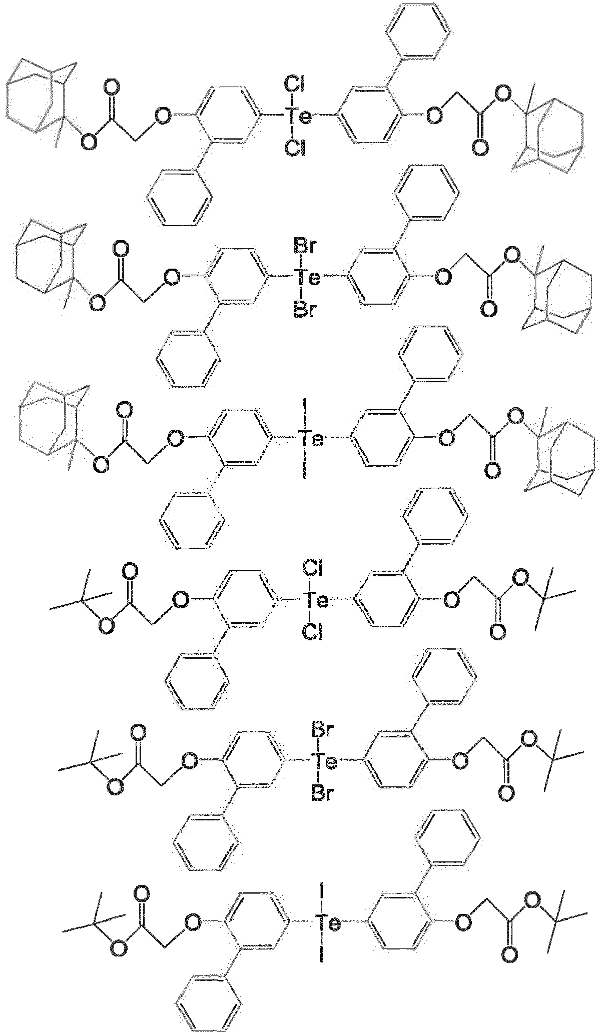

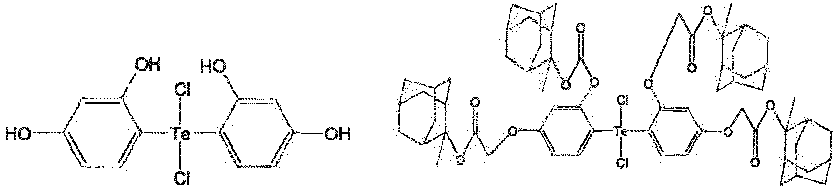

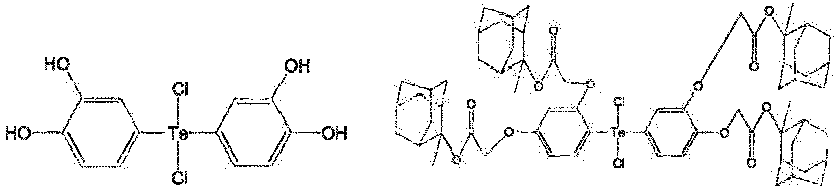

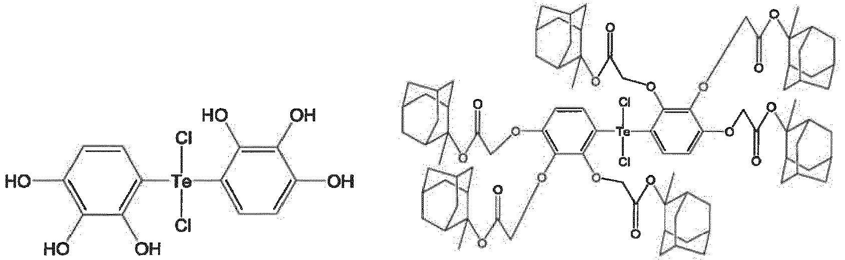

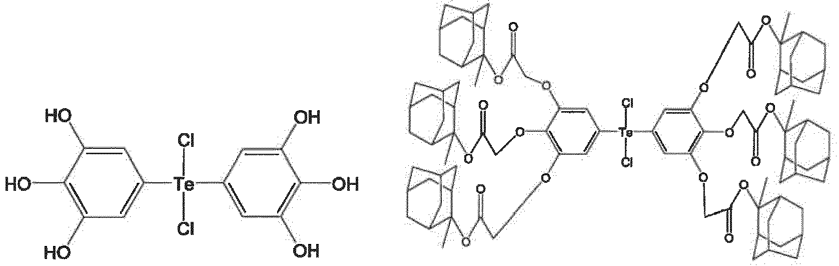

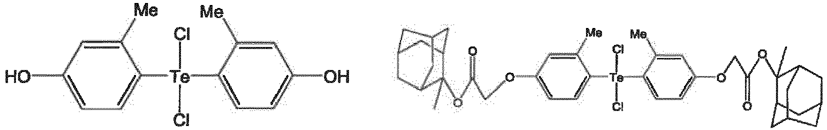

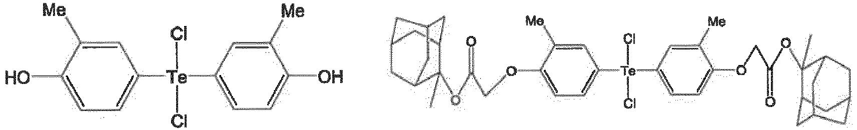

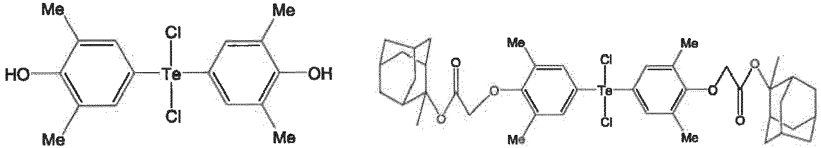

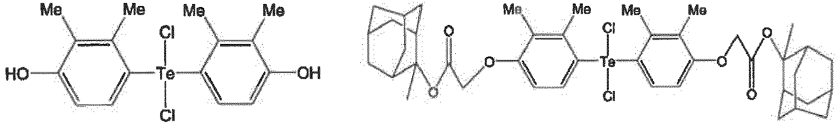

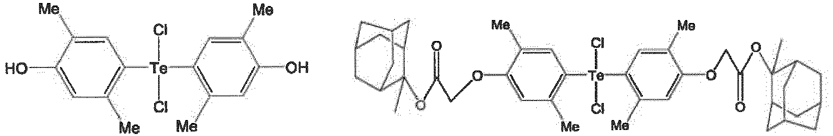

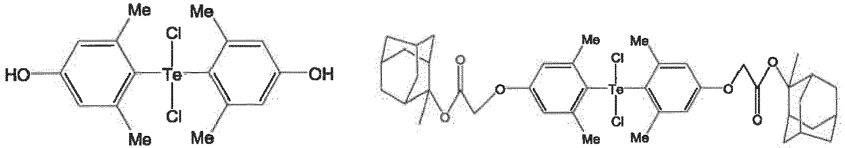

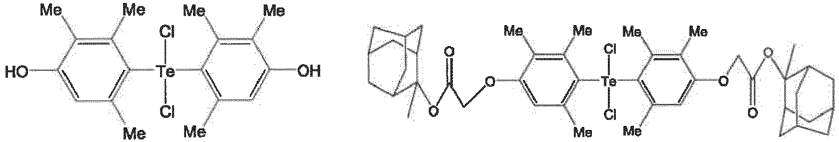

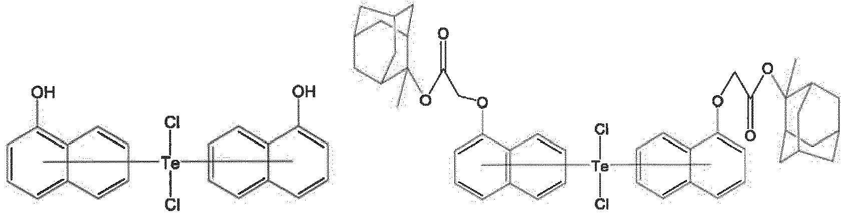

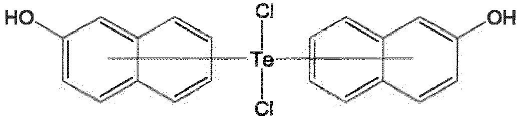

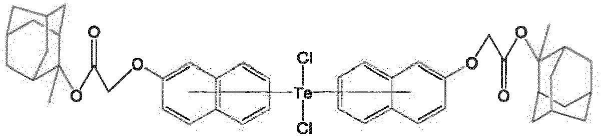

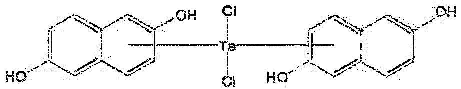

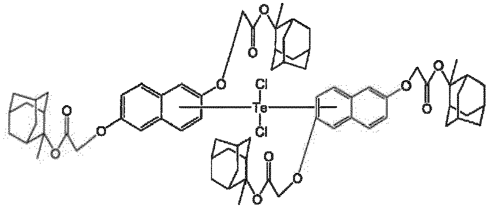

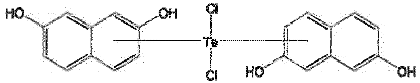

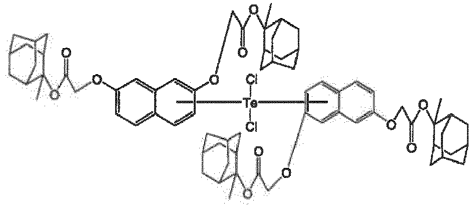

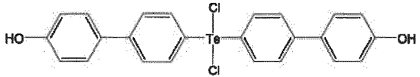

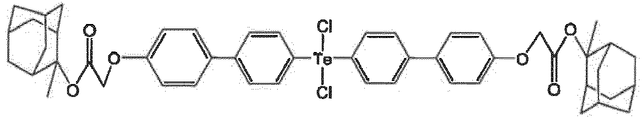

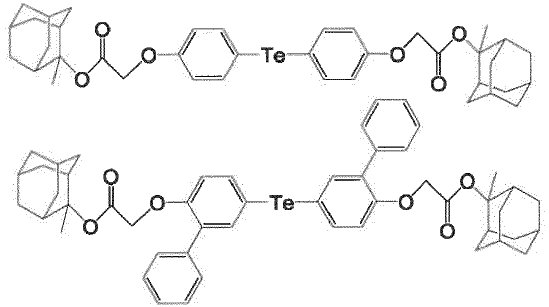

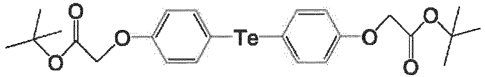

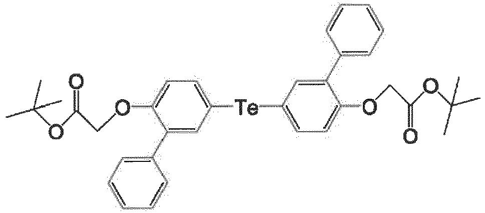

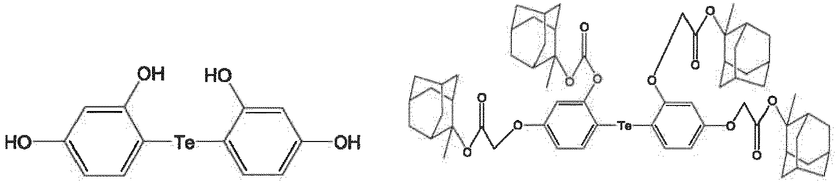

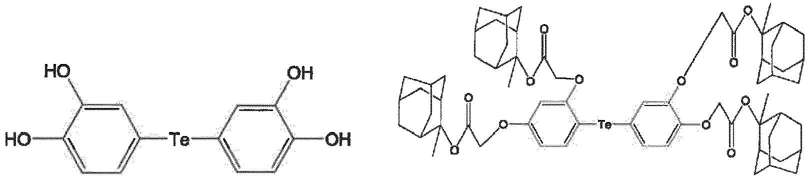

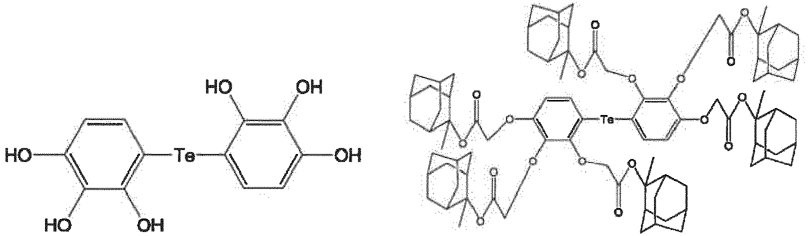

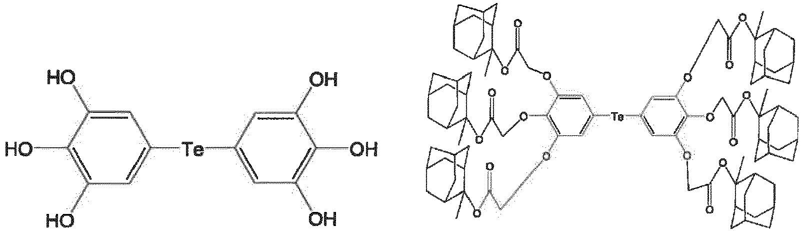

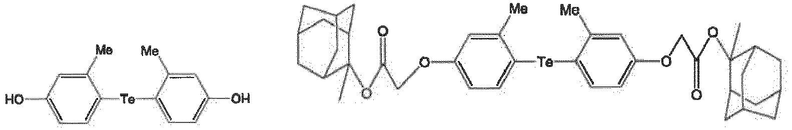

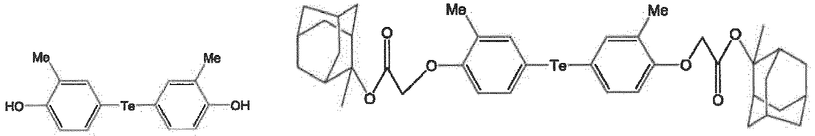

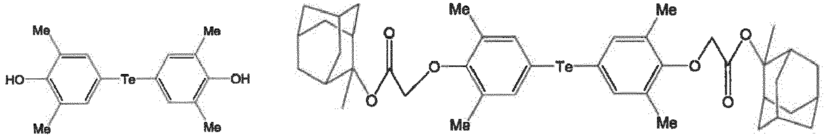

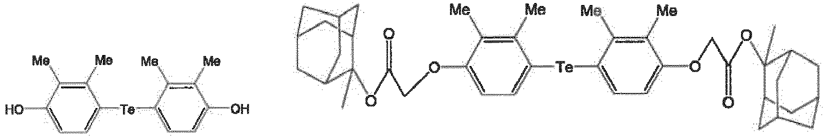

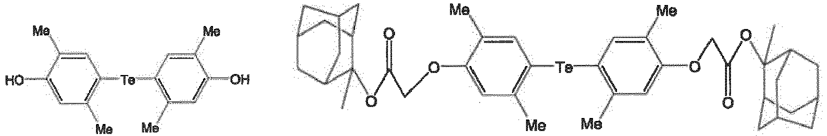

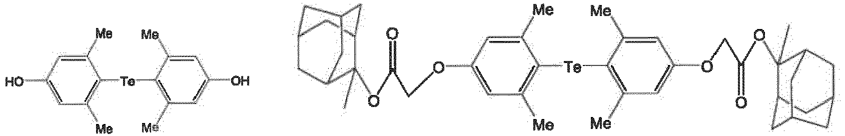

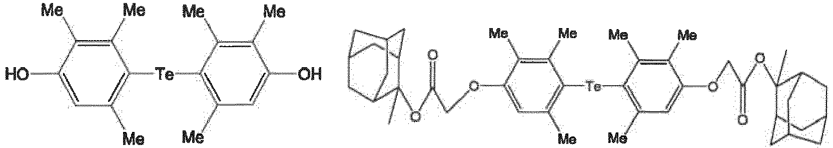

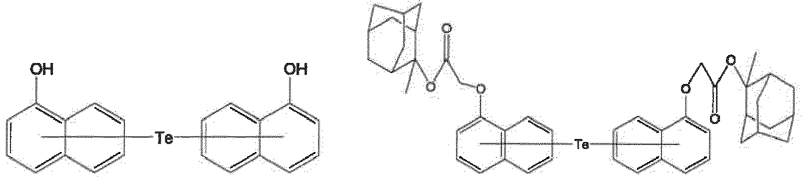

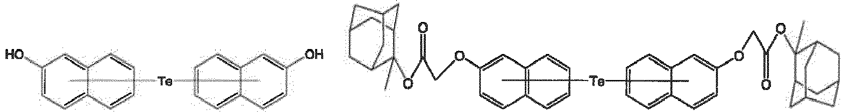

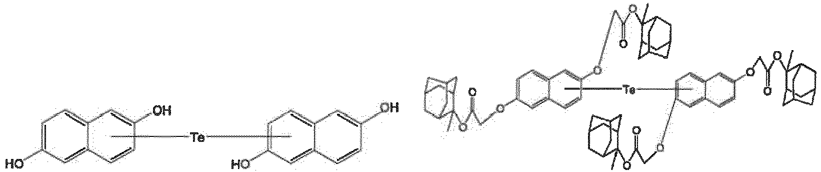

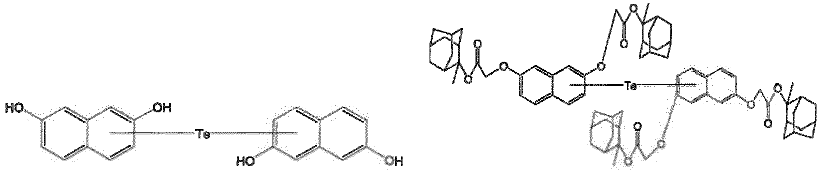

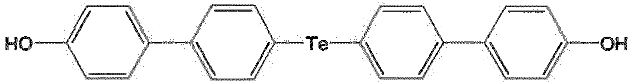

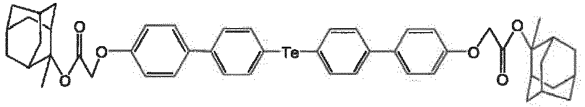

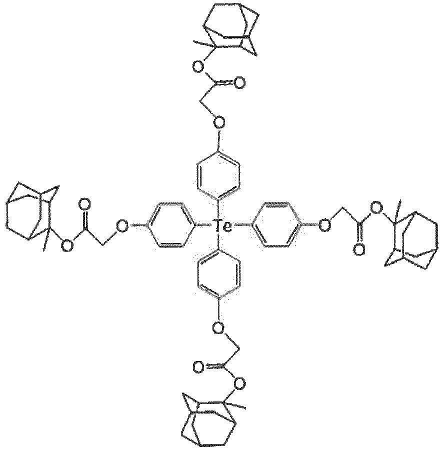

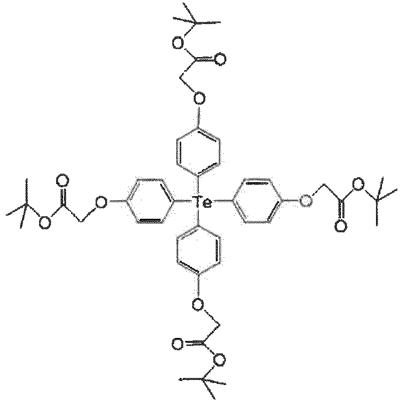

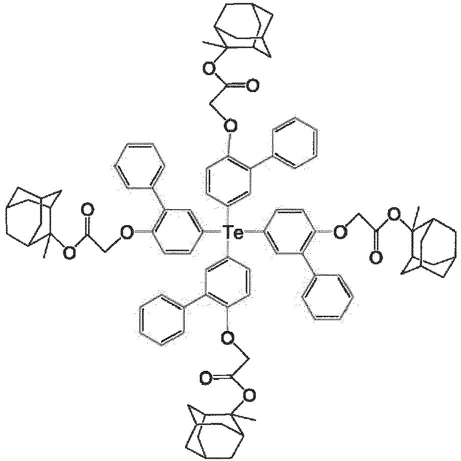

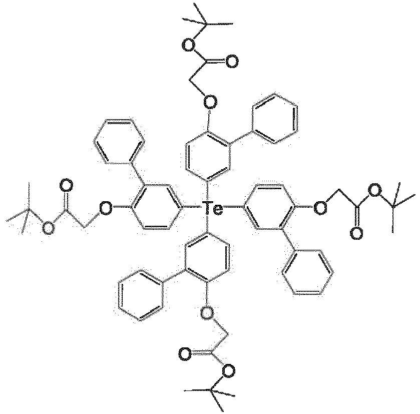

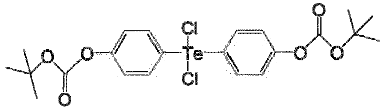

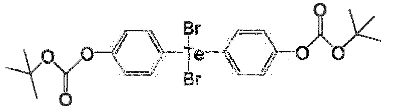

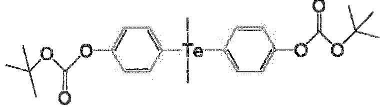

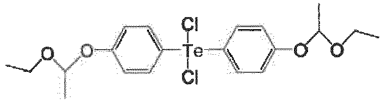

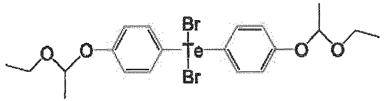

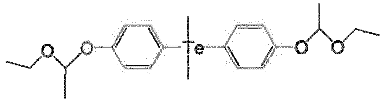

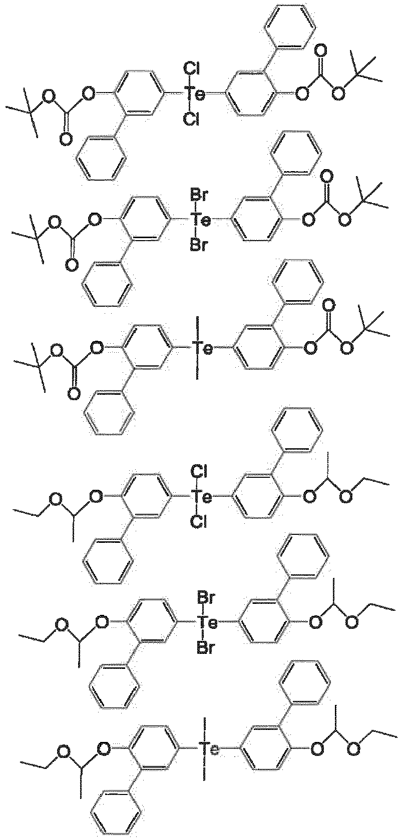

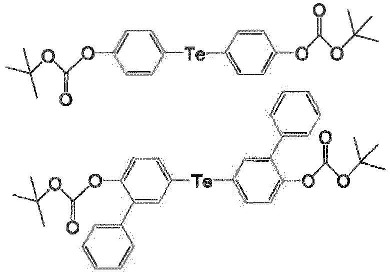

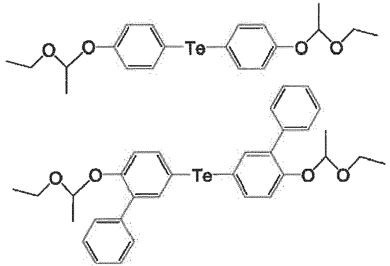

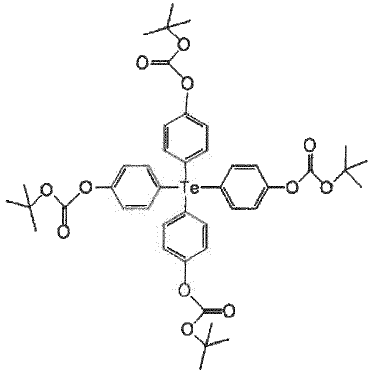

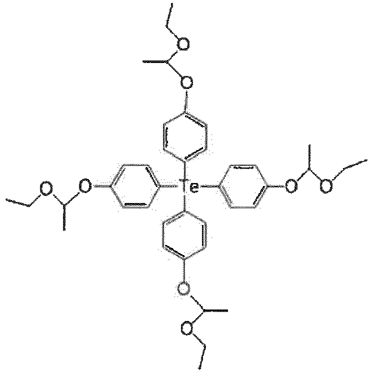

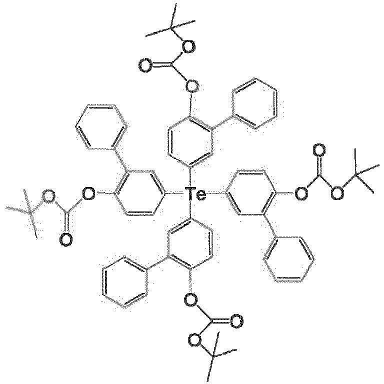

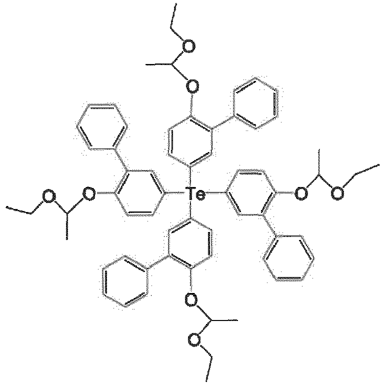

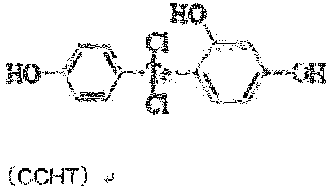

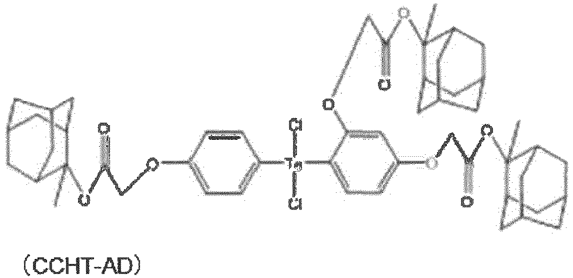

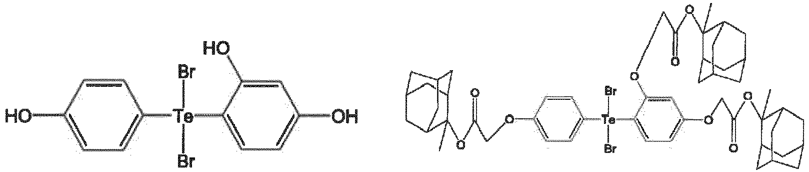

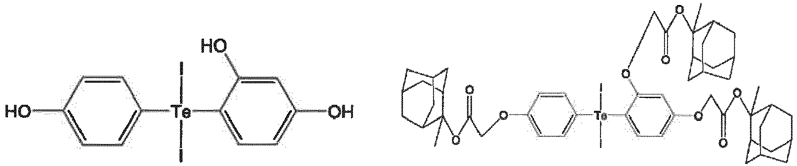

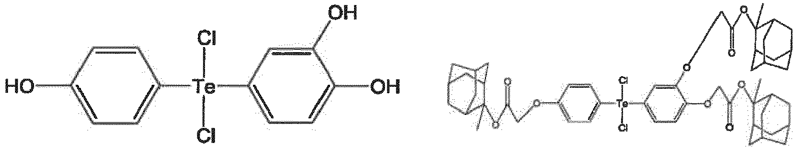

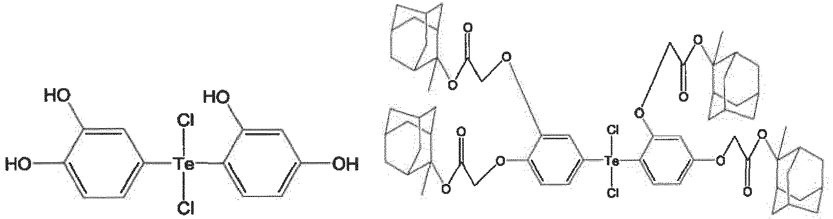

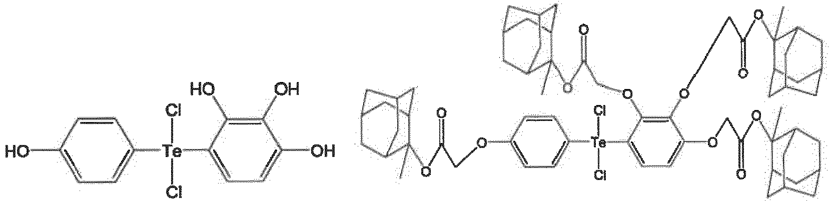

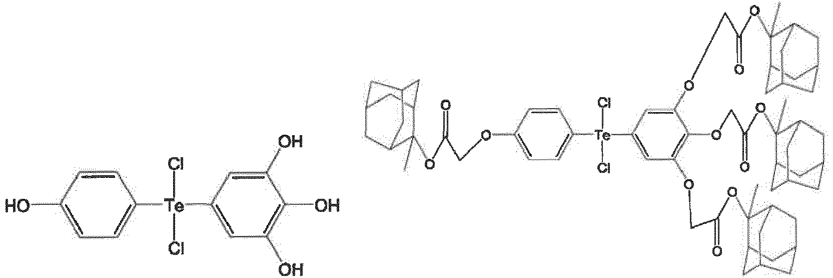

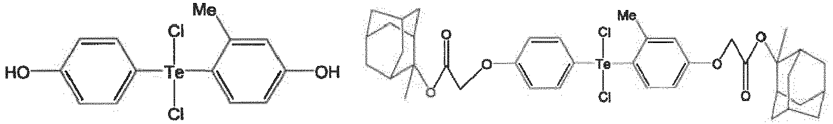

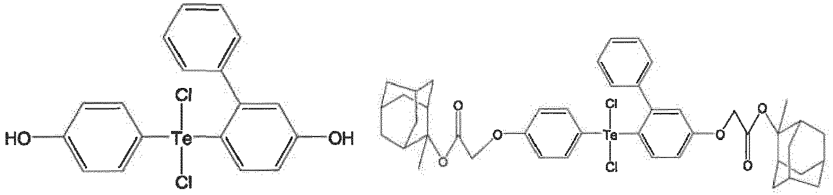

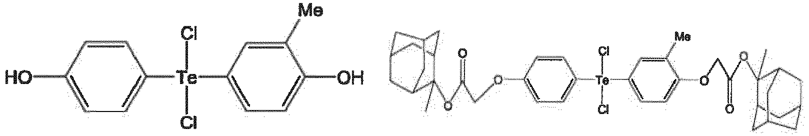

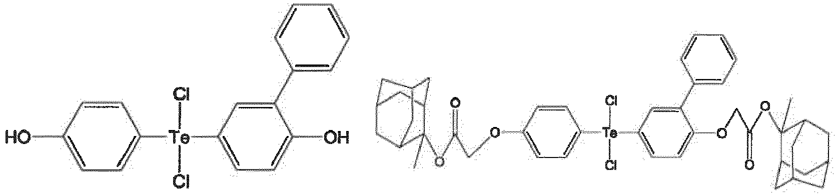

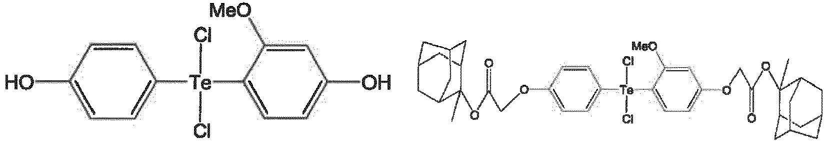

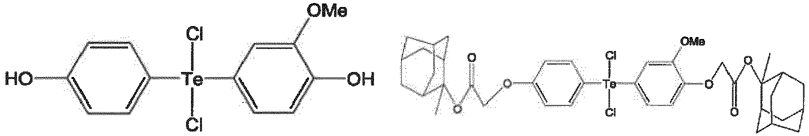

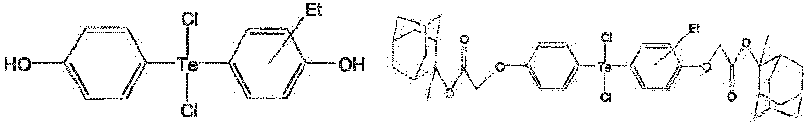

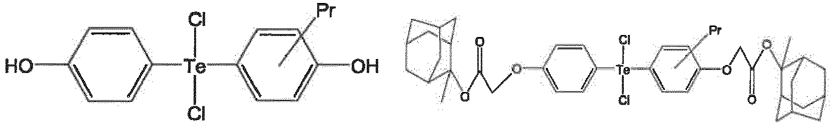

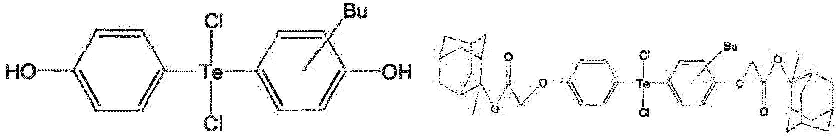

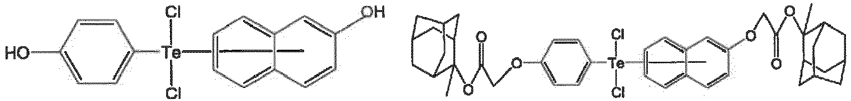

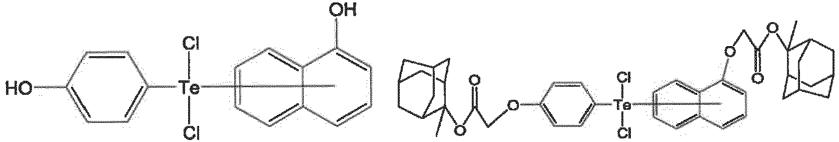

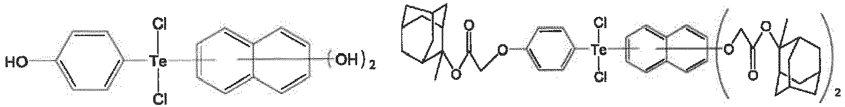

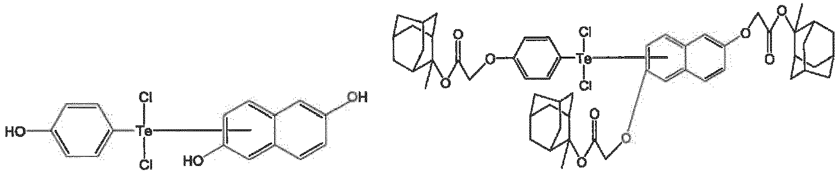

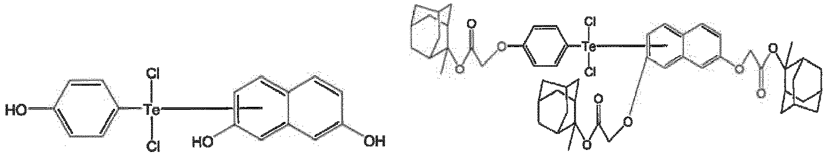

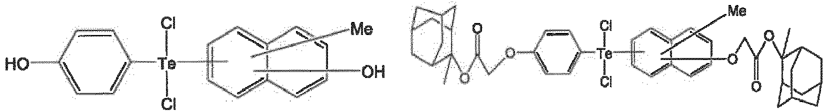

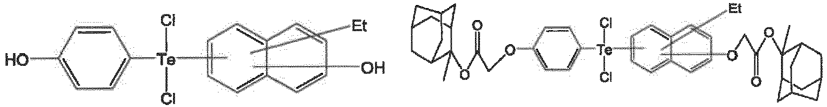

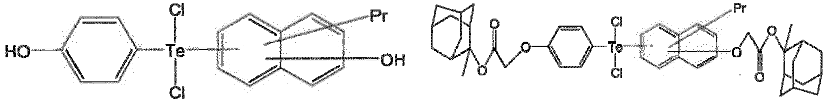

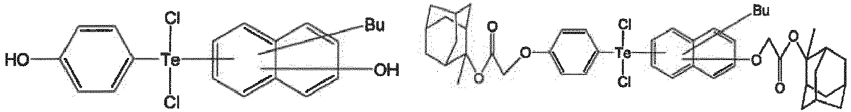

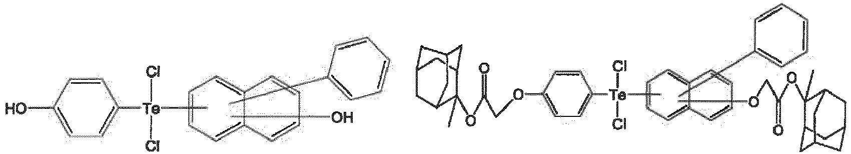

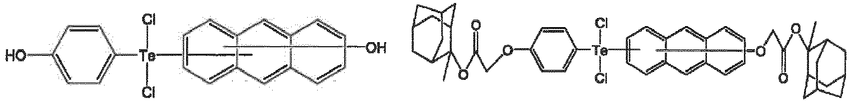

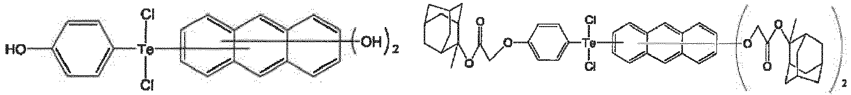

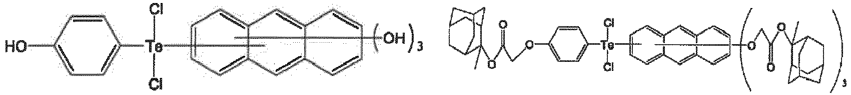

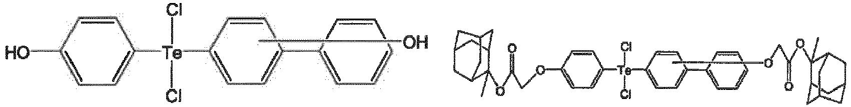

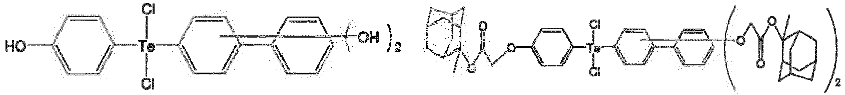

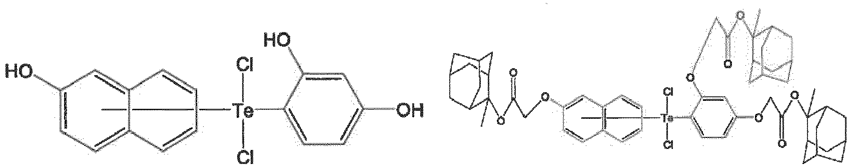

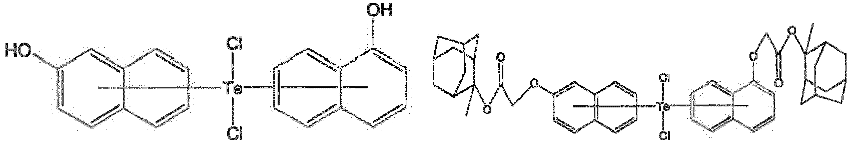

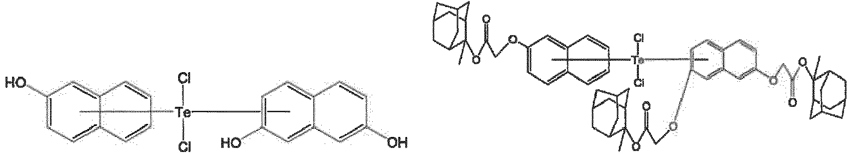

### (Resin Comprising Constitutional Unit Derived from Formula (A-1))

The composition for resist underlayer film formation of the present embodiment may contain a resin comprising a constitutional unit derived from the formula (A-1), instead of or together with the tellurium-containing compound represented by the formula (A-1). In other words, the composition for resist underlayer film formation of the present embodiment can contain a resin obtained using the compound represented by the formula (A-1) as a monomer.

Also, the resin of the present embodiment can be obtained, for example, by reacting the compound represented by the formula (A-1) with a crosslinking compound.

As the crosslinking compound, a publicly known compound can be used without particular limitations as long as it can oligomerize or polymerize the compound represented by the formula (A-1). Specific examples thereof include, but not particularly limited to, aldehydes, ketones, carboxylic acids, carboxylic acid halides, halogen-containing compounds, amino compounds, imino compounds, isocyanates, and unsaturated hydrocarbon group-containing compounds.

As the tellurium-containing resin, for example, a resin comprising a compound derived from the compound represented by the above formula (A-1) (including, for example, a resin comprising a compound derived from the compound represented by the above formula (A-2), and a resin comprising a compound derived from the compound represented by the above formula (A-3)) as well as a resin comprising a constitutional unit represented by any of the following formulae may be used.

A resin comprising a constitutional unit represented by the following formula (B1-M):

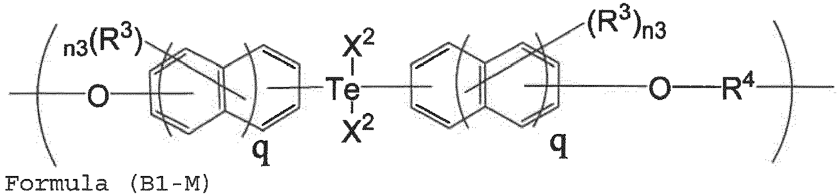

(In the formula (B1-M), each X² is independently a monovalent group containing an oxygen atom, a monovalent group containing a sulfur atom, a monovalent group containing a nitrogen atom, a hydrocarbon group, a hydrogen atom, or a halogen atom; each R³ is independently a monovalent group containing an oxygen atom, a monovalent group containing a sulfur atom, a monovalent group containing a nitrogen atom, a hydrocarbon group, or a halogen atom; q is an integer of 0 to 2; n³ is an integer of 0 to (4 + 2 × q) ; and R⁴ is a single bond or any structure represented by the following general formula (5).)

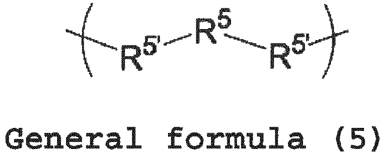

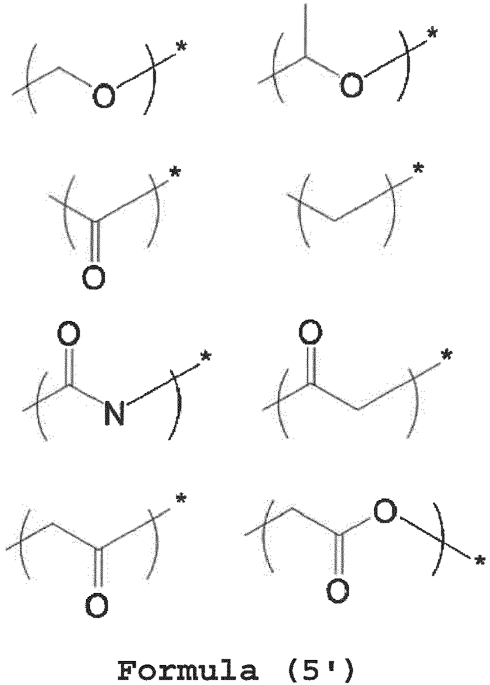

(In the general formula (5), R⁵ is a substituted or unsubstituted linear alkylene group of 1 to 20 carbon atoms, branched alkylene group of 3 to 20 carbon atoms, or cyclic alkylene group of 3 to 20 carbon atoms, or a substituted or unsubstituted arylene group of 6 to 20 carbon atoms; and each R^{5'} is independently any structure of the above formula (5'). In the formula (5¹), * indicates that this portion is connected to R⁵.)

A resin comprising a constitutional unit represented by the following formula (B1-M') (a resin wherein the R⁴ in the formula (B1-M) is a single bond):

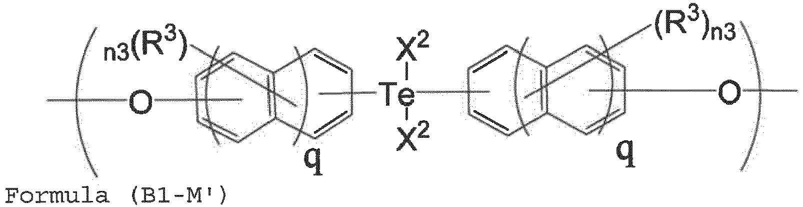

(In the formula (B1-M'), each X² is independently a monovalent group containing an oxygen atom, a monovalent group containing a sulfur atom, a monovalent group containing a nitrogen atom, a hydrocarbon group, a hydrogen atom, or a halogen atom; each R³ is independently a monovalent group containing an oxygen atom, a monovalent group containing a sulfur atom, a monovalent group containing a nitrogen atom, a hydrocarbon group, or a halogen atom; q is an integer of 0 to 2; and n³ is an integer of 0 to (4 + 2 × q).)

A resin comprising a constitutional unit represented by the following formula (B2-M) (a resin comprising a constitutional unit wherein the R⁴ in the formula (B1-M) is any structure represented by the above general formula (5)) :

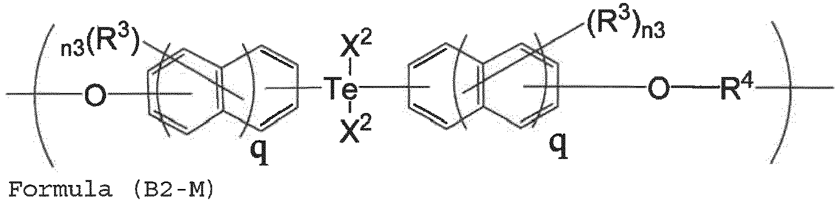

(In the formula (B2-M) , X², R³, q, and n³ are as defined in the formula (B1-M); and R⁴ is any structure represented by the above general formula (5).)

A resin comprising a constitutional unit represented by the following formula (B2-M'):

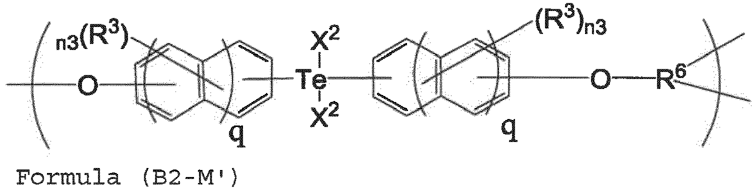

(In the formula (B2-M'), X², R³, q, and n³ are as defined in the formula (B1-M); and R⁶ is any structure represented by the following general formula (6).)

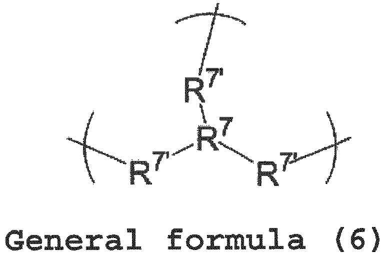

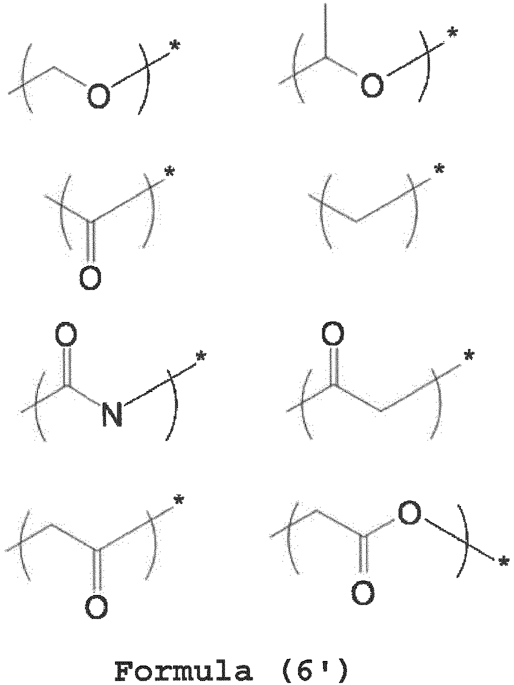

(In the general formula (6), R⁷ is a substituted or unsubstituted linear alkylene group of 1 to 20 carbon atoms, branched alkylene group of 3 to 20 carbon atoms, or cyclic alkylene group of 3 to 20 carbon atoms, or a substituted or unsubstituted arylene group of 6 to 20 carbon atoms; and each R^{7'} is independently any structure of the above formula (6'). In the formula (6'), * indicates that this portion is connected to R⁷.)

A resin comprising a constitutional unit represented by the following formula (C1):

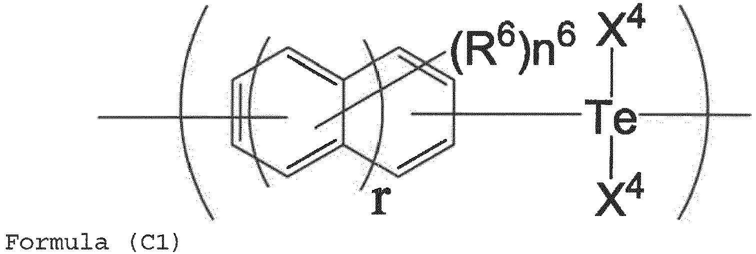

(In the formula (C1), each X⁴ is independently a monovalent group containing an oxygen atom, a monovalent group containing a sulfur atom, a monovalent group containing a nitrogen atom, a hydrocarbon group, a hydrogen atom, or a halogen atom; each R⁶ is independently a monovalent group containing an oxygen atom, a monovalent group containing a sulfur atom, a monovalent group containing a nitrogen atom, a hydrocarbon group, or a halogen atom; r is an integer of 0 to 2; and n⁶ is an integer of 2 to (4 + 2 × r).)

A resin comprising a constitutional unit represented by the following formula (B3-M):

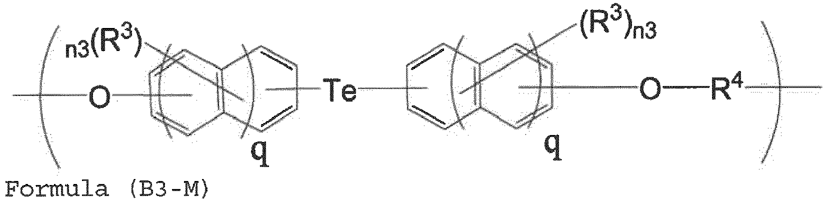

(In the formula (B3-M), each R³ is independently a monovalent group containing an oxygen atom, a monovalent group containing a sulfur atom, a monovalent group containing a nitrogen atom, a hydrocarbon group, or a halogen atom; q is an integer of 0 to 2; n³ is an integer of 0 to (4 + 2 × q); and R⁴ is a single bond or any structure represented by the following general formula (5).)

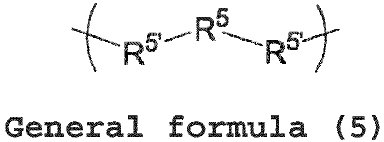

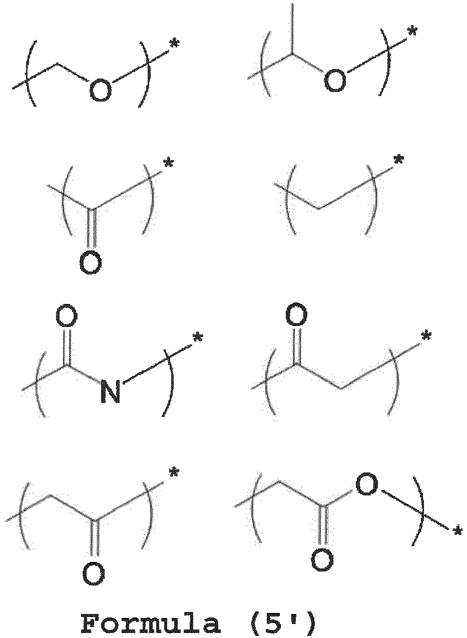

(In the general formula (5), R⁵ is a substituted or unsubstituted linear alkylene group of 1 to 20 carbon atoms, branched alkylene group of 3 to 20 carbon atoms, or cyclic alkylene group of 3 to 20 carbon atoms, or a substituted or unsubstituted arylene group of 6 to 20 carbon atoms; and each R^{5'} is independently any structure of the above formula (5'). In the formula (5'), * indicates that this portion is connected to R⁵.)

A resin comprising a constitutional unit represented by the following formula (B3-M') (a resin wherein the R⁴ in the formula (B3-M) is a single bond):

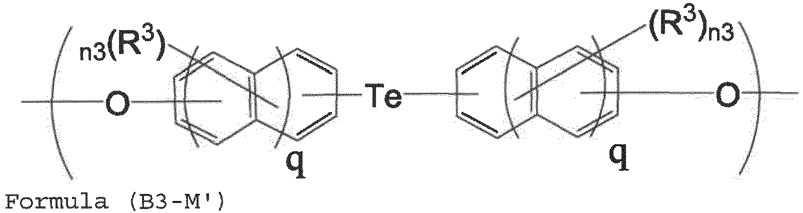

(In the formula (B3-M'), each R³ is independently a monovalent group containing an oxygen atom, a monovalent group containing a sulfur atom, a monovalent group containing a nitrogen atom, a hydrocarbon group, or a halogen atom; q is an integer of 0 to 2; and n³ is an integer of 0 to (4 + 2 × q).)

A resin comprising a constitutional unit represented by the following formula (B4-M) (a resin comprising a constitutional unit wherein the R⁴ in the formula (B3-M) is any structure represented by the above general formula (5)):

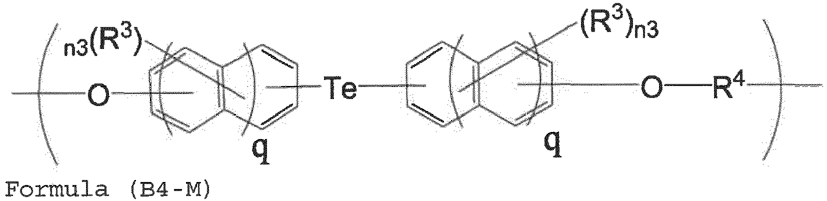

(In the formula (B4-M), R³, q, and n³ are as defined in the formula (B3-M); and R⁴ is any structure represented by the above general formula (5).)

A resin comprising a constitutional unit represented by the following formula (B4-M'):

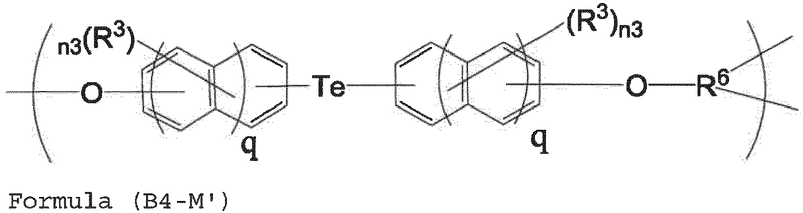

(In the formula (B4-M'), R³, q, and n³ are as defined in the formula (B3-M); and R⁶ is any structure represented by the following general formula (6).)

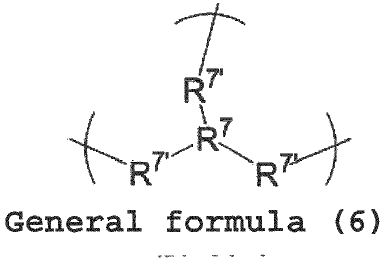

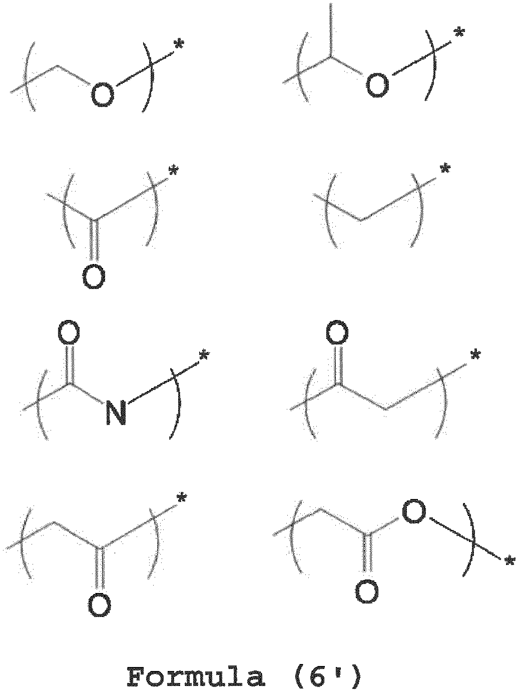

(In the general formula (6), R⁷ is a substituted or unsubstituted linear alkylene group of 1 to 20 carbon atoms, branched alkylene group of 3 to 20 carbon atoms, or cyclic alkylene group of 3 to 20 carbon atoms, or a substituted or unsubstituted arylene group of 6 to 20 carbon atoms; and each R^{7'} is independently any structure of the above formula (6'). In the formula (6'), * indicates that this portion is connected to R⁷.)

A resin comprising a constitutional unit represented by the following formula (C2):

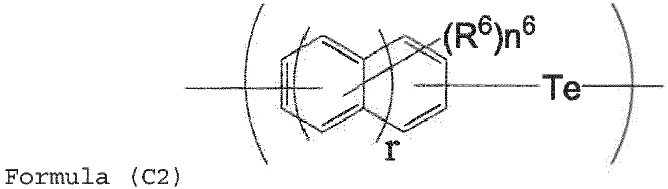

(In the formula (C2), each R⁶ is independently a monovalent group containing an oxygen atom, a monovalent group containing a sulfur atom, a monovalent group containing a nitrogen atom, a hydrocarbon group, or a halogen atom; r is an integer of 0 to 2; and n⁶ is an integer of 2 to (4 + 2 × r).)

The resin comprising each of the constitutional units mentioned above may differ in each substituent group among the constitutional units. For example, R⁵ in the general formula (5) for R⁴ in the formula (B1-M) or (B3-M), or R⁶ in the general formula (6) for the formula (B2-M') or (B4-M') may be the same or different among the constitutional units.

Specific examples of the constitutional unit derived from the formula (A-1) can include the following:

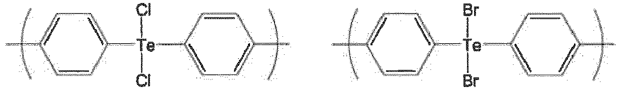

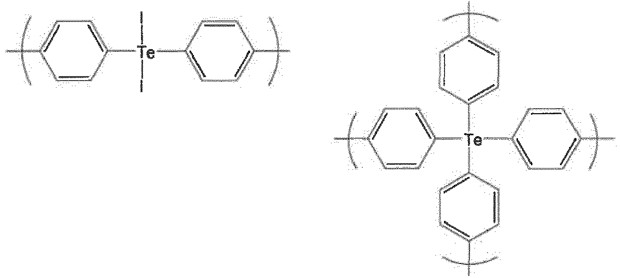

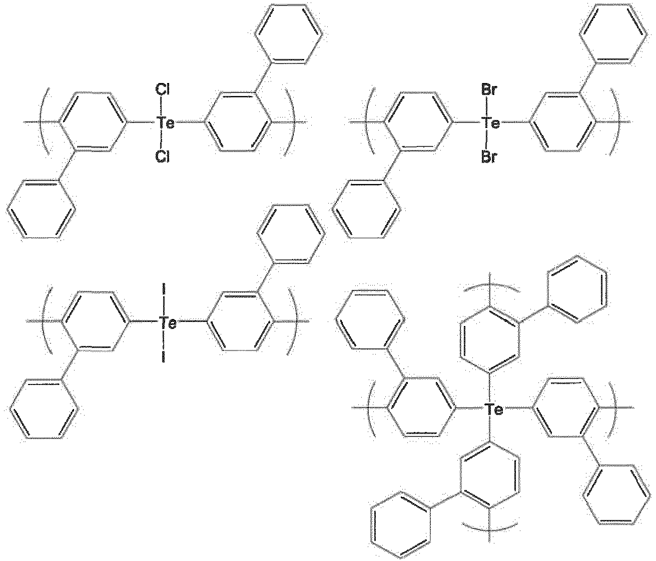

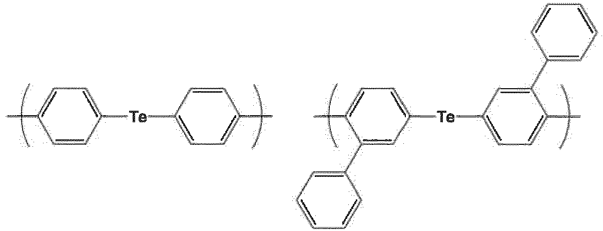

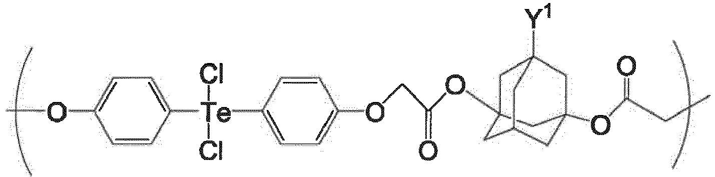

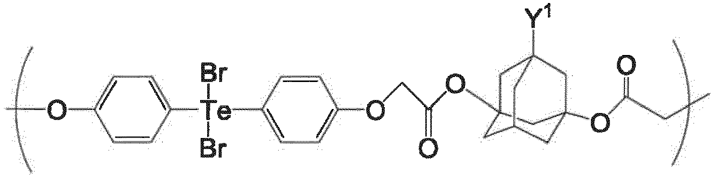

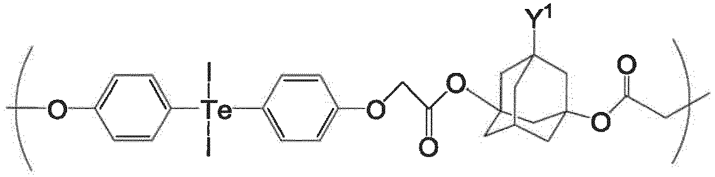

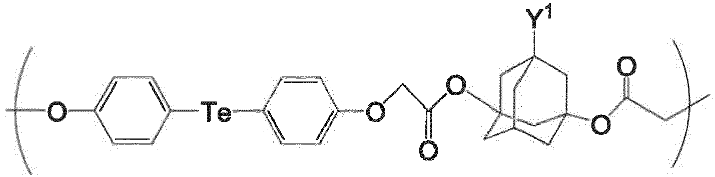

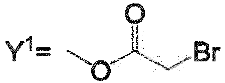

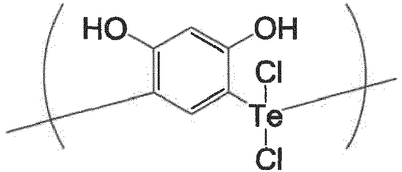

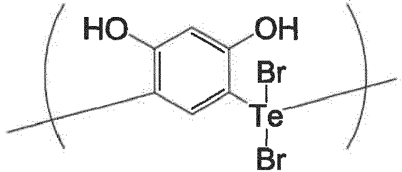

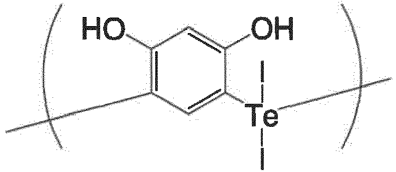

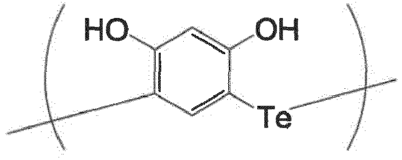

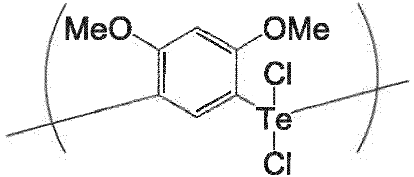

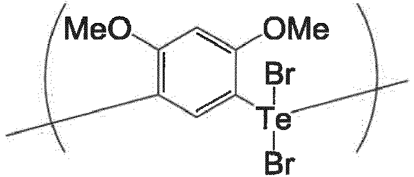

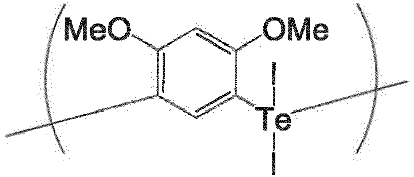

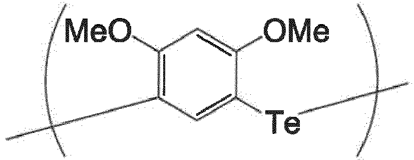

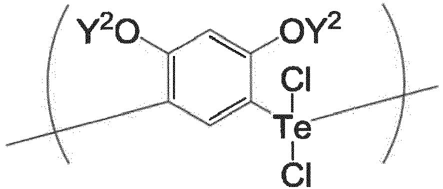

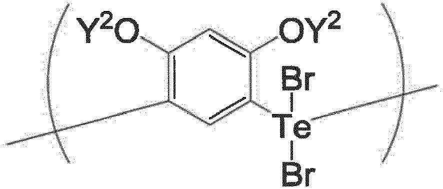

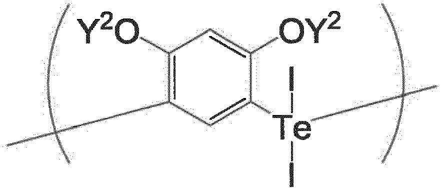

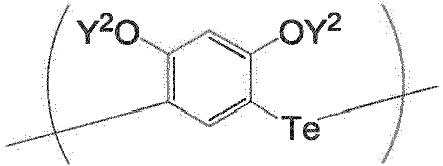

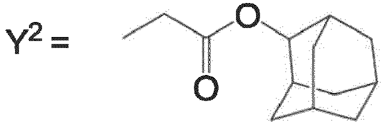

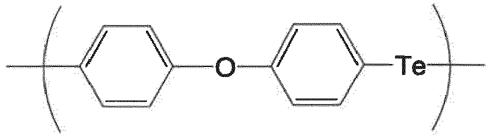

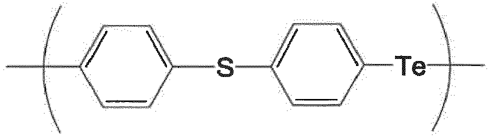

Herein, the resin according to the present embodiment may be a homopolymer of the compound represented by the above formula (A-1), but may be a copolymer with an additional phenol. Herein, examples of the copolymerizable phenol include, but are not particularly limited to, phenol, cresol, dimethylphenol, trimethylphenol, butylphenol, phenylphenol, diphenylphenol, naphthylphenol, resorcinol, methylresorcinol, catechol, butylcatechol, methoxyphenol, methoxyphenol, propylphenol, pyrogallol, and thymol.

Alternatively, the resin according to the present embodiment may be a copolymer with a polymerizable monomer, instead of the additional phenol mentioned above. Examples of such a monomer for copolymerization include, but are not particularly limited to, naphthol, methylnaphthol, methoxynaphthol, dihydroxynaphthalene, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, vinylnorbornene, pinene, and limonene. The resin according to the present embodiment may be a binary or higher (e.g., binary to quaternary) copolymer of the compound represented by the above formula (A-1) and the phenol mentioned above, may be a binary or higher (e.g., binary to quaternary) copolymer of the compound represented by the above formula (A-1) and the monomer for copolymerization mentioned above, or may be a ternary or higher (e.g., ternary to quaternary) copolymer of the compound represented by the above formula (A-1), the phenol mentioned above, and the monomer for copolymerization mentioned above.

The molecular weight of the resin according to the present embodiment is not particularly limited, and the weight average molecular weight (Mw) in terms of polystyrene is preferably 500 to 30,000 and more preferably 750 to 20,000. The resin according to the present embodiment preferably has a dispersibility (weight average molecular weight Mw/number average molecular weight Mn) within the range of 1.2 to 7 from the viewpoint of enhancing crosslinking efficiency and suppressing volatile components during baking. The Mn can be determined by a method described in Examples mentioned later.

The compound represented by the above formula (A-1) and/or the resin obtained with the compound as a constitutional unit preferably has high solubility in a solvent from the viewpoint of easier application to a wet process, etc. More specifically, in the case of using 1-methoxy-2-propanol (PGME) and/or propylene glycol monomethyl ether acetate (PGMEA) as a solvent, the solubility of the compound and/or the resin in the solvent is preferably 10% by mass or more. Herein, the solubility in PGME and/or PGMEA is defined as "Mass of the resin (or the compound) / (Mass of the resin (or the compound) + Mass of the solvent) × 100 (% by mass)". For example, 10 g of the compound represented by the above formula (A-1) and/or the resin obtained with the compound as a monomer is evaluated as being dissolved in 90 g of PGMEA when the solubility of the compound represented by the formula (A-1) and/or the resin obtained with the compound as a monomer in PGMEA is "3% by mass or more", and is evaluated as being not dissolved therein when the solubility is "less than 3% by mass".

### [Method for Purifying Compound or Resin]

The compound or the resin of the present embodiment can be purified by a purification method comprising the following steps.

Specifically, the purification method comprises the steps of: obtaining a solution (A) by dissolving the compound represented by the formula (A-1) or the resin comprising a constitutional unit derived from the formula (A-1) in a solvent comprising an organic solvent that does not inadvertently mix with water; and extracting impurities in the compound represented by the above formula (A-1) or the resin by bringing the obtained solution (A) into contact with an acidic aqueous solution (a first extraction step).

In the case of using the purification method of the present embodiment, the resin is preferably a resin obtained by reacting the compound represented by the formula (A-1) with a crosslinking compound.

According to the purification method of the present embodiment, the contents of various metals that may be contained as impurities in the compound or the resin having a specific structure described above can be effectively reduced.

Metals contained in the solution (A) containing the compound represented by the formula (A-1) or the resin comprising a constitutional unit derived from the compound represented by the formula (A-1) are transferred to the aqueous phase, then the organic phase and the aqueous phase are separated, and thus the compound represented by the formula (A-1) or the resin comprising a constitutional unit derived from the compound represented by the formula (A-1) having a reduced metal content can be obtained.

The compound represented by the formula (A-1) or the resin comprising a constitutional unit derived from the compound represented by the formula (A-1) used in the purification method of the present embodiment may be alone, or may be a mixture of two or more kinds. Also, the compound represented by the formula (A-1) or the resin comprising a constitutional unit derived from the compound represented by the formula (A-1) may be applied to the production method of the present embodiment together with various surfactants, various crosslinking agents, various acid generators, various stabilizers, and the like.

The "organic solvent that does not inadvertently mix with water" used in the purification method of the present embodiment means an organic solvent that does not uniformly mix with water at any ratio. Such an organic solvent is not particularly limited, but is preferably an organic solvent that is safely applicable to semiconductor manufacturing processes, and specifically it is an organic solvent having a solubility in water at room temperature of less than 30%, and more preferably is an organic solvent having a solubility of less than 20% and particularly preferably less than 10%. The amount of the organic solvent used is preferably 1 to 100 parts by mass based on 100 parts by mass of the compound represented by the formula (A-1) and the resin comprising a constitutional unit derived from the compound represented by the formula (A-1) used.

Specific examples of the organic solvent that does not inadvertently mix with water include, but not limited to, ethers such as diethyl ether and diisopropyl ether; esters such as ethyl acetate, n-butyl acetate, and isoamyl acetate; ketones such as methyl ethyl ketone, methyl isobutyl ketone, ethyl isobutyl ketone, cyclohexanone (CHN), cyclopentanone, 2-heptanone, and 2-pentanone; glycol ether acetates such as ethylene glycol monoethyl ether acetate, ethylene glycol monobutyl ether acetate, propylene glycol monomethyl ether acetate (PGMEA), and propylene glycol monoethyl ether acetate; aliphatic hydrocarbons such as n-hexane and n-heptane; aromatic hydrocarbons such as toluene and xylene; and halogenated hydrocarbons such as methylene chloride and chloroform. Among these, one or more organic solvents selected from the group consisting of toluene, 2-heptanone, cyclohexanone, cyclopentanone, methyl isobutyl ketone, propylene glycol monomethyl ether acetate, ethyl acetate, and the like are preferable, methyl isobutyl ketone, ethyl acetate, cyclohexanone, and propylene glycol monomethyl ether acetate are more preferable, and methyl isobutyl ketone and ethyl acetate are still more preferable. Methyl isobutyl ketone, ethyl acetate, and the like have relatively high saturation solubility for the compound represented by the formula (A-1) or the resin comprising a constitutional unit derived from the compound represented by the formula (A-1) and a relatively low boiling point, and it is thus possible to reduce the load in the case of industrially distilling off the solvent and in the step of removing the solvent by drying.

These organic solvents can be each used alone, and can be used as a mixture of two or more kinds.

The "acidic aqueous solution" used in the purification method of the present embodiment is arbitrarily selected from aqueous solutions in which generally known organic compounds or inorganic compounds are dissolved in water. Examples of the acidic aqueous solution include, but not limited to, aqueous mineral acid solutions in which mineral acids such as hydrochloric acid, sulfuric acid, nitric acid, and phosphoric acid are dissolved in water; and aqueous organic acid solutions in which organic acids such as acetic acid, propionic acid, oxalic acid, malonic acid, succinic acid, fumaric acid, maleic acid, tartaric acid, citric acid, methanesulfonic acid, phenolsulfonic acid, p-toluenesulfonic acid, and trifluoroacetic acid are dissolved in water. These acidic aqueous solutions can be each used alone, and can be also used as a combination of two or more kinds. Among these acidic aqueous solutions, aqueous solutions of one or more mineral acids selected from the group consisting of hydrochloric acid, sulfuric acid, nitric acid, and phosphoric acid, or aqueous solutions of one or more organic acids selected from the group consisting of acetic acid, propionic acid, oxalic acid, malonic acid, succinic acid, fumaric acid, maleic acid, tartaric acid, citric acid, methanesulfonic acid, phenolsulfonic acid, p-toluenesulfonic acid, and trifluoroacetic acid are preferable, aqueous solutions of sulfuric acid, nitric acid, and carboxylic acids such as acetic acid, oxalic acid, tartaric acid, and citric acid are more preferable, aqueous solutions of sulfuric acid, oxalic acid, tartaric acid, and citric acid are still more preferable, and an aqueous solution of oxalic acid is further preferable. It is considered that polyvalent carboxylic acids such as oxalic acid, tartaric acid, and citric acid coordinate with metal ions and provide a chelating effect, and thus tend to be capable of more effectively removing metals. As for water used herein, it is preferable to use water, the metal content of which is small, such as ion exchanged water, according to the purpose of the purification method of the present embodiment.

The pH of the acidic aqueous solution used in the purification method of the present embodiment is not particularly limited, but it is preferable to regulate the acidity of the aqueous solution in consideration of an influence on the compound represented by the formula (A-1) or the resin comprising a constitutional unit derived from the compound represented by the formula (A-1). Normally, the pH range of the acidic aqueous solution is about 0 to 5, and is preferably about pH 0 to 3.

The amount of the acidic aqueous solution used in the purification method of the present embodiment is not particularly limited, but it is preferable to regulate the amount from the viewpoint of reducing the number of extraction operations for removing metals and from the viewpoint of ensuring operability in consideration of the overall amount of fluid. From the above viewpoints, the amount of the acidic aqueous solution used is preferably 10 to 200% by mass, more preferably 20 to 100% by mass, based on 100% by mass of the solution (A).

In the purification method of the present embodiment, by bringing an acidic aqueous solution as described above into contact with the solution (A) containing one or more selected from the compound represented by the formula (A-1) and the resin comprising a constitutional unit derived from the compound represented by the formula (A-1) and the organic solvent that does not inadvertently mix with water, metals can be extracted from the compound or the resin in the solution (A) .

When an organic solvent that advertently mixes with water is contained, there is a tendency that the amount of the compound represented by the formula (A-1) or the resin comprising a constitutional unit derived from the compound represented by the formula (A-1) charged can be increased, also the fluid separability is improved, and purification can be carried out at a high reaction vessel efficiency. The method for adding the organic solvent that advertently mixes with water is not particularly limited. For example, any of a method involving adding it to the organic solvent-containing solution in advance, a method involving adding it to water or the acidic aqueous solution in advance, and a method involving adding it after bringing the organic solvent-containing solution into contact with water or the acidic aqueous solution. Among these, the method involving adding it to the organic solvent-containing solution in advance is preferable in terms of the workability of operations and the ease of managing the amount.

The organic solvent that inadvertently mixes with water used in the purification method of the present embodiment is not particularly limited, but is preferably an organic solvent that is safely applicable to semiconductor manufacturing processes. The amount of the organic solvent used that inadvertently mixes with water is not particularly limited as long as the solution phase and the aqueous phase separate, but is preferably 0.1 to 100 parts by mass, more preferably 0.1 to 50 parts by mass, and further preferably 0.1 to 20 parts by mass based on 100 parts by mass of the compound represented by the formula (A-1) and the resin comprising a constitutional unit derived from the compound represented by the formula (A-1).

Specific examples of the organic solvent used in the purification method of the present embodiment that inadvertently mixes with water include, but not limited to, ethers such as tetrahydrofuran and 1,3-dioxolane; alcohols such as methanol, ethanol, and isopropanol; ketones such as acetone and N-methylpyrrolidone; aliphatic hydrocarbons such as glycol ethers such as ethylene glycol monoethyl ether, ethylene glycol monobutyl ether, propylene glycol monomethyl ether (PGME), and propylene glycol monoethyl ether. Among these, N-methylpyrrolidone, propylene glycol monomethyl ether, and the like are preferable, and N-methylpyrrolidone and propylene glycol monomethyl ether are more preferable. These solvents can be each used alone, and can be used as a mixture of two or more kinds.

In the purification method of the present embodiment, the temperature when the solution (A) and the acidic aqueous solution are brought into contact, i.e., when extraction treatment is carried out, is preferably in the range of 20 to 90°C, and more preferably 30 to 80°C. The extraction operation is not particularly limited, and is carried out, for example, by thoroughly mixing the solution (A) and the acidic aqueous solution by stirring or the like and then leaving the obtained mixed solution to stand still. Thereby, metals contained in the solution (A) containing one or more selected from the compound represented by the formula (A-1) and the resin comprising a constitutional unit derived from the compound represented by the formula (A-1) and the organic solvents are transferred to the aqueous phase. Also, by this operation, the acidity of the solution (A) is lowered, and the degradation of the compound represented by the formula (A-1) and the resin comprising a constitutional unit derived from the compound represented by the formula (A-1) can be suppressed.

By being left to stand still, the mixed solution is separated into an aqueous phase and a solution phase containing one or more selected from the compound represented by the formula (A-1) and the resin comprising a constitutional unit derived from the compound represented by the formula (A-1) and the organic solvents, and thus the solution phase containing one or more selected from the compound represented by the formula (A-1) and the resin comprising a constitutional unit derived from the compound represented by the formula (A-1) and the organic solvents can be recovered by decantation. The time for leaving the mixed solution to stand still is not particularly limited, but it is preferable to regulate the time for leaving the mixed solution to stand still from the viewpoint of attaining good separation of the solution phase containing the organic solvents and the aqueous phase. Normally, the time for leaving the mixed solution to stand still is 1 minute or longer, preferably 10 minutes or longer, and more preferably 30 minutes or longer. While the extraction treatment may be carried out once, it is effective to repeat mixing, leaving-to-stand-still, and separating operations multiple times.

It is preferable that the purification method of the present embodiment includes the step of extracting impurities in the compound or the resin by further bringing the solution phase containing the compound or the resin into contact with water after the first extraction step (the second extraction step).

Specifically, for example, it is preferable that after the extraction treatment is carried out using an acidic aqueous solution, the solution phase that is extracted and recovered from the aqueous solution and that contains one or more selected from the compound represented by the formula (A-1) and the resin comprising a constitutional unit derived from the compound represented by the formula (A-1) and the organic solvents is further subjected to extraction treatment with water. The extraction treatment with water is not particularly limited, and can be carried out, for example, by thoroughly mixing the solution phase and water by stirring or the like and then leaving the obtained mixed solution to stand still. The mixed solution after being left to stand still is separated into an aqueous phase and a solution phase containing one or more selected from the compound represented by the formula (A-1) and the resin comprising a constitutional unit derived from the compound represented by the formula (A-1) and the organic solvents, and thus the solution phase containing one or more selected from the compound represented by the formula (A-1) and the resin comprising a constitutional unit derived from the compound represented by the formula (A-1) and the organic solvents can be recovered by decantation.

Water used herein is preferably water, the metal content of which is small, such as ion exchanged water, according to the purpose of the present embodiment. While the extraction treatment may be carried out once, it is effective to repeat mixing, leaving-to-stand-still, and separating operations multiple times. The proportions of both used in the extraction treatment and temperature, time, and other conditions are not particularly limited, and may be the same as those of the previous contact treatment with the acidic aqueous solution.

Water that is possibly present in the thus-obtained solution containing one or more selected from the compound represented by the formula (A-1) and the resin comprising a constitutional unit derived from the compound represented by the formula (A-1) and the organic solvents can be easily removed by performing vacuum distillation or a like operation. Also, if required, the concentration of the compound represented by the formula (A-1) and the resin comprising a constitutional unit derived from the compound represented by the formula (A-1) can be regulated to be any concentration by adding an organic solvent to the solution.

The method for isolating one or more selected from the compound represented by the above formula (A-1) and the resin comprising a constitutional unit derived from the compound represented by the formula (A-1) from the obtained solution containing one or more selected from the compound represented by the formula (A-1) and the resin comprising a constitutional unit derived from the compound represented by the formula (A-1) and the organic solvents is not particularly limited, and publicly known methods can be carried out, such as reduced-pressure removal, separation by reprecipitation, and a combination thereof. Publicly known treatments such as concentration operation, filtration operation, centrifugation operation, and drying operation can be carried out if required.

### (Other Components)

In the present embodiment, the composition for resist underlayer film formation can further comprise a solvent, an acid generating agent, an acid crosslinking agent, and the like, in addition to the tellurium-containing compound or the tellurium-containing resin. The composition for resist underlayer film formation can further comprise optional components such as a basic compound, water, an alcohol, and a curing catalyst.

The amount of the tellurium-containing compound or the tellurium-containing resin such as the compound represented by the above formula (A-1) and/or the resin obtained with the compound as a constitutional unit in the composition for resist underlayer film formation is preferably 0.1 to 70% by mass, more preferably 0.5 to 50% by mass, and particularly preferably 3.0 to 40% by mass, from the viewpoint of coatability and quality stability.

### [Solvent]

In the present embodiment, a publicly known solvent can be arbitrarily used as the solvent as long as the solvent dissolves at least the tellurium-containing compound or the tellurium-containing resin such as the compound represented by the above formula (A-1) and/or the resin obtained with the compound as a constitutional unit.

Specific examples of the solvent include, but are not particularly limited to: ketone based solvents such as acetone, methyl ethyl ketone, methyl isobutyl ketone, and cyclohexanone; cellosolve based solvents such as propylene glycol monomethyl ether and propylene glycol monomethyl ether acetate; ester based solvents such as ethyl lactate, methyl acetate, ethyl acetate, butyl acetate, isoamyl acetate, methyl methoxypropionate, and methyl hydroxyisobutyrate; alcohol based solvents such as methanol, ethanol, isopropanol, and 1-ethoxy-2-propanol; and aromatic hydrocarbons such as toluene, xylene, and anisole. These organic solvents can be used alone as one kind, or can be used in combination of two or more kinds.

Among these solvents, cyclohexanone, propylene glycol monomethyl ether, propylene glycol monomethyl ether acetate, ethyl lactate, methyl hydroxyisobutyrate, 1-methoxy-2-propanol, and anisole are particularly preferable from the viewpoint of safety.

The content of the solvent is not particularly limited, but is preferably 100 to 10,000 parts by mass, more preferably 200 to 5,000 parts by mass, and further preferably 200 to 1,000 parts by mass, based on 100 parts by mass in total of solid portions of the composition for resist underlayer film formation from the viewpoint of solubility and film formation.

### [Acid Crosslinking Agent]

As mentioned above, the composition for resist underlayer film formation of the present embodiment may contain an acid crosslinking agent, if required, from the viewpoint of, for example, suppressing intermixing. Examples of the acid crosslinking agent that may be used in the present embodiment include, but are not particularly limited to, melamine compounds, epoxy compounds, guanamine compounds, glycoluryl compounds, urea compounds, thioepoxy compounds, isocyanate compounds, azide compounds, and compounds containing a double bond such as alkenyl ether groups, which have at least one group selected from a methylol group, an alkoxymethyl group, and an acyloxymethyl group as a substituent group (crosslinkable group). These acid crosslinking agents can be used alone as one kind, or can be used in combination of two or more kinds. Also, these acid crosslinking agents may be used as additive agents. The crosslinkable group may be introduced as a pendant group to a polymer side chain in the tellurium-containing resin such as the resin obtained with the compound represented by the above formula (A-1) as a constitutional unit. Also, a compound containing a hydroxy group can be used as a crosslinking agent.

Specific examples of the acid crosslinking agent include those described in, for example, International Publication No. WO 2013/024779.

In the composition for resist underlayer film formation of the present embodiment, the content of the acid crosslinking agent is not particularly limited, but is preferably 5 to 50 parts by mass and more preferably 10 to 40 parts by mass, based on 100 parts by mass in total of solid portions of the composition for resist underlayer film formation. Within the above preferable range, mixing phenomena with a resist layer tends to be prevented. Also, an antireflection effect and film formability after crosslinking both tend to be enhanced.

### [Acid Generating Agent]

The composition for resist underlayer film formation of the present embodiment may contain an acid generating agent, if required, from the viewpoint of, for example, further accelerating crosslinking reaction by heat. For example, acid generating agents that generate an acid by thermal decomposition or generate an acid by light irradiation are known, any of which can be used. An acid generating agent described in, for example, International Publication No. WO 2013/024779 can be used as the acid generating agent.

In the composition for resist underlayer film formation of the present embodiment, the content of the acid generating agent is not particularly limited, but is preferably 0.1 to 50 parts by mass and more preferably 0.5 to 40 parts by mass based on 100 parts by mass in total of solid portions of the composition for resist underlayer film formation. Within the above preferable range, the amount of the acid generated tends to be large so that crosslinking reaction is enhanced. Also, mixing phenomena with a resist layer tend to be prevented.

### [Basic Compound]

The composition for resist underlayer film formation of the present embodiment may further contain a basic compound from the viewpoint of, for example, improving storage stability.

The basic compound plays a role as a quencher against acids in order to prevent crosslinking reaction from proceeding due to a trace amount of an acid generated by the acid generating agent. Examples of such a basic compound include, but are not particularly limited to, primary, secondary or tertiary aliphatic amines, amine blends, aromatic amines, heterocyclic amines, nitrogen-containing compounds having a carboxyl group, nitrogen-containing compounds having a sulfonyl group, nitrogen-containing compounds having a hydroxy group, nitrogen-containing compounds having a hydroxyphenyl group, alcoholic nitrogen-containing compounds, amide derivatives, and imide derivatives.

Specific examples of the basic compound include those described in, for example, International Publication No. WO 2013/024779.

In the composition for resist underlayer film formation of the present embodiment, the content of the basic compound is not particularly limited, but is preferably 0.001 to 2 parts by mass and more preferably 0.01 to 1 parts by mass based on 100 parts by mass in total of solid portions of the composition for resist underlayer film formation. Within the above preferable range, storage stability tends to be enhanced without excessively impairing crosslinking reaction.

The composition for resist underlayer film formation of the present embodiment may also contain an additional resin and/or compound for the purpose of conferring thermosetting properties or controlling absorbance. Examples of such an additional resin and/or compound include, but not particularly limited to: naphthol resins, xylene resins naphthol-modified resins, phenol-modified resins of naphthalene resins, polyhydroxystyrene, dicyclopentadiene resins, resins containing (meth)acrylate, dimethacrylate, trimethacrylate, tetramethacrylate, a naphthalene ring such as vinylnaphthalene or polyacenaphthylene, a biphenyl ring such as phenanthrenequinone or fluorene, or a heterocyclic ring having a heteroatom such as thiophene or indene, and resins containing no aromatic ring; and resins or compounds containing an alicyclic structure, such as rosin based resin, cyclodextrin, adamantine (poly)ol, tricyclodecane (poly)ol, and derivatives thereof. The composition for resist underlayer film formation of the present embodiment may further contain a publicly known additive agent. Examples of the publicly known additive agent include, but are not limited to, ultraviolet absorbers, surfactants, colorants, and nonionic surfactants.

### [Resist Underlayer Film for Lithography and Pattern Formation Method]

The resist underlayer film for lithography of the present embodiment is formed using the composition for resist underlayer film formation of the present embodiment. A pattern formed according to the present embodiment can be used as, for example, a resist pattern or a circuit pattern.

The pattern formation method of the present embodiment has the steps of: forming a resist underlayer film on a substrate using the composition for resist underlayer film formation of the present embodiment (step A-1); forming at least one photoresist layer on the resist underlayer film (step A-2); and after the formation of at least one photoresist layer in the step A-2, irradiating a predetermined region of the photoresist layer with radiation for development (step A-3). The "photoresist layer" means an outermost layer of a resist layer, i.e., a layer disposed on the uppermost side (on the side opposite to the substrate) in a resist layer.

Another pattern formation method of the present embodiment has the steps of: forming a resist underlayer film on a substrate using the composition for resist underlayer film formation of the present embodiment (step B-1); forming a resist intermediate layer film on the underlayer film using a resist intermediate layer film material (e.g., a silicon-containing resist layer) (step B-2); forming at least one photoresist layer on the resist intermediate layer film (step B-3); after the formation of at least one photoresist layer in the step B-3, irradiating a predetermined region of the photoresist layer with radiation for development, thereby forming a resist pattern (step B-4); and after the formation of the resist pattern in the step B-4, etching the resist intermediate layer film with the resist pattern as a mask, etching the underlayer film with the obtained intermediate layer film pattern as an etching mask, and etching the substrate with the obtained underlayer film pattern as an etching mask, thereby forming a pattern on the substrate (step B-5).

The resist underlayer film for lithography of the present embodiment is not limited by its formation method as long as the resist underlayer film for lithography is formed from the composition for resist underlayer film formation of the present embodiment. A publicly known approach can be applied thereto. The resist underlayer film can be formed by, for example, applying the composition for resist underlayer film formation of the present embodiment onto a substrate by a publicly known coating method or printing method such as spin coating or screen printing, and then removing an organic solvent by volatilization or the like.

In the formation of the resist underlayer film, it is preferable to perform baking treatment, for preventing mixing phenomena with an upper layer resist (e.g., a photoresist layer or a resist intermediate layer film) while accelerating crosslinking reaction. In this case, the baking temperature is not particularly limited, but is preferably in the range of 80 to 450°C and more preferably 200 to 400°C. The baking time is not particularly limited, but is preferably in the range of 10 seconds to 300 seconds. The thickness of the resist underlayer film can be arbitrarily selected according to required performance and is not particularly limited, but is usually preferably about 30 to 20,000 nm, and more preferably 50 to 15,000 nm.

After making the resist underlayer film on the substrate, a resist intermediate layer film can be established between a photoresist layer and the resist underlayer film. In the case of, for example, a two-layer process, a silicon-containing resist layer or a usual single-layer resist composed of hydrocarbon, etc. can be established as a resist intermediate layer film on the resist underlayer film. In the case of, for example, a three-layer process, it is preferable to make a silicon-containing intermediate layer between a resist intermediate layer film and a photoresist layer and further a silicon-free single-layer resist layer thereon. A publicly known photoresist material can be used for forming this resist layer to be disposed in the photoresist layer, in the resist intermediate layer film, and between these layers.

For example, for the silicon-containing resist material for a two-layer process, a silicon atom-containing polymer such as a polysilsesquioxane derivative or a vinylsilane derivative is used as a base polymer, and a positive type photoresist material further containing an organic solvent, an acid generating agent, and if required, a basic compound or the like is preferably used, from the viewpoint of oxygen gas etching resistance. Herein, a publicly known polymer for use in this kind of resist material can be used as the silicon atom-containing polymer.

For example, a polysilsesquioxane based intermediate layer is preferably used as the silicon-containing intermediate layer for a three-layer process. By imparting effects as an antireflection film to the resist intermediate layer film, there is a tendency that reflection can be effectively suppressed. For example, use of a material containing a large amount of an aromatic group and having high substrate etching resistance as the resist underlayer film in a process for exposure at 193 nm tends to increase a k value and enhance substrate reflection. However, the resist intermediate layer film suppresses the reflection so that the substrate reflection can be 0.5% or less. Although the intermediate layer having such an antireflection effect is not limited, polysilsesquioxane that crosslinks by an acid or heat in which a light absorbing group having a phenyl group or a silicon-silicon bond is introduced is preferably used for exposure at 193 nm.

Alternatively, a resist intermediate layer film formed by chemical vapour deposition (CVD) may be used. Although the intermediate layer highly effective as an antireflection film made by CVD is not limited, for example, a SiON film is known. In general, the formation of a resist intermediate layer film by a wet process such as spin coating or screen printing is more convenient and more advantageous in cost, as compared with CVD. The upper layer resist for a three-layer process may be positive type or negative type, and the same as a single-layer resist usually used can be used.

The resist underlayer film of the present embodiment can also be used as an antireflection film for usual single-layer resists or an underlying material for suppression of pattern collapse. The resist underlayer film of the present embodiment is excellent in etching resistance for an underlying process and can therefore be expected to also function as a hard mask for an underlying process.

In the case of forming a resist layer from the publicly known photoresist material mentioned above, a wet process such as spin coating or screen printing is preferably used, as in the case of forming the resist underlayer film. After coating with the resist material by spin coating or the like, prebaking is usually performed. This prebaking is preferably performed at a baking temperature of 80 to 180°C for a baking time in the range of 10 seconds to 300 seconds. Then, exposure, post-exposure baking (PEB), and development can be performed according to a conventional method to obtain a resist pattern. The thickness of each resist film is not particularly limited, but is generally preferably 30 nm to 500 nm and more preferably 50 nm to 400 nm.

The exposure light can be arbitrarily selected and used according to the photoresist material to be used. General examples thereof can include a high energy ray having a wavelength of 300 nm or less, specifically, excimer laser of 248 nm, 193 nm, or 157 nm, soft x-ray of 3 to 20 nm, electron beam, and X-ray.

In a resist pattern formed by the above method, pattern collapse is suppressed by the resist underlayer film of the present embodiment. Therefore, use of the resist underlayer film of the present embodiment can produce a finer pattern and can reduce an exposure amount necessary for obtaining the resist pattern.

Next, etching is performed with the obtained resist pattern as a mask. Gas etching is preferably used as the etching of the resist underlayer film in a two-layer process. The gas etching is preferably etching using oxygen gas. In addition to oxygen gas, an inert gas such as He or Ar, or CO, CO₂, NH₃, SO₂, N₂, NO₂, or H₂ gas may be added. Alternatively, the gas etching may be performed with CO, CO₂, NH₃, N₂, NO₂, or H₂ gas alone without the use of oxygen gas. Particularly, the latter gas is preferably used for side wall protection in order to prevent the undercut of pattern side walls.

On the other hand, gas etching is also preferably used as the etching of the intermediate layer (layer positioned between the photoresist layer and the resist underlayer film) in a three-layer process. The same gas etching as described in the above two-layer process is applicable thereto. Particularly, it is preferable to process the intermediate layer in a three-layer process by using chlorofluorocarbon based gas and using the resist pattern as a mask. Then, as mentioned above, the resist underlayer film can be processed by, for example, oxygen gas etching with the intermediate layer pattern as a mask.

Herein, in the case of forming an inorganic hard mask intermediate layer film as the intermediate layer, a silicon oxide film, a silicon nitride film, or a silicon oxynitride film (SiON film) is formed by CVD, ALD, or the like. Although a method for forming the nitride film is not limited, for example, a method described in Japanese Patent Application Laid-Open No. 2002-334869 or WO 2004/066377 can be used. Although a photoresist film can be formed directly on such an intermediate layer film, an organic antireflection film (BARC) may be formed on the intermediate layer film by spin coating and a photoresist film may be formed thereon.

A polysilsesquioxane based intermediate layer is also preferably used as the intermediate layer. By imparting effects as an antireflection film to the resist intermediate film, there is a tendency that reflection can be effectively suppressed. Although a specific material for the polysilsesquioxane based intermediate layer is not limited, for example, a material described in Japanese Patent Application Laid-Open No. 2007-226170 or 2007-226204 can be used.

The etching of the substrate can also be performed by a conventional method. For example, the substrate made of SiO₂ or SiN can be etched mainly using chlorofluorocarbon based gas, and the substrate made of p-Si, Al, or W can be etched mainly using chlorine or bromine based gas. In the case of etching the substrate with chlorofluorocarbon based gas, the silicon-containing resist of the two-layer resist process or the silicon-containing intermediate layer of the three-layer process is peeled at the same time with substrate processing. On the other hand, in the case of etching the substrate with chlorine or bromine based gas, the silicon-containing resist layer or the silicon-containing intermediate layer is separately peeled and in general, peeled by dry etching using chlorofluorocarbon based gas after substrate processing.

The resist underlayer film of the present embodiment is excellent in etching resistance of these substrates. The substrate can be arbitrarily selected from publicly known ones and used and is not particularly limited. Examples thereof include Si, α-Si, p-Si, SiO₂, SiN, SiON, W, TiN, and Al. The substrate may be a laminate having a film to be processed (substrate to be processed) on a base material (support). Examples of such a film to be processed include various low-k films such as Si, SiO₂, SiON, SiN, p-Si, α-Si, W, W-Si, Al, Cu, and Al-Si, and stopper films thereof. A material different from that for the base material (support) is usually used. The thickness of the substrate to be processed or the film to be processed is not particularly limited, but is usually preferably about 50 nm to 10,000 nm and more preferably 75 nm to 5,000 nm.

The resist underlayer film of the present embodiment is excellent in smoothness of an uneven substrate by filling. The method for evaluating the smoothness by filling can be arbitrarily selected from publicly known ones and used and is not particularly limited. The smoothness of an uneven substrate by filling can be evaluated, for example, by coating an uneven silicon substrate with a solution of each compound adjusted to a predetermined concentration by spin coating, performing solvent removal and drying at 110°C for 90 seconds, forming a tellurium-containing underlayer film so as to have a predetermined thickness, then baking the underlayer film at a temperature of about 240 to 300°C for a predetermined time, and then measuring the difference in underlayer film thickness (ΔT) between a line & space region and a patternless open region using an ellipsometer.

### Examples

The present invention will be more specifically described with reference to production examples and examples below. However, the present invention is not limited to these examples by any means.

### [Measurement Method]

### (Structure of Compound)

The structure of the compound was verified by carrying out ¹H-NMR measurement under the following conditions using "Advance 600 II spectrometer" manufactured by Bruker.
Frequency: 400 MHz
Solvent: d6-DMSO
Internal standard: TMS
Measurement temperature: 23°C

### (Molecular Weight)

The molecular weight of the compound was measured by LC-MS analysis using "Acquity UPLC/MALDI-Synapt HDMS" manufactured by Waters Corp.

### (Molecular Weight in Terms of Polystyrene)

The weight average molecular weight (Mw) and the number average molecular weight (Mn) in terms of polystyrene were determined by gel permeation chromatography (GPC) analysis, and the dispersibility (Mw/Mn) was determined.
Apparatus: Shodex GPC-101 (manufactured Showa Denko K.K.)
Column: KF-80M × 3
Eluent: 1 ml/min THF
Temperature: 40°C

### (Solubility)

The solubility of the obtained compound in propylene glycol monomethyl ether acetate (PGMEA) was measured as the solubility of the compound in a safe solvent. The solubility was evaluated according to the following criteria utilizing the amount of dissolution in PGMEA. The amount of dissolution in PGMEA was measured at 23°C by precisely weighing the compound into a test tube, adding PGMEA so as to attain a predetermined concentration, applying ultrasonic waves for 30 minutes in an ultrasonic cleaner, then visually observing the subsequent state of the fluid, and conducting evaluation on the basis of the concentration of the amount of complete dissolution.

### <Criteria>

A: 5.0% by mass ≤ Amount of dissolution
B: 3.0% by mass ≤ Amount of dissolution < 5.0% by mass
C: Amount of dissolution < 3.0% by mass

### (Production Example 1) Synthesis of Compound (BHPT)

In a glove box, to a 50 mL container, tellurium tetrachloride (5.39 g, 20 mmol) was fed, 10.8 g (100 mmol) of anisole was added, and the mixture was reacted at 160°C for 6 hours under reflux conditions. The obtained product was dried under reduced pressure, and recrystallization was carried out twice using acetonitrile, followed by filtration to obtain orange crystals. The obtained crystals were dried under reduced pressure for 24 hours to obtain 5.95 g of BMPT (bis(4-methoxyphenyl)tellurium dichloride).

As a result of measuring the molecular weight of the obtained compound (BMPT) by the above measurement method (LC-MS), it was 414.

The following peaks were found by NMR measurement performed on the obtained compound (BMPT) under the above measurement conditions, and the compound was confirmed to have a chemical structure of the compound (BMPT) shown below.
δ (ppm) 7.0 - 7.9 (8H, Ph-H), 3.8 (6H, -CH₃)

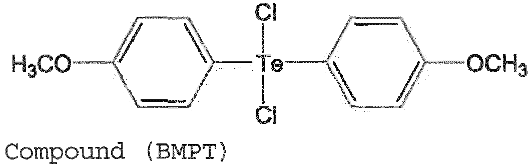

Then, to a container (internal capacity: 100 mL) equipped with a stirrer, a condenser tube, and a burette, 1.1 g (2.8 mmol) of bis(4-methoxyphenyl)tellurium dichloride and 18 ml of methylene dichloride were added, 3.9 g (15.75 mmol) of boron tribromide was dropped, and the mixture was reacted at -20°C for 48 hours. The solution after reaction was dropped to a 0.5 N hydrochloric acid solution in an ice bath, and a yellow solid was recovered after filtration. The solid was dissolved in ethyl acetate, the solution was dehydrated by the addition of magnesium sulfate and then concentrated, and the residue was separated and purified by column chromatography to obtain 0.1 g of BHPT (bis(4-hydroxyphenyl)tellurium dichloride).

As a result of measuring the molecular weight of the obtained compound (BHPT) by the above measurement method (LC-MS), it was 386.

The following peaks were found by NMR measurement performed on the obtained compound (BHPT) under the above measurement conditions, and the compound was confirmed to have a chemical structure of the compound (BHPT) shown below.
δ (ppm) 10.2 (2H, -OH), 6.8 - 7.8 (8H, Ph-H)

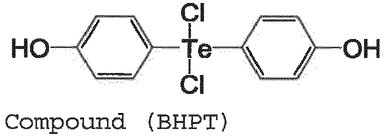

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 2) Synthesis of Compound (BHPT-ADBAC)

In a container (internal capacity: 200 mL) equipped with a stirrer, a condenser tube, and a burette, 3.9 g (10 mmol) of the compound (BHPT) obtained as mentioned above, 0.30 g (22 mmol) of potassium carbonate, and 0.64 g (2 mmol) of tetrabutyl ammonium bromide were dissolved in 50 ml of N-methylpyrrolidone, and the solution was stirred for 2 hours. After stirring, 6.3 g (22 mmol) of bromoacetic acid-2-methyladamantan-2-yl was further added thereto, and the mixture was reacted at 100°C for 24 hours. After the reaction terminated, the reaction mixture was dropped to a 1 N aqueous hydrochloric acid solution, and the resulting black solid was filtered off and separated and purified by column chromatography to obtain 1.9 g of the following compound (BHPT-ADBAC: bis(4-(2-methyl-2-adamantyloxycarbonylmethoxy)phenyl)tellurium dichloride).

As a result of measuring the molecular weight of the obtained compound (BHPT-ADBAC) by the above measurement method (LC-MS), it was 798.

The following peaks were found by NMR measurement performed on the obtained compound (BHPT-ADBAC) under the above measurement conditions, and the compound was confirmed to have a chemical structure of the compound (BHPT-ADBAC) shown below.
δ (ppm) 6.8 - 8.1 (8H, Ph-H), 4.7 - 5.0 (4H, O-CH₂-C (=O)-), 1.2 - 2.7 (34H, C-H/Adamantane of methylene and methine)

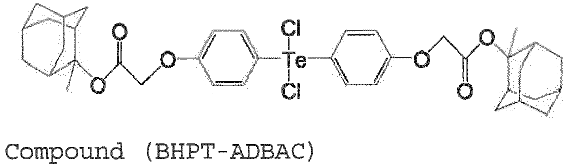

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 3) Synthesis of Compound (BHPT-BOC)

In a container (internal capacity: 200 mL) equipped with a stirrer, a condenser tube, and a burette, 3.9 g (10 mmol) of the compound (BHPT) obtained as mentioned above and 5.5 g (25 mmol) of di-t-butyl dicarbonate (manufactured by Sigma-Aldrich) were dissolved in 50 ml of N-methylpyrrolidone, 0.30 g (22 mmol) of potassium carbonate was added to the solution, and the mixture was reacted at 100°C for 24 hours. After the reaction terminated, the reaction mixture was dropped to a 1 N aqueous hydrochloric acid solution, and the resulting black solid was filtered off and separated and purified by column chromatography to obtain 1.0 g of the following compound (BHPT-BOC: bis(tert-butoxycarboxyphenyl)tellurium dichloride).

As a result of measuring the molecular weight of the obtained compound (BHPT-BOC) by the above measurement method (LC-MS), it was 585.

The following peaks were found by NMR measurement performed on the obtained compound (BHPT-BOC) under the above measurement conditions, and the compound was confirmed to have a chemical structure of the compound (BHPT-BOC) shown below.
δ (ppm) 7.1 - 7.3 (8H, Ph-H), 1.4 (18H, C-CH₃)

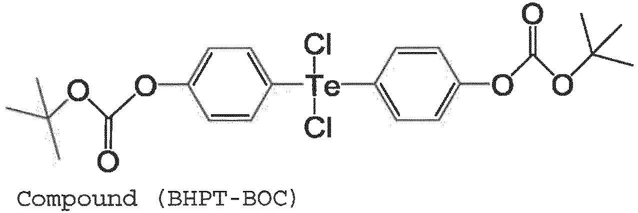

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 4) Synthesis of Compound (BHPT-EE)

In a container (internal capacity: 200 mL) equipped with a stirrer, a condenser tube, and a burette, 3.9 g (10 mmol) of the compound (BHPT) obtained as mentioned above and 1.8 g (25 mmol) of ethyl vinyl ether (manufactured by Tokyo Kasei Kogyo Co., Ltd.) were dissolved in 50 ml of N-methylpyrrolidone, 0.30 g (22 mmol) of potassium carbonate was added to the solution, and the mixture was reacted at 100°C for 24 hours. After the reaction terminated, the reaction mixture was dropped to a 1 N aqueous hydrochloric acid solution, and the resulting black solid was filtered off and separated and purified by column chromatography to obtain 1.0 g of the following compound (BHPT-EE:
bis(ethoxyethylphenyl)tellurium dichloride).

As a result of measuring the molecular weight of the obtained compound (BHPT-EE) by the above measurement method (LC-MS), it was 529.

The following peaks were found by NMR measurement performed on the obtained compound (BHPT-EE) under the above measurement conditions, and the compound was confirmed to have a chemical structure of the compound (BHPT-EE) shown below.
δ (ppm) 6.9 - 7.4 (8H, Ph-H), 5.6 (2H, CH), 1.6 (6H, -CH₃), 3.9 (4H, O-CH₂-), 1.2 (6H, -CH₃)

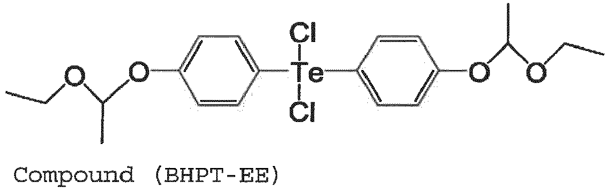

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 5) Synthesis of Compound (Ph-BHPT)

In a glove box, to a 50 mL container, tellurium tetrachloride (5.39 g, 20 mmol) was fed, 7.37 g (40 mmol) of 2-phenylanisole was added, and the mixture was reacted at 160°C for 6 hours under reflux conditions. The obtained product was dried under reduced pressure, and recrystallization was carried out twice using acetonitrile, followed by filtration to obtain orange crystals. The obtained crystals were dried under reduced pressure for 24 hours to obtain 3.91 g of Ph-BMPT (bis(3-phenyl-4-methoxyphenyl)tellurium dichloride).

As a result of measuring the molecular weight of the obtained compound (Ph-BMPT) by the above measurement method (LC-MS), it was 465.

The following peaks were found by NMR measurement performed on the obtained compound (Ph-BMPT) under the above measurement conditions, and the compound was confirmed to have a chemical structure of the compound (Ph-BMPT) shown below.
δ (ppm) 7.0 - 8.1 (16H, Ph-H), 3.8 (6H, -CH₃)

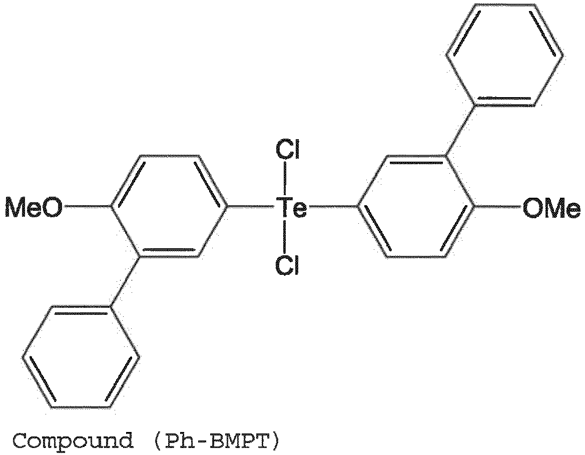

Then, to a container (internal capacity: 100 mL) equipped with a stirrer, a condenser tube, and a burette, 1.6 g (2.8 mmol) of Ph-BMPT and 25 ml of methylene dichloride were added, 3.9 g (15.75 mmol) of boron tribromide was dropped, and the mixture was reacted at - 20°C for 48 hours. The solution after reaction was dropped to a 0.5 N hydrochloric acid solution in an ice bath, and a yellow solid was recovered after filtration. The solid was dissolved in ethyl acetate, the solution was dehydrated by the addition of magnesium sulfate and then concentrated, and the residue was separated and purified by column chromatography to obtain 0.2 g of Ph-BHPT (bis(3-phenyl-4-hydroxyphenyl)tellurium dichloride).

As a result of measuring the molecular weight of the obtained compound (Ph-BHPT) by the above measurement method (LC-MS), it was 537.

The following peaks were found by NMR measurement performed on the obtained compound (Ph-BHPT) under the above measurement conditions, and the compound was confirmed to have a chemical structure of the compound (Ph-BHPT) shown below.
δ (ppm) 9.0 (2H, -OH), 7.0 - 7.5 (16H, Ph-H)

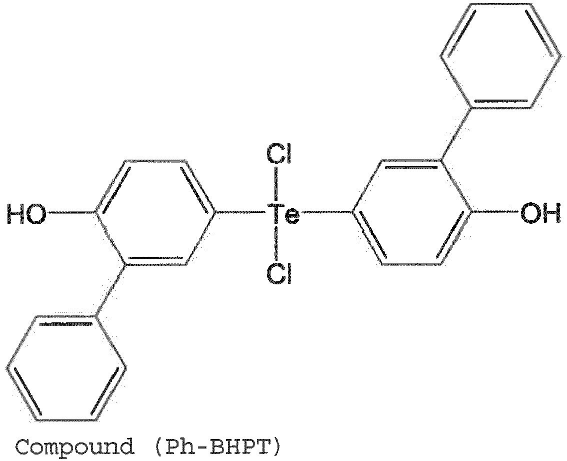

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 6) Synthesis of Compound (TDP)

In a glove box, to a 50 mL container, tellurium tetrachloride (6.74 g, 25 mmol) was fed, 3.29 g (35 mmol) of phenol was added, and the mixture was reacted at 160°C for 6 hours under reflux conditions. The obtained product was dried under reduced pressure, and recrystallization was carried out twice using acetonitrile, followed by filtration to obtain brown crystals. The obtained crystals were dried under reduced pressure for 24 hours to obtain 3.60 g of TDP (4,4'-telluriumdiphenol).

As a result of measuring the molecular weight of the obtained compound (TDP) by the above measurement method (LC-MS), it was 314.

The following peaks were found by NMR measurement performed on the obtained compound (TDP) under the above measurement conditions, and the compound was confirmed to have a chemical structure of the compound (TDP) shown below.
δ (ppm) 6.8 - 7.7 (8H, Ph-H), 9.8 (2H, -OH)

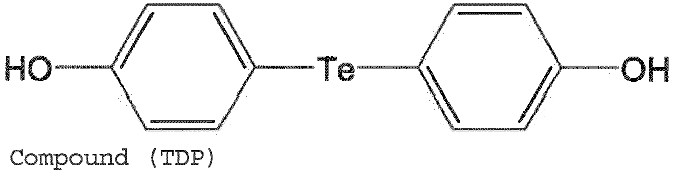

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 7) Synthesis of Compound (Ph-TDP)

In a glove box, to a 50 mL container, tellurium tetrachloride (6.74 g, 25 mmol) was fed, 6.96 g (35 mmol) of 2-phenol was added, and the mixture was reacted at 160°C for 6 hours under reflux conditions. The obtained product was dried under reduced pressure, and recrystallization was carried out twice using acetonitrile, followed by filtration to obtain brown crystals. The obtained crystals were dried under reduced pressure for 24 hours to obtain 2.46 g of Ph-TDP (bis(3-phenyl-4-hydroxyphenyl)tellurium).

As a result of measuring the molecular weight of the obtained compound (Ph-TDP) by the above measurement method (LC-MS), it was 466.

The following peaks were found by NMR measurement performed on the obtained compound (Ph-TDP) under the above measurement conditions, and the compound was confirmed to have a chemical structure of the compound (Ph-TDP) shown below.
δ (ppm) 6.8 - 7.7 (16H, Ph-H), 9.8 (2H, -OH)

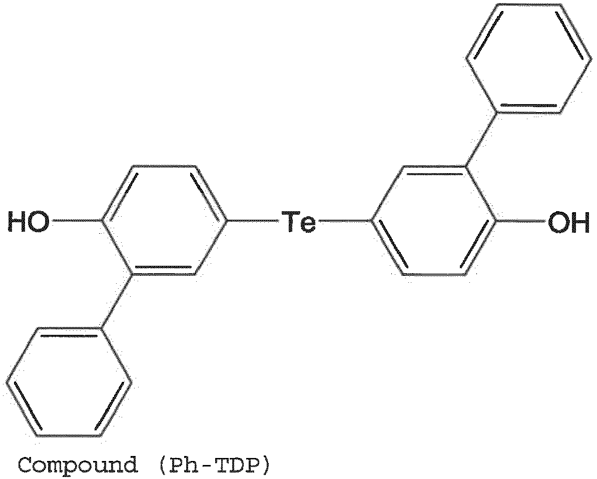

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 8) Synthesis of Compound (Ph-BHPT-ADBAC)

The same operations as in Production Example 2 were performed except that 5.4 g (10 mmol) of the compound (Ph-BHPT) was used in place of 3.9 g (10 mmol) of the compound (BHPT), to obtain 1.28 g of a compound (Ph-BHPT-ADBAC) having a structure shown below.

As a result of measuring the molecular weight of the obtained compound (Ph-BHPT-ADBAC) by the above measurement method (LC-MS), it was 537.

The following peaks were found by NMR measurement performed on the obtained compound (Ph-BHPT-ADBAC) under the above measurement conditions, and the compound was confirmed to have a chemical structure of the compound (BHPT-ADBAC) shown below.
δ (ppm) 7.1 - 7.7 (16H, Ph-H), 5.0 (4H, O-CH₂-C (=O)-), 1.0 - 2.6 (34H, C-H/Adamantane of methylene and methine)

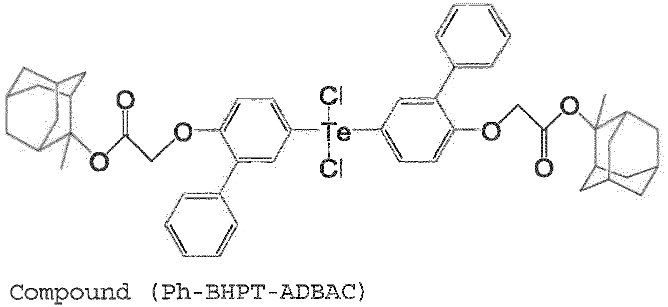

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 9) Synthesis of Compound (TDP-ADBAC)

The same operations as in Production Example 2 were performed except that 3.2 g (10 mmol) of the compound (TDP) was used in place of 3.9 g (10 mmol) of the compound (BHPT), to obtain 1.46 g of a compound (TDP-ADBAC) having a structure shown below.

As a result of measuring the molecular weight of the obtained compound (TDP-ADBAC) by the above measurement method (LC-MS), it was 726.

The following peaks were found by NMR measurement performed on the obtained compound (TDP-ADBAC) under the above measurement conditions, and the compound was confirmed to have a chemical structure of the compound (TDP-ADBAC) shown below.
δ (ppm) 7.0 - 7.4 (8H, Ph-H), 5.0 (4H, O-eH₂-C (=O)-), 1.0 - 2.6 (34H, C-H/Adamantane of methylene and methine)

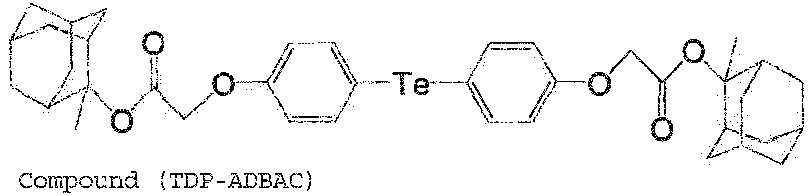

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 10) Synthesis of Compound (Ph-TDP-ADBAC)

The same operations as in Production Example 2 were performed except that 4.7 g (10 mmol) of the compound (Ph-TDP) was used in place of 3.9 g (10 mmol) of the compound (BHPT), to obtain 1.70 g of a compound (Ph-TDP-ADBAC) having a structure shown below.

As a result of measuring the molecular weight of the obtained compound (Ph-TDP-ADBAC) by the above measurement method (LC-MS), it was 879.

The following peaks were found by NMR measurement performed on the obtained compound (Ph-TDP-ADBAC) under the above measurement conditions, and the compound was confirmed to have a chemical structure of the compound (Ph-TDP-ADBAC) shown below.
δ (ppm) 7.1 - 7.7 (16H, Ph-H), 5.0 (4H, O-CH₂-C (=O)-), 1.0 - 2.6 (34H, C-H/Adamantane of methylene and methine)

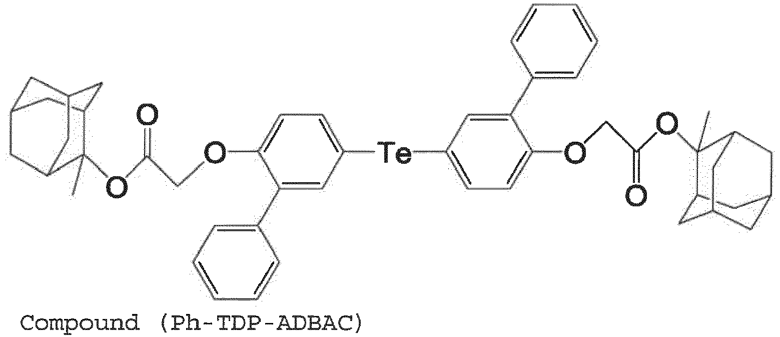

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 11) Synthesis of Compound (Ph-TDP-BOC)

The same operations as in Production Example 3 were performed except that 4.7 g (10 mmol) of the compound (Ph-TDP) was used in place of 3.9 g (10 mmol) of the compound (BHPT), to obtain 1.14 g of a compound (Ph-TDP-BOC) having a structure shown below.

As a result of measuring the molecular weight of the obtained compound (Ph-TDP-BOC) by the above measurement method (LC-MS), it was 666.

The following peaks were found by NMR measurement performed on the obtained compound (Ph-TDP-BOC) under the above measurement conditions, and the compound was confirmed to have a chemical structure of the compound (Ph-TDP-BOC) shown below.
δ (ppm) 7.3 - 7.7 (8H, Ph-H), 1.4 (18H, C-CH₃)

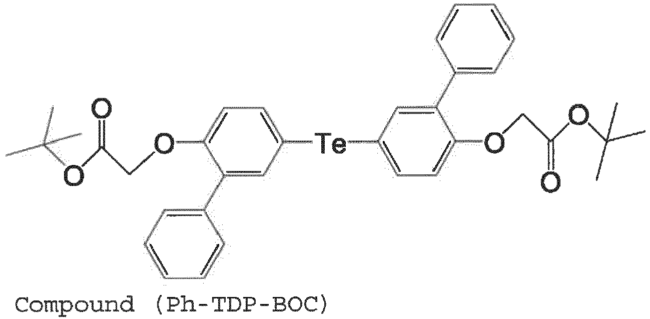

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 12) Synthesis of Compound (Ph-TDP-EE)

The same operations as in Production Example 4 were performed except that 4.7 g (10 mmol) of the compound (Ph-TDP) was used in place of 3.9 g (10 mmol) of the compound (BHPT), to obtain 1.16 g of a compound (Ph-TDP-EE) having a structure shown below.

As a result of measuring the molecular weight of the obtained compound (Ph- TDP-EE) by the above measurement method (LC-MS), it was 610.

The following peaks were found by NMR measurement performed on the obtained compound (Ph-TDP-EE) under the above measurement conditions, and the compound was confirmed to have a chemical structure of the compound (Ph-TDP-EE) shown below.
δ (ppm) 7.1 - 7.7 (16H, Ph-H), 5.6 (2H, CH), 1.6 (6H, -CH₃), 3.9 (4H, O-CH₂-), 1.2 (6H, -CH₃)

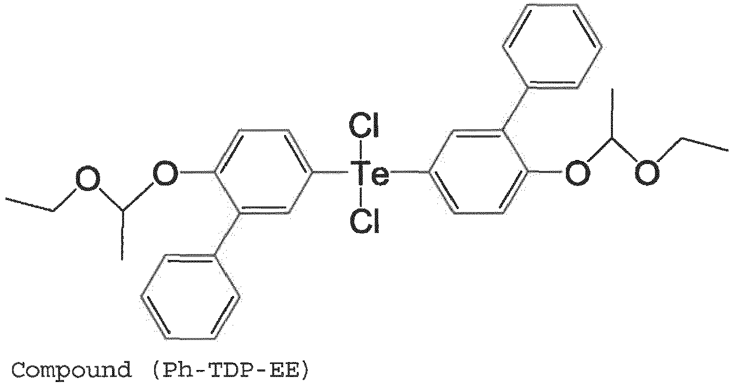

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 13) Synthesis of R1-BHPT

To a container (internal capacity: 100 ml) equipped with a stirrer, a condenser tube, and a burette, 8.1 g (21 mmol) of the compound (BHPT), 0.7 g (42 mmol) of paraformaldehyde, 50 ml of glacial acetic acid, and 50 ml of PGME were fed, 8 ml of 95% sulfuric acid was added, and the reaction solution was stirred at 100°C for 6 hours and reacted. Next, the reaction solution was concentrated. The reaction product was precipitated by the addition of 1000 ml of methanol. After cooling to room temperature, the precipitates were separated by filtration. The obtained solid matter was subjected to filtration, dried, and then separated and purified by column chromatography to obtain 5.6 g of the objective resin (R1-BHPT) having a structure represented by the following formula.

As a result of measuring the molecular weight in terms of polystyrene of the obtained resin (R1-BHPT) by the above method, it was Mn: 587, Mw: 1216, Mw/Mn: 2.07.

The following peaks were found by NMR measurement performed on the obtained resin(R1-BHPT) under the above measurement conditions, and the resin was confirmed to have a chemical structure of the following formula (R1-BHPT) .
δ (ppm) 10.2 (2H, -OH), 6.8 - 7.8 (8H, Ph-H), 4.1 (2H, -CH₂)

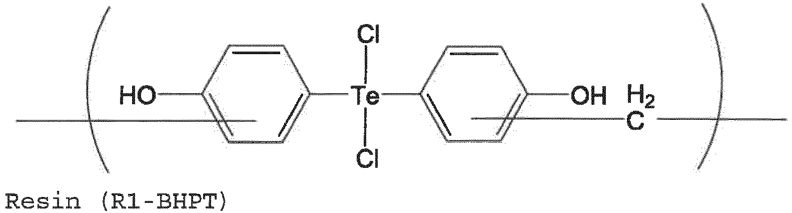

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 14) Synthesis of R2-BHPT

The same operations as in Production Example 13 were performed except that 7.6 g (42 mmol) of 4-biphenylcarboxyaldehyde (manufactured by Mitsubishi Gas Chemical Company Inc.) was used in place of 0.7 g (42 mmol) of paraformaldehyde, to obtain 5.7 g of the objective resin (R2-BHPT) having a structure represented by the following formula.

As a result of measuring the molecular weight in terms of polystyrene of the obtained resin (R2-BHPT) by the above method, it was Mn: 405, Mw: 880, Mw/Mn: 2.17.

The following peaks were found by NMR measurement performed on the obtained resin (R2-BHPT) under the above measurement conditions, and the resin was confirmed to have a chemical structure of the following formula (R2-BHPT).
δ (ppm) 10.2 (2H, -OH), 6.8 - 7.8 (17H, Ph-H), 4.5 (1H, -CH)

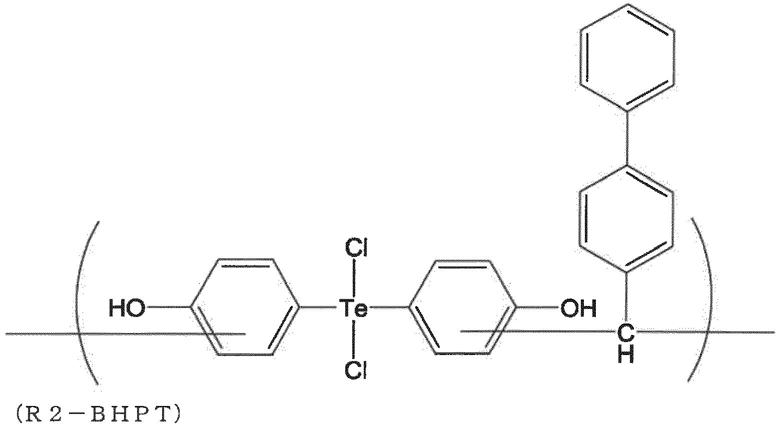

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 15) Synthesis of R1-BHPT-ADBAC

The same operations as in Production Example 13 were performed except that 16.8 g of the compound (BHPT-ADBAC) was used in place of 8.1 g (21 mmol) of the compound (BHPT), to obtain 5.0 g of the objective resin (R1-BHPT-ADBAC) having a structure represented by the following formula.

As a result of measuring the molecular weight in terms of polystyrene of the obtained resin (R1-BHPT-ADBAC) by the above method, it was Mn: 1045, Mw: 2330, Mw/Mn: 2.23.

The following peaks were found by NMR measurement performed on the obtained resin (R1-BHPT-ADBAC) under the above measurement conditions, and the resin was confirmed to have a chemical structure of the following formula (R1-BHPT-ADBAC).
δ (ppm) 6.8 - 8.1 (8H, Ph-H), 4.7 - 5.0 (4H, O-CH₂-C (=O)-), 1.2 - 2.7 (34H, C-H/Adamantane of methylene and methine), 4.1 (2H, -CH₂)

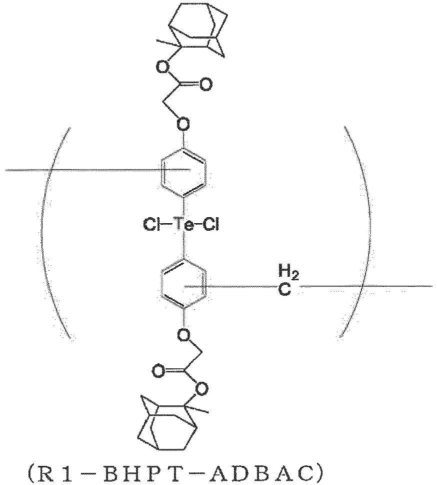

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 16) Synthesis of R2-BHPT-ADBAC

The same operations as in Production Example 15 were performed except that 7.6 g (42 mmol) of 4-biphenylcarboxyaldehyde (manufactured by Mitsubishi Gas Chemical Company Inc.) was used in place of 0.7 g (42 mmol) of paraformaldehyde, to obtain 10.4 g of the objective resin (R2-BHPT-ADBAC) having a structure represented by the following formula.

As a result of measuring the molecular weight in terms of polystyrene of the obtained resin (R2-BHPT-ADBAC) by the above method, it was Mn: 840, Mw: 1819, Mw/Mn: 2.16.

The following peaks were found by NMR measurement performed on the obtained resin (R2-BHPT-ADBAC) under the above measurement conditions, and the resin was confirmed to have a chemical structure of the following formula (R2-BHPT-ADBAC).
δ (ppm) 6.8 - 8.1 (17H, Ph-H), 4.7 - 5.0 (4H, O-CH₂-C (=O)-), 1.2 - 2.7 (34H, C-H/Adamantane of methylene and methine), 4.5 (1H, -CH)

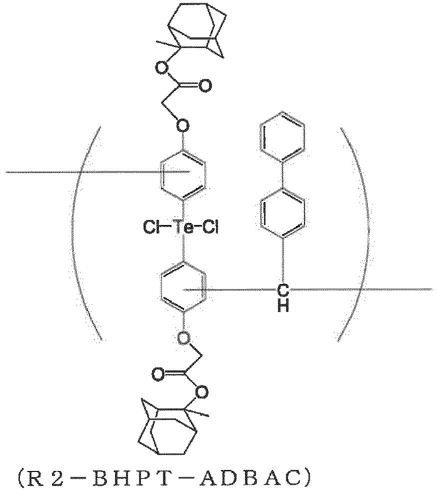

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 17) Synthesis of R1-BHPT-BOC

The same operations as in Production Example 13 were performed except that 12.3 g of the compound (BHPT-BOC) was used in place of 8.1 g (21 mmol) of the compound (BHPT), to obtain 7.6 g of the objective resin (R1-BHPT-BOC) having a structure represented by the following formula.

As a result of measuring the molecular weight in terms of polystyrene of the obtained resin (R1-BHPT-BOC) by the above method, it was Mn: 768, Mw: 1846, Mw/Mn: 2.40.

The following peaks were found by NMR measurement performed on the obtained resin (R1-BHPT-BOC) under the above measurement conditions, and the resin was confirmed to have a chemical structure of the following formula (R1-BHPT-BOC).
δ (ppm) 7.1 - 7.3 (8H, Ph-H), 1.4 (18H, C-CH₃), 4.1 (2H, -CH₂)

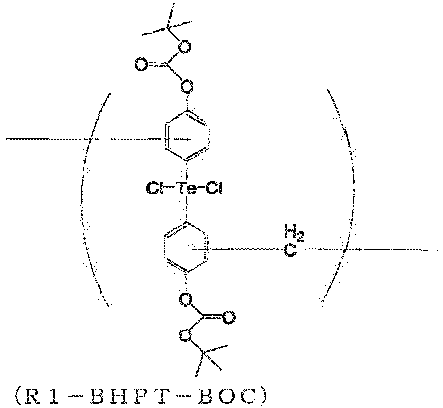

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 18) Synthesis of R2-BHPT-BOC

The same operations as in Production Example 17 were performed except that 7.6 g (42 mmol) of 4-biphenylcarboxyaldehyde (manufactured by Mitsubishi Gas Chemical Company Inc.) was used in place of 0.7 g (42 mmol) of paraformaldehyde, to obtain 3.7 g of the objective resin (R2-BHPT-BOC) having a structure represented by the following formula.

As a result of measuring the molecular weight in terms of polystyrene of the obtained resin (R2-BHPT-BOC) by the above method, it was Mn: 620, Mw: 1336, Mw/Mn: 2.15.

The following peaks were found by NMR measurement performed on the obtained resin (R2-BHPT-BOC) under the above measurement conditions, and the resin was confirmed to have a chemical structure of the following formula (R2-BHPT-BOC).
δ (ppm) 7.1 - 7.3 (17H, Ph-H), 1.4 (18H, C-CH3), 4.5 (1H, -CH)

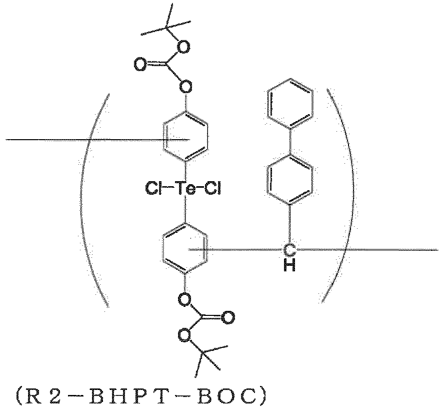

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 19) Synthesis of R1-BHPT-EE

The same operations as in Production Example 13 were performed except that 11.1 g of the compound (BHPT-EE) was used in place of 8.1 g (21 mmol) of the compound (BHPT), to obtain 7.8 g of the objective resin (R1-BHPT-EE) having a structure represented by the following formula.

As a result of measuring the molecular weight in terms of polystyrene of the obtained resin (R1-BHPT-EE) by the above method, it was Mn: 694, Mw: 1548, Mw/Mn: 2.23.

The following peaks were found by NMR measurement performed on the obtained resin (R1-BHPT-EE) under the above measurement conditions, and the resin was confirmed to have a chemical structure of the following formula (R1-BHPT-EE) .
δ (ppm) 6.9 - 7.4 (8H, Ph-H), 5.6 (2H, CH), 1.6 (6H, -CH₃), 3.9 (4H, O-CH₂-), 1.2 (6H, -CH₃), 4.1 (2H, -CH₂)

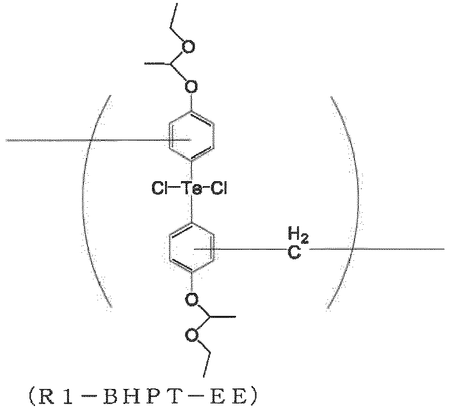

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 20) Synthesis of R2-BHPT-EE

The same operations as in Production Example 19 were performed except that 7.6 g (42 mmol) of 4-biphenylcarboxyaldehyde (manufactured by Mitsubishi Gas Chemical Company Inc.) was used in place of 0.7 g (42 mmol) of paraformaldehyde, to obtain 3.6 g of the objective resin (R2-BHPT-EE) having a structure represented by the following formula.

As a result of measuring the molecular weight in terms of polystyrene of the obtained resin (R2-BHPT-EE) by the above method, it was Mn: 610, Mw: 1208, Mw/Mn: 1.98.

The following peaks were found by NMR measurement performed on the obtained resin (R2-BHPT-EE) under the above measurement conditions, and the resin was confirmed to have a chemical structure of the following formula (R2-BHPT-EE).
δ (ppm) 6.9 - 7.4 (17H, Ph-H), 5.6 (2H, CH), 1.6 (6H, -CH₃), 3.9 (4H, O-CH₂-), 1.2 (6H, -CH₃), 4.5 (1H, - CH)

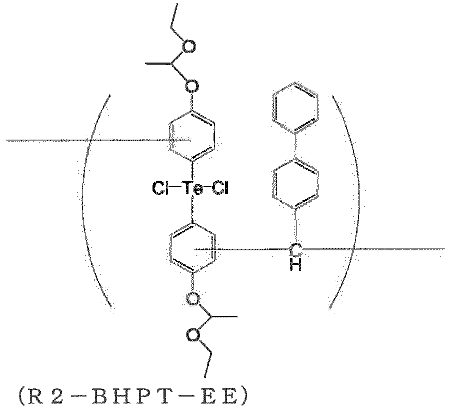

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 21) Synthesis of R1-Ph-BHPT

The same operations as in Production Example 13 were performed except that 11.3 g of the compound (Ph-BHPT) was used in place of 8.1 g (21 mmol) of the compound (BHPT), to obtain 7.0 g of the objective resin (R1-Ph-BHPT) having a structure represented by the following formula.

As a result of measuring the molecular weight in terms of polystyrene of the obtained resin (R1-Ph-BHPT) by the above method, it was Mn: 764, Mw: 1695, Mw/Mn: 2.22.

The following peaks were found by NMR measurement performed on the obtained resin (R1-Ph-BHPT) under the above measurement conditions, and the resin was confirmed to have a chemical structure of the following formula (R1-Ph-BHPT) .
δ (ppm) 9.0 (2H, -OH), 7.0 - 7.5 (16H, Ph-H), 4.1 (2H, -CH₂)

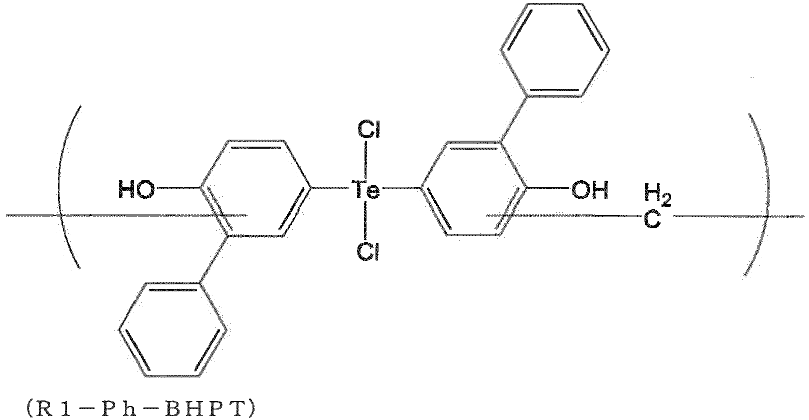

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 22) Synthesis of R2-Ph-BHPT

The same operations as in Production Example 21 were performed except that 7.6 g (42 mmol) of 4-biphenylcarboxyaldehyde (manufactured by Mitsubishi Gas Chemical Company Inc.) was used in place of 0.7 g (42 mmol) of paraformaldehyde, to obtain 3.4 g of the objective resin (R2-Ph-BHPT) having a structure represented by the following formula.

As a result of measuring the molecular weight in terms of polystyrene of the obtained resin (R2-Ph-BHPT) by the above method, it was Mn: 672, Mw: 1345, Mw/Mn: 2.00.

The following peaks were found by NMR measurement performed on the obtained resin (R2-Ph-BHPT) under the above measurement conditions, and the resin was confirmed to have a chemical structure of the following formula (R2-Ph-BHPT).
δ (ppm) 9.0 (2H, -OH), 7.0 - 7.5 (25H, Ph-H), 4.5 (1H, -CH)

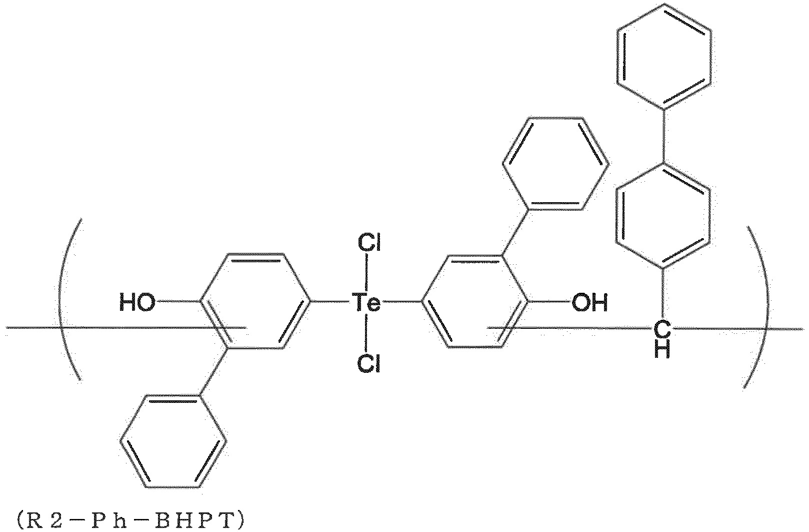

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 23) Synthesis of R1-TDP

The same operations as in Production Example 13 were performed except that 6.6 g of the compound (TDP) was used in place of 8.1 g (21 mmol) of the compound (BHPT), to obtain 4.6 g of the objective resin (R1-TDP) having a structure represented by the following formula.

As a result of measuring the molecular weight in terms of polystyrene of the obtained resin (R1-TDP) by the above method, it was Mn: 449, Mw: 995, Mw/Mn: 2.22.

The following peaks were found by NMR measurement performed on the obtained resin (R1-TDP) under the above measurement conditions, and the resin was confirmed to have a chemical structure of the following formula (R1-TDP) .
δ (ppm) 6.8 - 7.7 (8H, Ph-H), 9.8 (2H, -OH), 4.1 (2H, -CH₂)

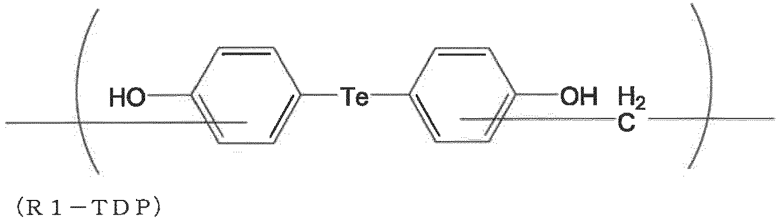

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 24) Synthesis of R2-TDP

The same operations as in Production Example 23 were performed except that 7.6 g (42 mmol) of 4-biphenylcarboxyaldehyde (manufactured by Mitsubishi Gas Chemical Company Inc.) was used in place of 0.7 g (42 mmol) of paraformaldehyde, to obtain 2.0 g of the objective resin (R2-TDP) having a structure represented by the following formula.

As a result of measuring the molecular weight in terms of polystyrene of the obtained resin (R2-TDP) by the above method, it was Mn: 414, Mw: 922, Mw/Mn: 2.23.

The following peaks were found by NMR measurement performed on the obtained resin (R2-TDP) under the above measurement conditions, and the resin was confirmed to have a chemical structure of the following formula (R2-TDP) .
δ (ppm) 6.8 - 7.7 (17H, Ph-H), 9.8 (2H, -OH), 4.5 (1H, -CH)

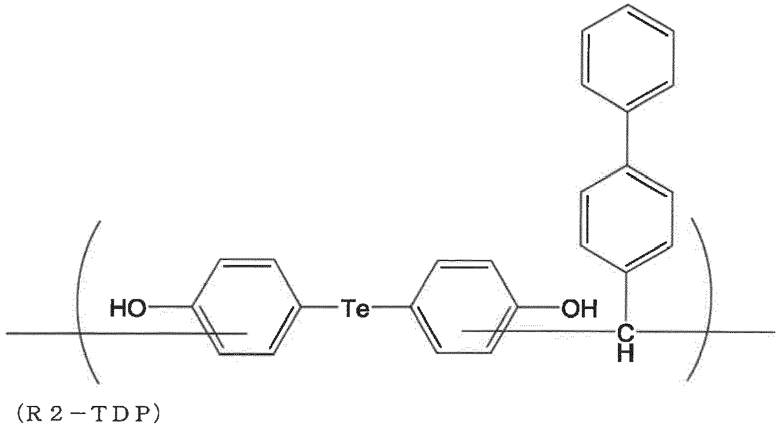

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 25) Synthesis of R1-Ph-TDP

The same operations as in Production Example 13 were performed except that 9.8 g of the compound (Ph-TDP) was used in place of 8.1 g (21 mmol) of the compound (BHPT), to obtain 6.9 g of the objective resin (R1-Ph-TDP) having a structure represented by the following formula.

As a result of measuring the molecular weight in terms of polystyrene of the obtained resin (R1-Ph-TDP) by the above method, it was Mn: 665, Mw: 1474, Mw/Mn: 2.22.

The following peaks were found by NMR measurement performed on the obtained resin (R1-Ph-TDP) under the above measurement conditions, and the resin was confirmed to have a chemical structure of the following formula (R1-Ph-TDP) .
δ (ppm) 6.8 - 7.7 (16H, Ph-H), 9.8 (2H, -OH), 4.1 (2H, -CH₂)

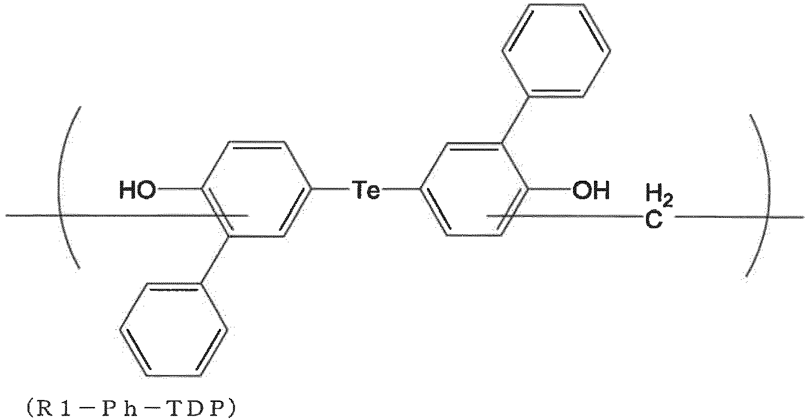

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 26) Synthesis of R2-Ph-TDP

The same operations as in Production Example 25 were performed except that 7.6 g (42 mmol) of 4-biphenylcarboxyaldehyde (manufactured by Mitsubishi Gas Chemical Company Inc.) was used in place of 0.7 g (42 mmol) of paraformaldehyde, to obtain 3.2 g of the objective resin (R2-Ph-TDP) having a structure represented by the following formula.

As a result of measuring the molecular weight in terms of polystyrene of the obtained resin (R2-Ph-TDP) by the above method, it was Mn: 608, Mw: 1395, Mw/Mn: 2.29.

The following peaks were found by NMR measurement performed on the obtained resin (R2-Ph-TDP) under the above measurement conditions, and the resin was confirmed to have a chemical structure of the following formula (R2-Ph-TDP).
δ (ppm) 6.8 - 7.7 (25H, Ph-H), 9.8 (2H, -OH), 4.5 (1H, -CH)

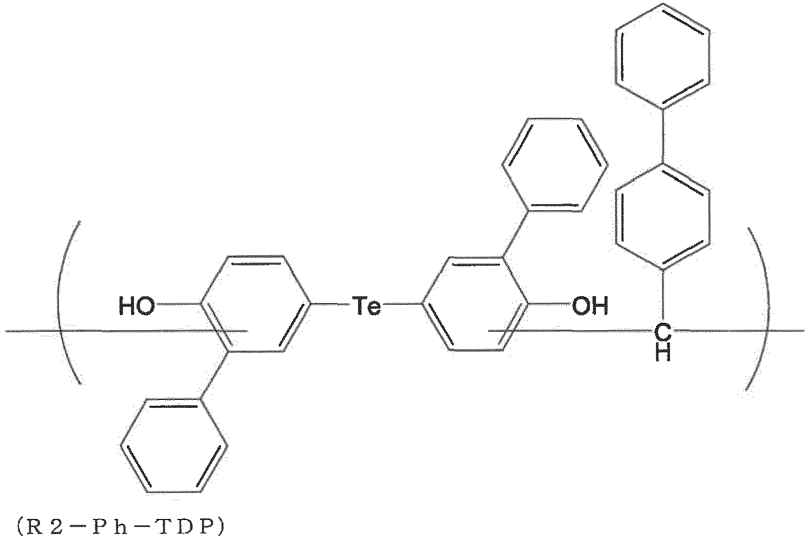

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 27) Synthesis of R1-Ph-BHPT-ADBAC

The same operations as in Production Example 13 were performed except that 20.0 g of the compound (Ph-BHPT-ADBAC) was used in place of 8.1 g (21 mmol) of the compound (BHPT), to obtain 5.0 g of the objective resin (R1-Ph-BHPT-ADBAC) having a structure represented by the following formula.

As a result of measuring the molecular weight in terms of polystyrene of the obtained resin (R1-Ph-BHPT-ADBAC) by the above method, it was Mn: 1045, Mw: 2330, Mw/Mn: 2.23.

The following peaks were found by NMR measurement performed on the obtained resin (R1-Ph-BHPT-ADBAC) under the above measurement conditions, and the resin was confirmed to have a chemical structure of the following formula (R1-Ph-BHPT-ADBAC).
δ (ppm) 6.8 - 8.1 (8H, Ph-H), 4.7 - 5.0 (4H, O-CH₂-C (=O)-), 1.2 - 2.7 (34H, C-H/Adamantane of methylene and methine), 4.1 (2H, -CH₂)

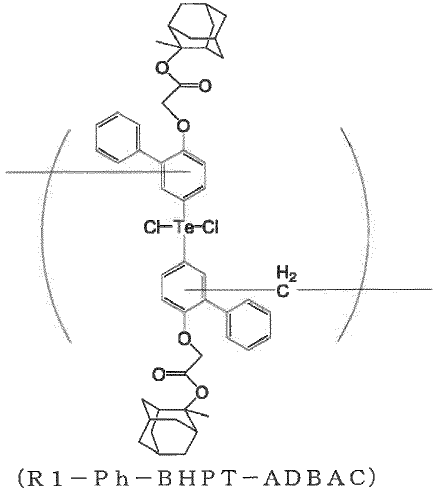

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 28) Synthesis of R2-Ph-BHPT-ADBAC

The same operations as in Production Example 27 were performed except that 7.6 g (42 mmol) of 4-biphenylcarboxyaldehyde (manufactured by Mitsubishi Gas Chemical Company Inc.) was used in place of 0.7 g (42 mmol) of paraformaldehyde, to obtain 6.0 g of the objective resin (R2-Ph-BHPT-ADBAC) having a structure represented by the following formula.

As a result of measuring the molecular weight in terms of polystyrene of the obtained resin (R2-Ph-BHPT-ADBAC) by the above method, it was Mn: 1188, Mw: 2394, Mw/Mn: 2.02.

The following peaks were found by NMR measurement performed on the obtained resin (R2-Ph-BHPT-ADBAC) under the above measurement conditions, and the resin was confirmed to have a chemical structure of the following formula (R2-Ph-BHPT-ADBAC).
δ (ppm) 7.1 - 7.7 (25H, Ph-H), 5.0 (4H, O-CH2-C (=O)-), 1.0 - 2.6 (34H, C-H/Adamantane of methylene and methine), 4.5 (1H, -CH)

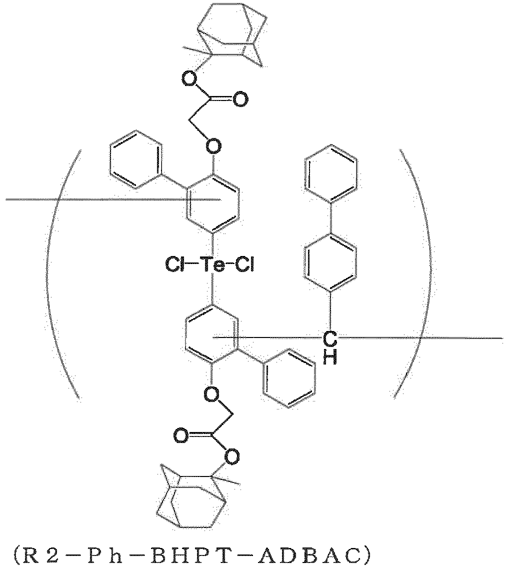

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 29) Synthesis of R1-TDP-ADBAC

The same operations as in Production Example 13 were performed except that 15.3 g of the compound (TDP-ADBAC) was used in place of 8.1 g (21 mmol) of the compound (BHPT), to obtain 11.4 g of the objective resin (R1-TDP-ADBAC) having a structure represented by the following formula.

As a result of measuring the molecular weight in terms of polystyrene of the obtained resin (R1-TDP-ADBAC) by the above method, it was Mn: 954, Mw: 2148, Mw/Mn: 2.25.

The following peaks were found by NMR measurement performed on the obtained resin (R1-TDP-ADBAC) under the above measurement conditions, and the resin was confirmed to have a chemical structure of the following formula (R1-TDP-ADBAC).
δ (ppm) 7.0 - 7.4 (8H, Ph-H), 5.0 (4H, O-CH2-C (=O)-), 1.0 - 2.6 (34H, C-H/Adamantane of methylene and methine), 4.1 (2H, -CH2)

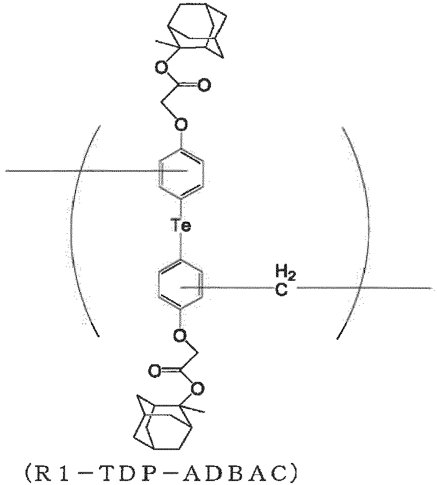

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 30) Synthesis of R2-TDP-ADBAC

The same operations as in Production Example 29 were performed except that 7.6 g (42 mmol) of 4-biphenylcarboxyaldehyde (manufactured by Mitsubishi Gas Chemical Company Inc.) was used in place of 0.7 g (42 mmol) of paraformaldehyde, to obtain 4.6 g of the objective resin (R2-TDP-ADBAC) having a structure represented by the following formula.

As a result of measuring the molecular weight in terms of polystyrene of the obtained resin (R2-TDP-ADBAC) by the above method, it was Mn: 910, Mw: 1805, Mw/Mn: 1.98.

The following peaks were found by NMR measurement performed on the obtained resin (R2-TDP-ADBAC) under the above measurement conditions, and the resin was confirmed to have a chemical structure of the following formula (R2-TDP-ADBAC).
δ (ppm) 7.0 - 7.4 (17H, Ph-H), 5.0 (4H, O-CH2-C (=O)-), 1.0 - 2.6 (34H, C-H/Adamantane of methylene and methine), 4.5 (1H, -CH)

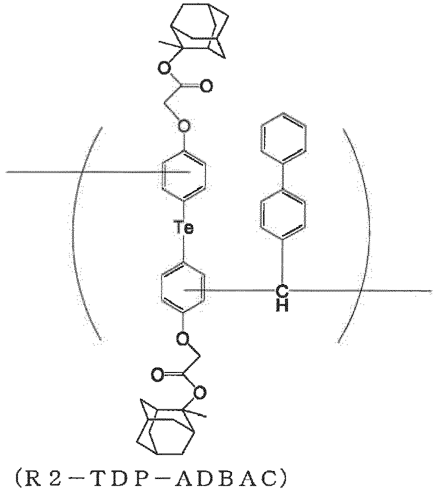

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 31) Synthesis of R1-Ph-TDP-ADBAC

The same operations as in Production Example 13 were performed except that 18.5 g of the compound (Ph-TDP-ADBAC) was used in place of 8.1 g (21 mmol) of the compound (BHPT), to obtain 12.0 g of the objective resin (R1-Ph-TDP-ADBAC) having a structure represented by the following formula.

As a result of measuring the molecular weight in terms of polystyrene of the obtained resin (R1-Ph-TDP-ADBAC) by the above method, it was Mn: 1152, Mw: 2570, Mw/Mn: 2.23.

The following peaks were found by NMR measurement performed on the obtained resin (R1-Ph-TDP-ADBAC) under the above measurement conditions, and the resin was confirmed to have a chemical structure of the following formula (R1-Ph-TDP-ADBAC).
δ (ppm) 7.1 - 7.7 (16H, Ph-H), 5.0 (4H, O-CH₂-C (=O)-), 1.0 - 2.6 (34H, C-H/Adamantane of methylene and methine), 4.1 (2H, -CH2)

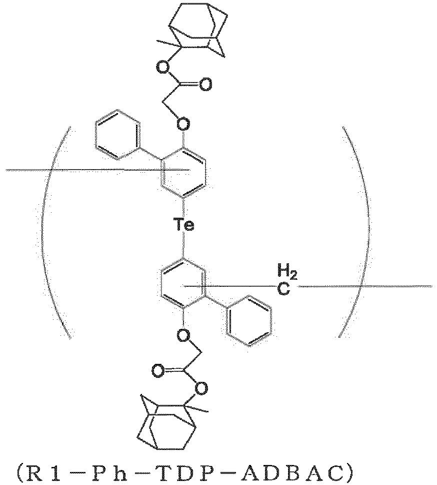

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 32) Synthesis of R2-Ph-TDP-ADBAC

The same operations as in Production Example 31 were performed except that 7.6 g (42 mmol) of 4-biphenylcarboxyaldehyde (manufactured by Mitsubishi Gas Chemical Company Inc.) was used in place of 0.7 g (42 mmol) of paraformaldehyde, to obtain 5.6 g of the objective resin (R2-Ph-TDP-ADBAC) having a structure represented by the following formula.

As a result of measuring the molecular weight in terms of polystyrene of the obtained resin (R2-Ph-TDP-ADBAC) by the above method, it was Mn: 1100, Mw: 2205, Mw/Mn: 2.004.

The following peaks were found by NMR measurement performed on the obtained resin (R2-Ph-TDP-ADBAC) under the above measurement conditions, and the resin was confirmed to have a chemical structure of the following formula (R2-Ph-TDP-ADBAC).
δ (ppm) 7.1 - 7.7 (25H, Ph-H), 5.0 (4H, O-CH₂-C (=O)-), 1.0 - 2.6 (34H, C-H/Adamantane of methylene and methine), 4.5 (1H, -CH)

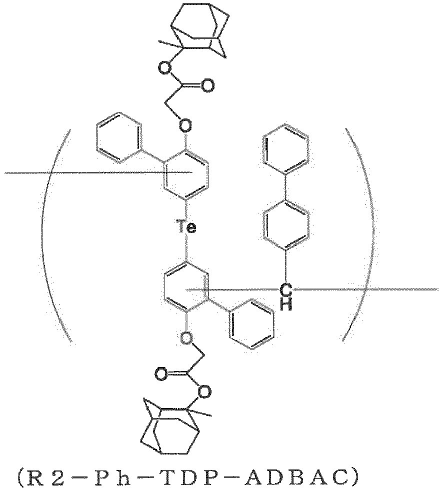

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 33) Synthesis of resin (BHPT-co-ADTBA)

In a 100 mL container, 0.58 g (1.5 mmol) of the compound (BHPT) was placed, 0.05 g (0.15 mmol) of tetrabutyl ammonium bromide, 0.28 g (2 mmol) of potassium carbonate, and 2 ml of N-methylpyrrolidone were added, and the mixture was stirred at 80°C for 2 hours. Next, 0.547 g (1.0 mmol) of ADTBA (1,3,5-adamantane tribromoacetate) was dissolved in 1 ml of N-methylpyrrolidone, and the solution was reacted at 80°C for 48 hours. The obtained reaction product was dropped to 1 N HCl to obtain brown crystals. The crystals were filtered and then dried under reduced pressure to obtain 0.40 g of the objective resin (BHPT-co-ADTBA).

As a result of measuring the molecular weight in terms of polystyrene of the obtained resin (BHPT-co-ADTBA) by the above method, it was Mn: 750, Mw: 1350, Mw/Mn: 1.80.

The following peaks were found by NMR measurement performed on the obtained resin (BHPT-co-ADTBA) under the above measurement conditions, and the resin was confirmed to have a chemical structure of the following formula (BHPT-co-ADTBA).
δ (ppm) 6.9 - 7.4 (4H, Ph-H), 4.6 (4H, -O-CH₂-CO-), 4.3 (2H, -CH₂-Br), 1.2 - 3.4 (13H, C-H/Adamantane of methylene and methine) 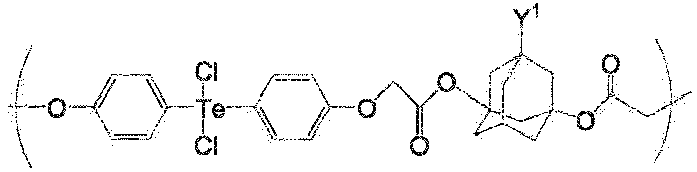 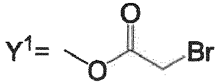 Compound (BHPT-co-ADTBA)

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 34) Synthesis of Resin (TDP-co-ADTBA)

The same operations as in Production Example 33 were performed except that 0.47 g of the compound (TDP) was used in place of 0.58 g (1.5 mmol) of the compound (BHPT), to obtain 0.36 g of the objective resin (TDP-co-ADTBA) having a structure represented by the following formula.

As a result of measuring the molecular weight in terms of polystyrene of the obtained resin (TDP-co-ADTBA) by the above method, it was Mn: 680, Mw: 1238, Mw/Mn: 1.82.

The following peaks were found by NMR measurement performed on the obtained resin (TDP-co-ADTBA) under the above measurement conditions, and the resin was confirmed to have a chemical structure of the following formula (TDP-co-ADTBA).
δ (ppm) 6.9 - 7.4 (4H, Ph-H), 4.6 (4H, -O-CH₂-CO-), 4.3 (2H, -CH₂-Br), 1.2 - 3.4 (13H, C-H/Adamantane of methylene and methine) 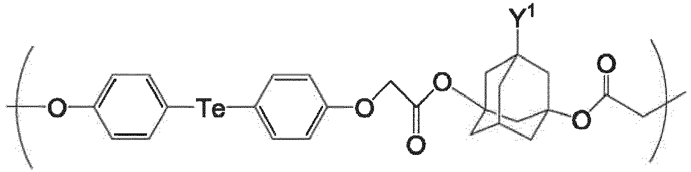 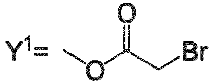 Compound (TDP-co-ADTBA)

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 35) Synthesis of Resin (DMB-co-TeCl2-OH)

In a glove box, to a 100 ml container, 5.39 g (20 mmol) of tellurium tetrachloride was fed, 2.8 g (20 mmol) of 1,3-dimethoxybenzene, 5.9 g (44 mmol) of aluminum trichloride, and 20 ml of chloroform were added, and the mixture was reacted for 24 hours under ice cooling. The obtained product was dried under reduced pressure, and recrystallization was carried out twice using acetonitrile, followed by filtration. The obtained crystals were dried under reduced pressure for 24 hours to obtain 3.0 g of a resin (DMB-co-TeCl2).

As a result of measuring the molecular weight in terms of polystyrene of the obtained resin (DBM-co-TeCl2) by the above method, it was Mn: 39820, Mw: 62910, Mw/Mn: 1.58.

The following peaks were found by NMR measurement performed on the obtained resin (DMB-co-TeCl2) under the above measurement conditions, and the resin was confirmed to have a chemical structure of the following formula (DMB-co-TeCl2) .
δ (ppm) 6.0 - 7.2 (2H, Ph-H), 3.6 (6H, -CH₃)

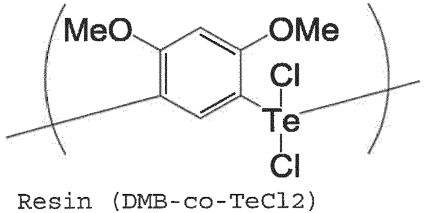

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

Then, to a container (internal capacity: 100 mL) equipped with a stirrer, a condenser tube, and a burette, 0.78 g of the resin (DMB-co-TeCl2) and 15 ml of chloroform were added, 3.9 g (15.75 mmol) of boron tribromide was dropped, and the mixture was reacted at - 20°C for 48 hours. The solution after reaction was dropped to a 1.0 N hydrochloric acid solution in an ice bath, and a black solid was recovered after filtration. The solid was dissolved in ethyl acetate, the solution was dehydrated by the addition of magnesium sulfate and then concentrated, and the residue was separated and purified by column chromatography to obtain 0.4 g of a resin (DMB-co-TeCl2-OH).

As a result of measuring the molecular weight in terms of polystyrene of the obtained resin (DMB-co-TeCl2-OH) by the above method, it was Mn: 39800, Mw: 62880, Mw/Mn: 1.58.

The following peaks were found by NMR measurement performed on the obtained resin (DMB-co-TeCl2-OH) under the above measurement conditions, and the resin was confirmed to have a chemical structure of the resin (DMB-co-TeCl2-OH) shown below.
δ (ppm) 9.0 (2H, -OH), 6.4 - 7.0 (2H, Ph-H)

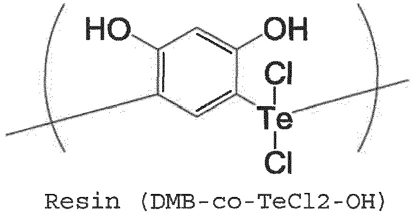

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 36) Synthesis of Resin (Re-co-Te)

In a glove box, to a 100 mL container, tellurium tetrachloride (7.54 g, 28 mmol) was fed, 1.54 g (14 mmol) of resorcinol and 20 ml of carbon tetrachloride were added, and the mixture was reacted at 80°C for 24 hours under reflux conditions. The obtained reaction solution was washed by the addition of dichloromethane and filtered, and the obtained solid was dried under reduced pressure.

Then, in a 300 ml container, 13.0 g (66 mmol) of sodium ascorbate was dissolved in 25 ml of water, the above solid dissolved in 60 ml of ethyl acetate was dropped to the solution, and the mixture was reacted at 25°C for 24 hours. The solution after reaction was subjected to extraction with ethyl acetate 15 times, and the organic solvent was then distilled off to obtain a brown solid.

Further, in a container (internal capacity: 100 mL) equipped with a stirrer, a condenser tube, and a burette, the obtained brown solid was placed, 10 ml of ethyl acetate and 13.0 g (60 mmol) of copper powder were added, and the mixture was reacted at 80°C for 24 hours under reflux conditions. The obtained reaction solution was concentrated 2-fold, the residue was dropped to chloroform, and the obtained precipitates were filtered and dried to obtain 0.2 g of a black-brown resin (Re-co-Te).

As a result of measuring the molecular weight in terms of polystyrene of the obtained resin (Re-co-Te) by the above method, it was Mn: 21500, Mw: 41500, Mw/Mn: 1.93.

The following peaks were found by NMR measurement performed on the obtained resin (Re-co-Te) under the above measurement conditions, and the resin was confirmed to have a chemical structure of the resin (Re-co-Te) shown below.
δ (ppm) 9.1 (2H, -OH), 6.1 - 7.0 (2H, Ph-H)

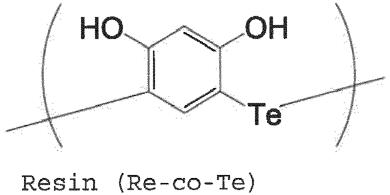

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 37) Synthesis of Resin (DMB-co-TeCl2-ADBAC)

In a container (internal capacity: 200 mL) equipped with a stirrer, a condenser tube, and a burette, 3.7 g of the resin (DMB-co-TeCl2-OH), 0.30 g (22 mmol) of potassium carbonate, and 6.3 g (22 mmol) of bromoacetic acid-2-methyladamantan-2-yl were dissolved in 50 ml of N-methylpyrrolidone, and the solution was stirred for 2 hours. After stirring, 5.7 g (22 mmol) of adamantane bromoacetate was further added thereto, and the mixture was reacted at 100°C for 24 hours. After the reaction terminated, the reaction mixture was dropped to a 1 N aqueous hydrochloric acid solution, and the resulting black solid was filtered off and dried to obtain 5.3 g of the following resin (DMB-co-TeCl2-ADBAC).

The following peaks were found by NMR measurement performed on the obtained resin (DMB-co-TeCl2-ADBAC) under the above measurement conditions, and the resin was confirmed to have a chemical structure of the resin (DMB-co-TeCl2-ADBAC) shown below.
δ (ppm) 6.5 - 7.2 (2H, Ph-H), 4.9 - 5.0 (4H, -CH2-), 1.0 - 2.6 (34H, C-H/Adamantane of methylene and methine)

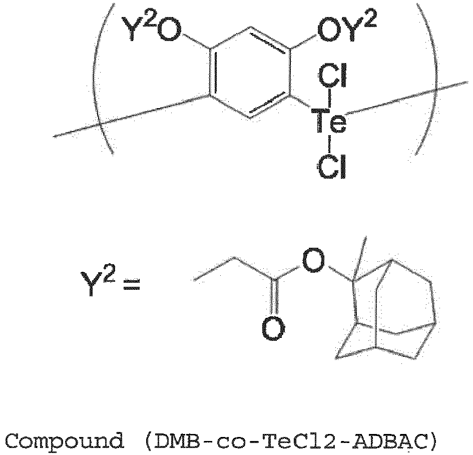

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 38) Synthesis of Resin (Re-co-Te-ADBAC)

In a container (internal capacity: 200 mL) equipped with a stirrer, a condenser tube, and a burette, 2.7 g of the resin (Re-co-Te), 0.30 g (22 mmol) of potassium carbonate, and 0.64 g (2 mmol) of tetrabutyl ammonium bromide were dissolved in 50 ml of N-methylpyrrolidone, and the solution was stirred for 2 hours. After stirring, 6.3 g (22 mmol) of bromoacetic acid-2-methyladamantan-2-yl was further added thereto, and the mixture was reacted at 100°C for 24 hours. After the reaction terminated, the reaction mixture was dropped to a 1 N aqueous hydrochloric acid solution, and the resulting black solid was filtered off and dried to obtain 4.6 g of the following resin (Re-co-Te-ADBAC).

The following peaks were found by NMR measurement performed on the obtained resin (Re-co-Te-ADBAC) under the above measurement conditions, and the resin was confirmed to have a chemical structure of the resin (Re-co-Te-ADBAC) shown below.
δ (ppm) 6.5 - 7.2 (2H, Ph-H), 4.9 - 5.0 (4H, -CH₂-), 1.0 - 2.6 (34H, C-H/Adamantane of methylene and methine)

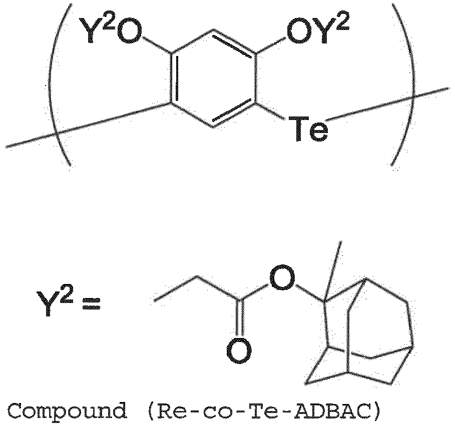

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 39) Synthesis of Resin (DPE-co-Te)

In a glove box, to a 300 ml container, tellurium tetrachloride (75 g, 280 mmol) was fed, 100 ml of carbon tetrachloride and 15 g (140 mmol) of diphenyl ether were added, and the mixture was reacted at 80°C for 24 hours under reflux conditions. The obtained reaction solution was washed by the addition of dichloromethane and filtered, and the obtained solid was dried under reduced pressure.

Then, in a 1000 ml container, 130 g (66 mmol) of sodium ascorbate was dissolved in 250 ml of water, the above solid dissolved in 120 ml of ethyl acetate was dropped to the solution, and the mixture was reacted at 25°C for 24 hours. The solution after reaction was subjected to extraction with ethyl acetate 5 times, and the organic solvent was then distilled off to obtain a brown solid.

Further, in a container (internal capacity: 100 mL) equipped with a stirrer, a condenser tube, and a burette, the obtained brown solid was placed, 20 ml of ethyl acetate and 38.0 g (600 mmol) of copper powder were added, and the mixture was reacted at 80°C for 24 hours under reflux conditions. The obtained reaction solution was concentrated 2-fold, the residue was dropped to hexane, and the obtained precipitates were filtered and dried to obtain 0.11 g of a red resin (DPE-co-Te).

As a result of measuring the molecular weight in terms of polystyrene of the obtained resin (DPE-co-Te) by the above method, it was Mn: 1280, Mw: 2406, Mw/Mn: 1.88.

The following peaks were found by NMR measurement performed on the obtained resin (DPE-co-Te) under the above measurement conditions, and the resin was confirmed to have a chemical structure of the resin (DPE-co-Te) shown below.
δ (ppm) 6.9 - 8.8 (8H, Ph-H)

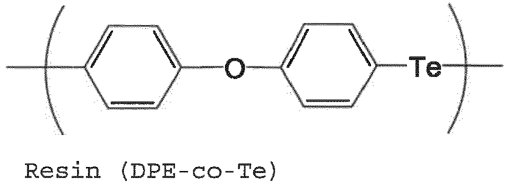

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 40) Synthesis of Tellurium-Containing Core-Shell Type Hyperbranched Polymer

To a 200 mL container, 3.2 g (25 mmol) of tellurium and 25 ml of THF were added and stirred for suspension, 30 ml of a methyllithium solution (1 mol/l, diethyl ether solution) was dropped under ice cooling, and the mixture was stirred at 0°C for 1 hour. 6.1 g (40 mmol) of chloromethylstyrene was further added thereto, and the mixture was further reacted by being stirred at 25°C for 2 hours. Next, the solvent in the reaction solution was distilled off, and the residue was dried under reduced pressure to obtain 2.0 g of methyltellanylstyrene.

To a 200 mL container, 3.2 g (25 mmol) of tellurium and 25 ml of THF were added and stirred for suspension, 30 ml of a methyllithium solution (1 mol/l, diethyl ether solution) was dropped under ice cooling, and the mixture was stirred at 0°C for 1 hour. Next, 20 ml of a 0.5 mol/l aqueous ammonium chloride solution was added thereto, and the mixture was reacted by being stirred at 25°C for 2 hours. After reaction, the aqueous layer was separated and subjected to extraction with diethyl ether three times. The solvent in the extracted organic layer was distilled off, and the residue was dried under reduced pressure to obtain 2.2 g of dimethyl ditelluride.

Further, to a container (internal capacity: 500 mL) equipped with a stirrer, a condenser tube, and a burette, 80 g of chlorobenzene, 2.6 g (10 mmol) of the above methyltellanylstyrene, 0.7 g (2.5 mmol) of the dimethyl ditelluride, and 0.4 g (2.5 mmol) of azobisisobutyronitrile were added, and the mixture was stirred at 110°C for 1 hour in the current of nitrogen. After stirring, 90 g of benzene, 0.4 g of acrylic acid, and 4.35 g of t-butyl acrylate were added thereto, and the mixture was further reacted by being stirred at 110°C for 5 hours. After the reaction terminated, 1500 ml of water was added to the reaction solution, and the mixture was filtered and dried to obtain 2.0 g of a tellurium-containing core-shell type hyperbranched polymer (referred to as "Te-containing hyperbranched polymer" in Table 2).

As a result of measuring the molecular weight in terms of polystyrene of the obtained tellurium-containing core-shell type hyperbranched polymer by the above method, it was Mn: 3260, Mw: 5800, Mw/Mn: 1.78.

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 41) Synthesis of compound (CCHT)

In a glove box, to a 50 mL container, tellurium tetrachloride (0.27 g, 1.0 mmol) and resorcinol (0.15 g, 1.36 mmol) were fed, 5 mL of carbon tetrachloride was added as a solvent, and the mixture was reacted for 6 hours under reflux conditions. The obtained product was filtered, washed twice with dichloromethane, and dried under reduced pressure to obtain a pale yellow solid. This solid was placed in a 50 mL container, resorcinol (1.10 g, 10 mmol) was added, and then, the mixture was reacted at 170°C for 24 hours. The obtained reaction solution was dissolved in ethyl acetate, and precipitates were formed again with n-hexane to obtain CCHT ((2,4-dihydroxyphenyl)(4-hydroxyphenyl)tellurium dichloride).

As a result of measuring the molecular weight of the obtained compound (CCHT) by the above measurement method (LC-MS), it was 401.

The following peaks were found by NMR measurement performed on the obtained compound (CCHT) under the above measurement conditions, and the compound was confirmed to have a chemical structure of the compound (CCHT) shown below.
δ (ppm) 9.5-9.9 (3H, -OH), 6.3-7.2 (7H, Ph-H)

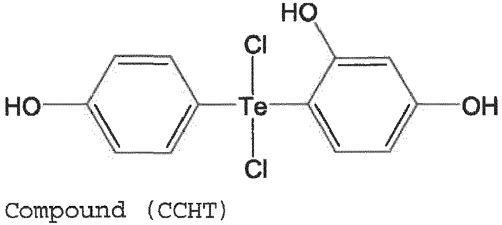

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### (Production Example 42) Synthesis of compound (CCHT-ADBAC)

The same operations as in Production Example 2 were performed except that 2.7 g (6.7 mmol) of the compound (CCHT) was used in place of 3.9 g (10 mmol) of the compound (BHPT), to obtain 1.09 g of a compound (CCHT-ADBAC) having a structure shown below.

As a result of measuring the molecular weight of the obtained compound (Ph-BHPT-ADBAC) by the above measurement method (LC-MS), it was 537.

The following peaks were found by NMR measurement performed on the obtained compound (CCHT-ADBAC) under the above measurement conditions, and the compound was confirmed to have a chemical structure of the compound (CCHT-ADBAC) shown below.
δ (ppm) 6.5-7.0 (7H, Ph-H), 5.0 (6H, O-CH2-C(=O)-), 1.0-2.6 (51H, C-H/Adamantane of methylene and methine)

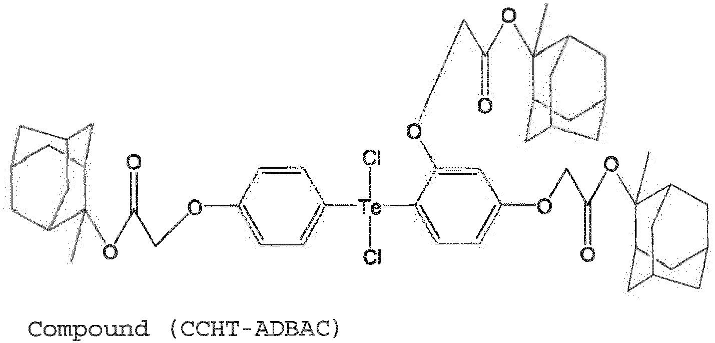

As a result of evaluating the obtained compound for its solubility in PGMEA by the above measurement method, it was 5% by mass or more (evaluation A). Thus, the compound was evaluated as having excellent solubility. Therefore, the compound was evaluated as having high storage stability in a solution state and being also sufficiently applicable to an edge bead remover, which is widely used in semiconductor fine processing processes.

### [Comparative Production Example 1]

A 4-neck flask (internal capacity: 10 L) equipped with a Dimroth condenser tube, a thermometer, and a stirring blade and having a detachable bottom was prepared. To this 4-neck flask, 1.09 kg (7 mol) of 1,5-dimethylnaphthalene (manufactured by Mitsubishi Gas Chemical Co., Inc.), 2.1 kg (28 mol as formaldehyde) of 40% by mass of an aqueous formalin solution (manufactured by Mitsubishi Gas Chemical Co., Inc.), and 0.97 mL of 98% by mass of sulfuric acid (manufactured by Kanto Chemical Co., Inc.) were fed in the current of nitrogen, and the mixture was reacted for 7 hours while being refluxed at 100°C at normal pressure. Subsequently, 1.8 kg of ethylbenzene (a special grade reagent, manufactured by Wako Pure Chemical Industries, Ltd.) was added as a diluting solvent to the reaction solution, and the mixture was left to stand still, followed by removal of an aqueous phase as a lower phase. Neutralization and washing with water were further performed, and ethylbenzene and unreacted 1,5-dimethylnaphthalene were distilled off under reduced pressure to obtain 1.25 kg of a dimethylnaphthalene formaldehyde resin as a light brown solid.

The molecular weight of the obtained dimethylnaphthalene formaldehyde was Mn: 562, Mw: 1168, Mw/Mn: 2.08.

Then, a 4-neck flask (internal capacity: 0.5 L) equipped with a Dimroth condenser tube, a thermometer, and a stirring blade was prepared. To this 4-neck flask, 100 g (0.51 mol) of the dimethylnaphthalene formaldehyde resin obtained as described above and 0.05 g of p-toluenesulfonic acid were fed in the current of nitrogen, the temperature was elevated to 190°C, and the mixture was heated for 2 hours and then stirred. Subsequently, 52.0 g (0.36 mol) of 1-naphthol was further added thereto, the temperature was further elevated to 220°C, and the mixture was reacted for 2 hours. After dilution with a solvent, neutralization and washing with water were performed, and the solvent was distilled off under reduced pressure to obtain 126.1 g of a modified resin (CR-1) as a black-brown solid.

For the obtained resin (CR-1), Mn: 885, Mw: 2220, Mw/Mn: 4.17. As a result of evaluating the obtained resin (CR-1) for its solubility in PGMEA by the above measurement method, it was evaluated as 5% by mass or more (evaluation A).

### [Examples 1 to 48 and Comparative Example 1]

Compositions for resist underlayer film formation were prepared according to the composition shown in Table 1 or 2. The following materials were used in these compositions.
Acid generating agent: "di-tertiary butyl diphenyliodonium nonafluoromethanesulfonate (DTDPI)" manufactured by Midori Kagaku Co., Ltd.
Acid crosslinking agent: "NIKALAC MX270 (NIKALAC)" manufactured by Sanwa Chemical.
Organic solvent: propylene glycol monomethyl ether acetate (PGMEA)
Novolac: "PSM4357" manufactured by Gunei Chemical Industry Co., Ltd.

Next, a silicon substrate was spin coated with each of the compositions for resist underlayer film formation of Examples 1 to 48 and Comparative Example 1, then baked at 240°C for 60 seconds (Examples 1 to 42 and Comparative Example 1) or baked at 300°C for 60 seconds (Examples 43 to 48) to respectively make underlayer films having a film thickness of 200 nm.

Then, etching test was conducted under conditions shown below to evaluate etching resistance. The evaluation results are shown in Table 1 or 2.

### [Etching Test]

Etching apparatus: "RIE-10NR" manufactured by Samco International, Inc.
Output: 50 W
Pressure: 20 Pa
Time: 2 min
Etching gas
Ar gas flow rate:CF₄ gas flow rate:O₂ gas flow rate = 50:5:5 (seem)

### [Evaluation of Etching Resistance]

The etching resistance was evaluated by the following procedures.

First, an underlayer film of novolac was made under the same conditions as in Example 1 except that novolac ("PSM4357" manufactured by Gunei Chemical Industry Co., Ltd.) was used in place of the compound used in Example 1. Then, this underlayer film of novolac was subjected to the above etching test, and the etching rate was measured.

Next, the underlayer films of Examples 1 to 48 and Comparative Example 1 were subjected to the above etching test in the same way as above, and the etching rate was measured.

Then, the etching resistance was evaluated according to the following evaluation criteria on the basis of the etching rate of the underlayer film of novolac.

### [Evaluation Criteria]

A: The etching rate was less than -10% as compared with the underlayer film of novolac.
B: The etching rate was -10% to +5% as compared with the underlayer film of novolac.
C: The etching rate was more than +5% as compared with the underlayer film of novolac.

**[Table 1]**

| | Composition for underlayer film formation (parts by mass) | Organic solvent (parts by mass) | Acid generating agent (parts by mass) | Crosslinking agent (parts by mass) | Evaluation of etching resistance |
|---|---|---|---|---|---|
| Example 1 | BHPT (10) | PGMEA (90) | DTDPI (0.5) | NIKALAC (0.5) | A |
| Example 2 | BHPT-ADBAC (10) | PGMEA (90) | DTDPI (0.5) | NIKALAC (0.5) | A |
| Example 3 | BHPT-BOC (10) | PGMEA (90) | DTDPI (0.5) | NIKALAC (0.5) | A |
| Example 4 | BHPT-EE (10) | PGMEA (90) | DTDPI (0.5) | NIKALAC (0.5) | A |
| Example 5 | Ph-BHPT (10) | PGMEA (90) | DTDPI (0.5) | NIKALAC (0.5) | A |
| Example 6 | TDP (10) | PGMEA (90) | DTDPI (0.5) | NIKALAC (0.5) | A |
| Example 7 | Ph-TDP (10) | PGMEA (90) | DTDPI (0.5) | NIKALAC (0.5) | A |
| Example 8 | Ph-BHPT-ADBAC (10) | PGMEA (90) | DTDPI (0.5) | NIKALAC (0.5) | A |
| Example 9 | TDP-ADBAC (10) | PGMEA (90) | DTDPI (0.5) | NIKALAC (0.5) | A |
| Example 10 | Ph-TDP-ADBAC (10) | PGMEA (90) | DTDPI (0.5) | NIKALAC (0.5) | A |
| Example 11 | Ph-TDP-BOC (10) | PGMEA (90) | DTDPI (0.5) | NIKALAC (0.5) | A |
| Example 12 | Ph-TDP-EE (10) | PGMEA (90) | DTDPI (0.5) | NIKALAC (0.5) | A |
| Example 13 | R1-BHPT (10) | PGMEA (90) | DTDPI (0.5) | NIKALAC (0.5) | A |
| Example 14 | R2-BHPT (10) | PGMEA (90) | DTDPI (0.5) | NIKALAC (0.5) | A |
| Example 15 | R1-BHPT-ADBAC (10) | PGMEA (90) | DTDPI (0.5) | NIKALAC (0.5) | A |
| Example 16 | R2-BHPT-ADBAC (10) | PGMEA (90) | DTDPI (0.5) | NIKALAC (0.5) | A |
| Example 17 | R1-BHPT-BOC (10) | PGMEA (90) | DTDPI (0.5) | NIKALAC (0.5) | A |
| Example 18 | R2-BHPT-BOC (10) | PGMEA (90) | DTDPI (0.5) | NIKALAC (0.5) | A |
| Example 19 | R1-BHPT-EE (10) | PGMEA (90) | DTDPI (0.5) | NIKALAC (0.5) | A |
| Example 20 | R2-BHPT-EE (10) | PGMEA (90) | DTDPI (0.5) | NIKALAC (0.5) | A |
| Example 21 | R1-Ph-BHPT (10) | PGMEA (90) | DTDPI (0.5) | NIKALAC (0.5) | A |
| Example 22 | R2-Ph-BHPT (10) | PGMEA (90) | DTDPI (0.5) | NIKALAC (0.5) | A |

**[Table 2]**

| | Composition for underlayer film formation (parts by mass) | Organic Solvent (parts by mass) | Acid generating agent (parts by mass) | Crosslinking agent (parts by mass) | Evaluation of etching resistance |
|---|---|---|---|---|---|
| Example 23 | R1-TDP (10) | PGMEA (90) | DTDPI (0.5) | NIKALAC (0.5) | A |
| Example 24 | R2-TDP (10) | PGMEA (90) | DTDPI (0.5) | NIKALAC (0.5) | A |
| Example 25 | R1-Ph-TDP (10) | PGMEA (90) | DTDPI (0.5) | NIKALAC (0.5) | A |
| Example 26 | R2-Ph-TDP (10) | PGMEA (90) | DTDPI (0.5) | NIKALAC (0.5) | A |
| Example 27 | R1-Ph-BHPT-ADBAC (10) | PGMEA (90) | DTDPI (0.5) | NIKALAC (0.5) | A |
| Example 28 | R2-Ph-BHPT-ADBAC (10) | PGMEA (90) | DTDPI (0.5) | NIKALAC (0.5) | A |
| Example 29 | R1-TDP-ADBAC (10) | PGMEA (90) | DTDPI (0.5) | NIKALAC (0.5) | A |
| Example 30 | R2-TDP-ADBAC (10) | PGMEA (90) | DTDPI (0.5) | NIKALAC (0.5) | A |
| Example 31 | R1-Ph-TDP-ADBAC (10) | PGMEA (90) | DTDPI (0.5) | NIKALAC (0.5) | A |
| Example 32 | R2-Ph-TDP-ADBAC (10) | PGMEA (90) | DTDPI (0.5) | NIKALAC (0.5) | A |
| Example 33 | BHPT-cc-ADTBA (10) | PGMEA (90) | DTDPI (0.5) | NIKALAC (0.5) | A |
| Example 34 | TDP-co-ADTBA (10) | PGMEA (90) | DTDPI (0.5) | NIKALAC (0.5) | A |
| Example 35 | DMB-co-TeCl2-OH (10) | PGMEA (90) | DTDPI (0.5) | NIKALAC (0.5) | A |
| Example 36 | Re-co-Te (10) | PGMEA (90) | DTDPI (0.5) | NIKALAC (0.5) | A |
| Example 37 | DMB-co-TeCl2-ADBAC (10) | PGMEA (90) | DTDPI (0.5) | NIKALAC (0.5) | A |
| Example 38 | Re-co-Te-ADBAC (10) | PGMEA (90) | DTDPI (0.5) | NIKALAC (0.5) | A |
| Example 39 | DPE-co-Te (10) | PGMEA (90) | DTDPI (0.5) | NIKALAC (0.5) | A |
| Example 40 | Te-containing hyperbranched polymer (10) | PGMEA (90) | DTDPI (0.5) | NIKALAC (0.5) | A |
| Example 41 | CCHT (10) | PGMEA (90) | DTDPI (0.5) | NIKALAC (0.5) | A |
| Example 42 | CCHT-ADBAC (10) | PGMEA (90) | DTDPI (0.5) | NIKALAC (0.5) | A |
| Example 43 | BHPT (10) | PGMEA (90) | None | None | A |
| Example 44 | BHPT-ADBAC (10) | PGMEA (90) | None | None | A |
| Example 45 | TDP (10) | PGMEA (90) | None | None | A |
| Example 46 | R1-BHPT (10) | PGMEA (90) | None | None | A |
| Example 47 | R1-BHPT-ADBAC (10) | PGMEA (90) | None | None | A |
| Example 48 | Re-co-Te (10) | PGMEA (90) | None | None | A |
| Comparative Example 1 | CR-1 (10) | PGMEA (90) | DTDPI (0.5) | NIKALAC (0.5) | C |

### [Example 49]

Next, a SiO₂ substrate having a film thickness of 300 nm was coated with the composition for resist underlayer film formation of Example 1, and baked at 240°C for 60 seconds and further at 400°C for 120 seconds to form a resist underlayer film having a film thickness of 85 nm. This underlayer film was coated with a resist solution for ArF and baked at 130°C for 60 seconds to form a photoresist layer having a film thickness of 140 nm.

The ArF resist solution used was prepared by containing 1 part by mass of a compound represented by the following formula (CR-1A), 1 part by mass of triphenylsulfonium nonafluoromethanesulfonate, 2 parts by mass of tributylamine, and 30 parts by mass of propylene glycol monomethyl ether.

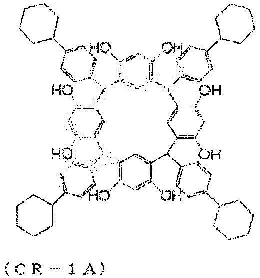

The compound represented by the formula (CR-1A) was synthesized as described below.

To a temperature-controllable autoclave (made of SUS316L) (internal capacity: 500 mL) equipped with an electromagnetic stirring device, 74.3 g (3.71 mol) of anhydrous HF and 50.5 g (0.744 mol) of BF₃ were fed, and the content was stirred and increased in pressure with carbon monoxide to 2 MPa while maintaining the liquid temperature to -30°C. Then, while maintaining the pressure at 2 MPa and the liquid temperature at -30°C, a raw material obtained by mixing 57.0 g (0.248 mol) of 4-cyclohexylbenzene and 50.0 g of n-heptane was supplied thereto and kept for 1 hour. Then, the content was collected into ice, diluted with benzene, and then neutralized, and the obtained oil layer was analyzed by gas chromatography. As a result of determining reaction performance, the 4-cyclohexylbenzene conversion was 100%, and the 4-cyclohexylbenzaldehyde selectivity was 97.3%.

The target component was isolated by simple distillation and analyzed by GC-MS, and consequently exhibited the molecular weight 188 of the target 4-cyclohexylbenzaldehyde (hereinafter, referred to as "CHBAL"). Specifically, the molecular weight was measured using GC-MS QP2010 Ultra manufactured by Shimadzu Corp. The chemical shift value (δ ppm, TMS standard) of ¹H-NMR in a deuterated chloroform solvent was 1.0 to 1.6 (m, 10H), 2.6 (m, 1H), 7.4 (d, 2H), 7.8 (d, 2H), and 10.0 (s, 1H).

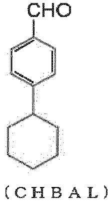

To a sufficiently dried and nitrogen purged 4-neck flask (1000 mL) equipped with a dropping funnel, a Dimroth condenser tube, a thermometer, and a stirring blade, resorcinol (22 g, 0.2 mol) manufactured by Kanto Chemical Co., Inc., the above 4-cyclohexylbenzaldehyde (46.0 g, 0.2 mol), and dehydrated ethanol (200 mL) were added in the current of nitrogen to prepare an ethanol solution. This solution was heated to 85°C using a mantle heater while being stirred. Subsequently, 75 mL of concentrated hydrochloric acid (35%) was dropped through the dropping funnel over 30 minutes, and continuously stirred at 85°C for 3 hours. After the reaction terminated, the reaction mixture was allowed to cool. After the temperature reached room temperature, the reaction mixture was cooled in an ice bath. The resultant was left to stand still for 1 hour to produce target pale yellow crude crystals, which were then filtered off. The crude crystals were washed twice with 500 mL of methanol, filtered off, and dried in vacuum to obtain 50 g of a compound represented by the formula (CR-1A) as a product.

As a result of LC-MS analysis, the structure of the product exhibited a molecular weight of 1121. The chemical shift value (δ ppm, TMS standard) of ¹H-NMR in a deuterated chloroform solvent was 0.8 to 1.9 (m, 44H), 5.5 to 5.6 (d, 4H), 6.0 to 6.8 (m, 24H), 8.4 and 8.5 (m, 8H). From these results, the obtained product was identified as the target compound (CR-1A) (yield: 91%).

Subsequently, the photoresist layer was exposed using an electron beam lithography system (manufactured by ELIONIX INC.; ELS-7500, 50 keV), baked (PEB) at 115°C for 90 seconds, and developed for 60 seconds in 2.38% by mass tetramethyl ammonium hydroxide (TMAH) aqueous solution to obtain a positive type resist pattern.

### [Comparative Example 2]

A photoresist layer was formed directly on a SiO₂ substrate in the same way as in Example 49 except that resist underlayer film formation was not performed, to obtain a positive type resist pattern.

### [Evaluation]

For each of Example 49 and Comparative Example 2, the shapes of the obtained 45 nm L/S (1:1) and 80 nm L/S (1:1) resist patterns were observed under an electron microscope manufactured by Hitachi, Ltd. (S-4800). The shapes of the resist patterns after development were evaluated as being good when having "good" rectangularity without pattern collapse, and as being "poor" when this was not the case. The smallest line width having good rectangularity without pattern collapse as a result of this observation was used as an index for resolution evaluation. The minimum amount of electron beam energy capable of lithographing good pattern shapes was used as an index for sensitivity evaluation. The results are shown in Table 3.

**[Table 3]**

| | Composition for underlayer film formation | Resolution (nmL/S) | Sensitivity (µC/cm²) | Resist pattern shape after development |
|---|---|---|---|---|
| Example 49 | As described in Example 1 | 45 | 10 | Good |
| Comparative Example 2 | None | 80 | 32 | Poor |

As is evident from Table 3, the resist underlayer film of Example 49 obtained using the composition for resist underlayer film formation of the present invention was confirmed to be significantly superior in both resolution and sensitivity to Comparative Example 2. Also, the resist pattern shape after development had good rectangularity without pattern collapse. Therefore, the pattern was confirmed to be excellent in heat resistance without dripping during heating. The difference in the resist pattern shape after development indicated that the composition for resist underlayer film formation of Example 49 is excellent in filling properties for uneven substrates and film smoothness and has good adhesiveness to a resist material.

### [Example 50]

A SiO₂ substrate having a film thickness of 300 nm was coated with the composition for resist underlayer film formation used in Example 1, and baked at 240°C for 60 seconds and further at 400°C for 120 seconds to form a resist underlayer film having a film thickness of 90 nm. This resist underlayer film was coated with a silicon-containing intermediate layer material and baked at 200°C for 60 seconds to form a resist intermediate layer film having a film thickness of 35 nm. This resist intermediate layer film was further coated with the above resist solution for ArF and baked at 130°C for 60 seconds to form a photoresist layer having a film thickness of 150 nm. The silicon-containing intermediate layer material used was the silicon atom-containing polymer described in <Production Example 1> of Japanese Patent Application Laid-Open No. 2007-226170.

Subsequently, the photoresist layer was mask exposed using an electron beam lithography system (manufactured by ELIONIX INC.; ELS-7500, 50 keV), baked (PEB) at 115°C for 90 seconds, and developed for 60 seconds in 2.38% by mass tetramethyl ammonium hydroxide (TMAH) aqueous solution to obtain a 45 nm L/S (1:1) positive type resist pattern.

Then, the silicon-containing intermediate layer film (SOG) was dry etched with the obtained resist pattern as a mask using RIE-10NR manufactured by Samco International, Inc. Subsequently, and dry etching of the resist underlayer film with the obtained silicon-containing intermediate layer film pattern as a mask and dry etching of the SiO₂ film with the obtained resist underlayer film pattern as a mask were performed in order.

The respective etching conditions are as shown below.

### (Conditions for etching of resist intermediate layer film with resist pattern)

Output: 50 W
Pressure: 20 Pa
Time: 1 min
Etching gas
Ar gas flow rate: CF₄ gas flow rate:O₂ gas flow rate = 50:8:2 (sccm)

### (Conditions for etching of resist underlayer film with resist intermediate film pattern)

Output: 50 W
Pressure: 20 Pa
Time: 2 min
Etching gas
Ar gas flow rate:CF₄ gas flow rate:O₂ gas flow rate = 50:5:5 (sccm)

### (Conditions for etching of SiO₂ film with resist underlayer film pattern)

Output: 50 W
Pressure: 20 Pa
Time: 2 min
Etching gas
Ar gas flow rate: C₅F₁₂ gas flow rate: C₂F₆ gas flow rate:O₂ gas flow rate = 50:4:3:1 (sccm)

### [Evaluation]

The pattern cross section (the shape of the SiO₂ film after etching) of Example 50 obtained as mentioned above was observed under an electron microscope manufactured by Hitachi, Ltd. (S-4800). As a result, the shape of the SiO₂ film after etching in a multilayer resist process was confirmed to be a rectangular shape and be good without defects.

### Industrial Applicability

The compound and the resin according to the present invention are excellent in filling properties for uneven substrates, have a relatively high carbon concentration, a relatively low oxygen concentration, and also relatively high solvent solubility, and are applicable to a wet process. Therefore, the composition for resist underlayer film formation and the resist underlayer film containing the compound or the resin according to the present invention can be used widely and effectively for various purposes that require such performance. Also, the present invention can be used particularly effectively in the fields of resist underlayer films for lithography, underlayer films for multilayer resists, and pattern formation methods.

The disclosure of Japanese Patent Application No. 2016-091797 filed on April 28, 2016 is incorporated herein by reference in its entirety.

All literatures, patent applications, and technical standards described herein are incorporated herein by referent to the same extent as if each individual literature, patent application, or technical standard is specifically and individually indicated to be incorporated by reference.

## Claims

1. A composition for resist underlayer film formation comprising a tellurium-containing compound or a tellurium-containing resin.

2. The composition for resist underlayer film formation according to claim 1, wherein the tellurium-containing compound is represented by the following formula (A-1) : 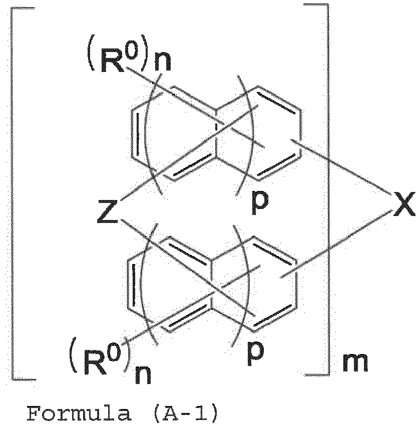 wherein X is a 2m-valent group of 0 to 60 carbon atoms containing tellurium; Z is an oxygen atom, a sulfur atom, or a non-crosslinked state; each R⁰ is independently a monovalent group containing an oxygen atom, a monovalent group containing a sulfur atom, a monovalent group containing a nitrogen atom, a hydrocarbon group, or a halogen atom; m is an integer of 1 to 4; each p is independently an integer of 0 to 2; and each n is independently an integer of 0 to (5 + 2 × p).

3. The composition for resist underlayer film formation according to claim 2, wherein the tellurium-containing compound is represented by the following formula (A-2): 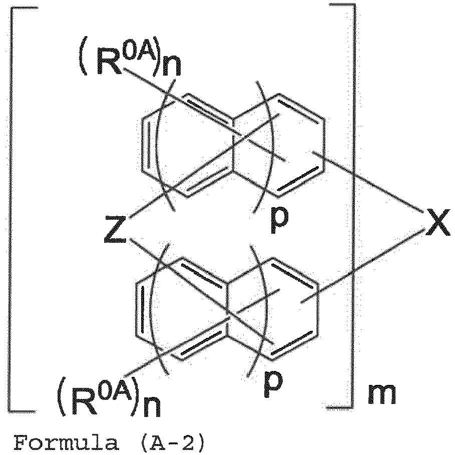 wherein X is a 2m-valent group of 0 to 60 carbon atoms containing tellurium; Z is an oxygen atom, a sulfur atom, a single bond, or a non-crosslinked state; each R^{0A} is independently selected from the group consisting of a hydrocarbon group, a halogen atom, a cyano group, a nitro group, an amino group, an alkyl group of 1 to 30 carbon atoms, an alkenyl group of 2 to 30 carbon atoms, an aryl group of 6 to 40 carbon atoms, a hydroxy group or a group in which a hydrogen atom of a hydroxy group is substituted with an acid crosslinking reactive group or an acid dissociation reactive group, and a combination thereof, wherein the alkyl group, the alkenyl group, and the aryl group each optionally have an ether bond, a ketone bond, or an ester bond; m is an integer of 1 to 4; each p is independently an integer of 0 to 2; and each n is independently an integer of 0 to (5 + 2 × p).

4. The composition for resist underlayer film formation according to claim 2, wherein the tellurium-containing compound is represented by the following formula (A-3): 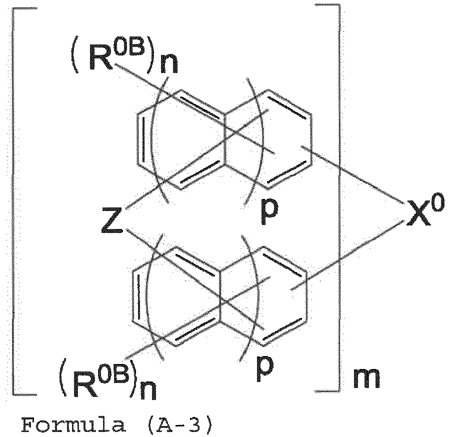 wherein X⁰ is a 2m-valent group of 0 to 30 carbon atoms containing tellurium; Z is an oxygen atom, a sulfur atom, or a non-crosslinked state; each R^{0B} is independently a monovalent group containing an oxygen atom, a monovalent group containing a sulfur atom, a monovalent group containing a nitrogen atom, a hydrocarbon group, or a halogen atom; m is an integer of 1 to 4; each p is independently an integer of 0 to 2; and each n is independently an integer of 0 to (5 + 2 × p).

5. The composition for resist underlayer film formation according to claim 2, wherein the tellurium-containing compound is represented by the following formula (1A) : 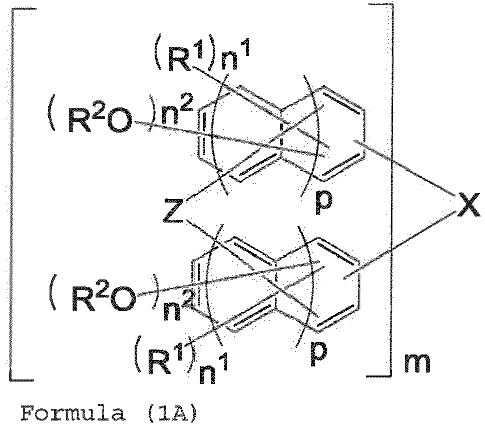 wherein X, Z, m, and p are as defined in the above formula (A-1) ; each R¹ is independently an alkyl group, an aryl group, an alkenyl group, or a halogen atom; each R² is independently a hydrogen atom or an acid dissociation reactive group; each n¹ is independently an integer of 0 to (5 + 2 × p) ; and each n² is independently an integer of 0 to (5 + 2 × p), provided that at least one n² is an integer of 1 to (5 + 2 × p).

6. The composition for resist underlayer film formation according to claim 4, wherein the tellurium-containing compound is represented by the following formula (1B) : 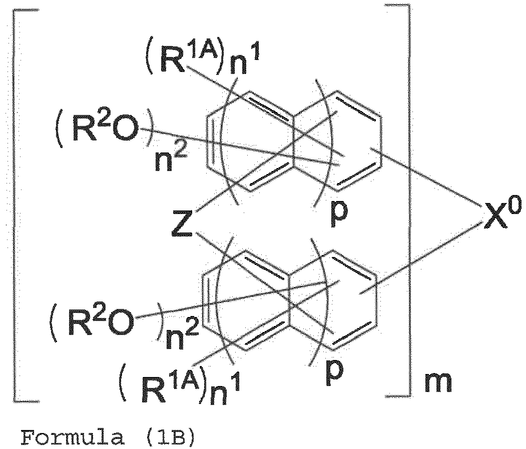 wherein X⁰, Z, m, and p are as defined in the above formula (A-3); each R^{1A} is independently an alkyl group, an aryl group, an alkenyl group, or a halogen atom; each R² is independently a hydrogen atom, an acid crosslinking reactive group, or an acid dissociation reactive group; each n¹ is independently an integer of 0 to (5 + 2 × p) ; and each n² is independently an integer of 0 to (5 + 2 × p), provided that at least one n² is an integer of 1 to (5 + 2 × p).

7. The composition for resist underlayer film formation according to claim 6, wherein the tellurium-containing compound is represented by the following formula (2A): 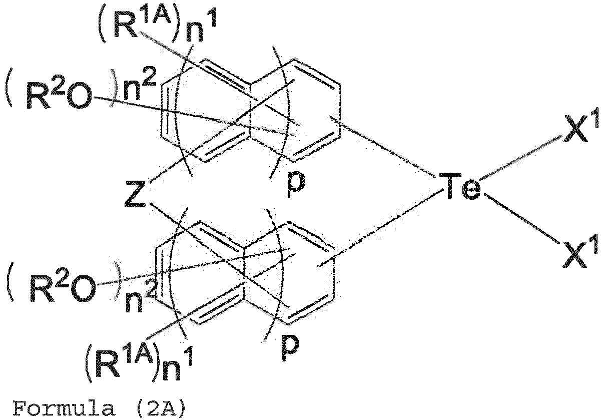 wherein Z, R^{1A}, R², p, n¹, and n² are as defined in the above formula (1B); and each X¹ is independently a monovalent group containing an oxygen atom, a monovalent group containing a sulfur atom, a monovalent group containing a nitrogen atom, a hydrocarbon group, a hydrogen atom, or a halogen atom.

8. The composition for resist underlayer film formation according to claim 7, wherein the tellurium-containing compound is represented by the following formula (2A'): 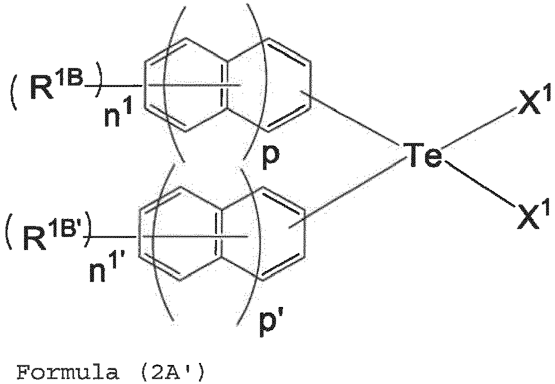 wherein R^{1B} and R^{1B'} are each independently an alkyl group, an aryl group, an alkenyl group, a halogen atom, a hydroxy group or a group in which a hydrogen atom of a hydroxy group is substituted with an acid crosslinking reactive group or an acid dissociation reactive group; X¹ is as defined as X¹ in the above formula (2A) ; n¹ and n^{1'} are as defined as n¹ in the above formula (2A) ; p and p' are as defined as p in the above formula (2A); and members in at least one combination selected from R^{1B} and R^{1B'}, n¹ and n^{1'}, p and p', and the substitution position of R^{1B} and the substitution position of R^{1B'} differ from each other.

9. The composition for resist underlayer film formation according to claim 7, wherein the tellurium-containing compound is represented by the following formula (3A): 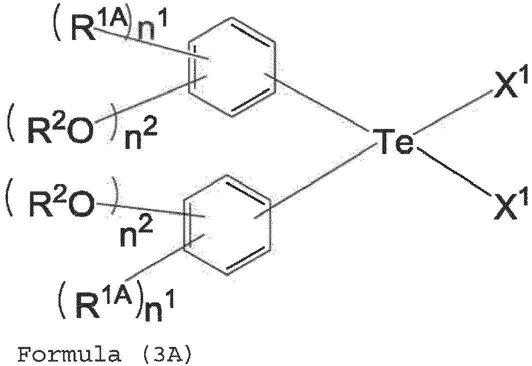 wherein R^{1A}, R², X¹, n¹, and n² are as defined in the above formula (2A).

10. The composition for resist underlayer film formation according to claim 9, wherein the tellurium-containing compound is represented by the following formula (4A): 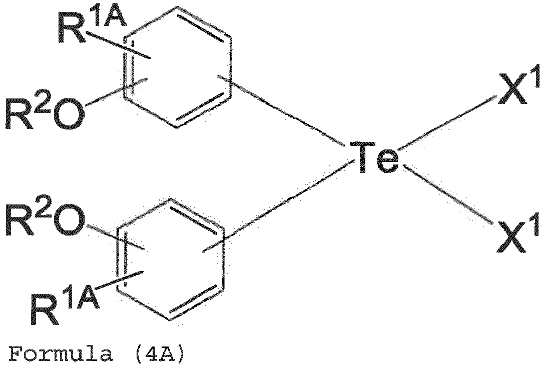 wherein R^{1A}, R², and X¹ are as defined in the above formula (3A).

11. The composition for resist underlayer film formation according to claim 6, wherein the tellurium-containing compound is represented by the following formula (2B): 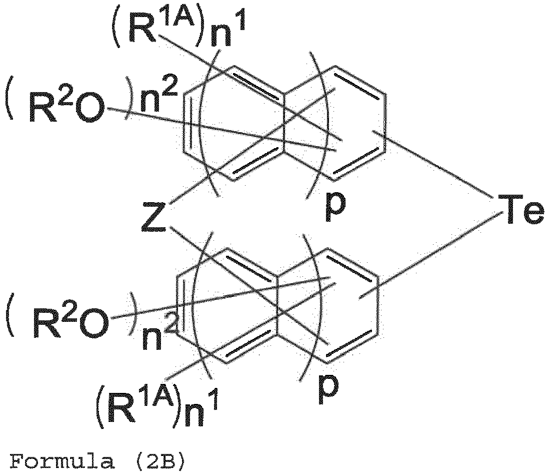 wherein Z, R^{1A}, R², p, n¹, and n² are as defined in the above formula (1B).

12. The composition for resist underlayer film formation according to claim 10, wherein the tellurium-containing compound is represented by the following formula (2B'): 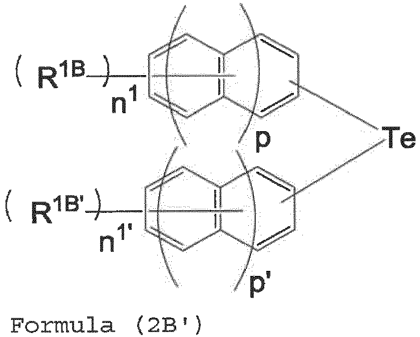 wherein R^{1B} and R^{1B'} are each independently an alkyl group, an aryl group, an alkenyl group, a halogen atom, a hydroxy group or a group in which a hydrogen atom of a hydroxy group is substituted with an acid crosslinking reactive group or an acid dissociation reactive group; n¹ and n^{1'} are as defined as n¹ in the above formula (2B); p and p' are as defined as p in the above formula (2B); and members in at least one combination selected from R^{1B} and R^{1B'}, n¹ and n^{1'}, p and p', and the substitution position of R^{1B} and the substitution position of R^{1B'} differ from each other.

13. The composition for resist underlayer film formation according to claim 11, wherein the tellurium-containing compound is represented by the following formula (3B): 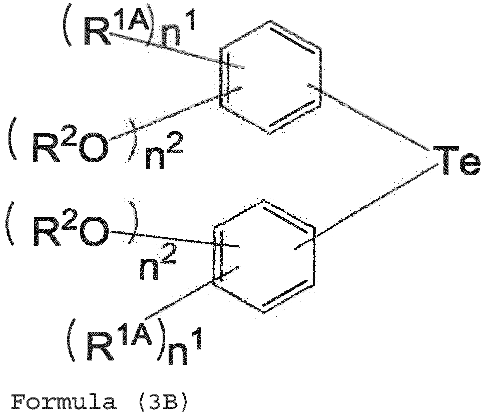 wherein R^{1A}, R², n¹, and n² are as defined in the above formula (2B).

14. The composition for resist underlayer film formation according to claim 13, wherein the tellurium-containing compound is represented by the following formula (4B): 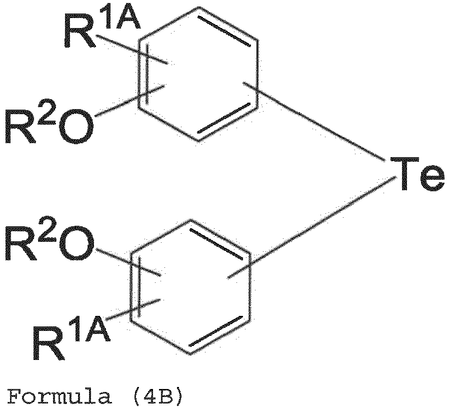 wherein R¹, R², and X¹ are as defined in the above formula (3B).

15. The composition for resist underlayer film formation according to any one of claims 5 to 7, 9 to 11, 13, and 14, wherein the tellurium-containing compound has at least one acid dissociation reactive group as R² in the above formula.

16. The composition for resist underlayer film formation according to any one of claims 5 to 7, 9 to 11, 13, and 14, wherein all of R² in the above formula in the tellurium-containing compound are hydrogen atoms.

17. The composition for resist underlayer film formation according to claim 1, wherein the tellurium-containing resin is a resin comprising a constitutional unit derived from a compound represented by the following formula (A-1) : 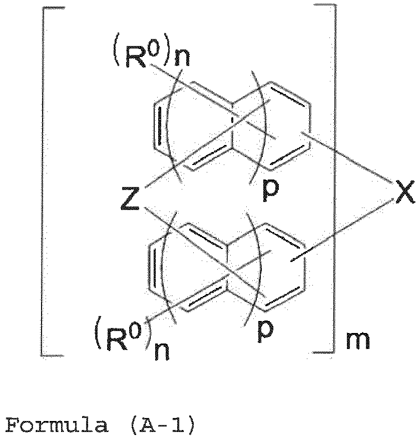 wherein X is a 2m-valent group of 0 to 60 carbon atoms containing tellurium; Z is an oxygen atom, a sulfur atom, or a non-crosslinked statea non-crosslinked state; each R⁰ is independently selected from the group consisting of a monovalent group containing an oxygen atom, a monovalent group containing a sulfur atom, a monovalent group containing a nitrogen atom, a hydrocarbon group, a halogen atom, and a combination thereof; m is an integer of 1 to 4; each p is independently an integer of 0 to 2; and each n is independently an integer of 0 to (5 + 2 × p).

18. The composition for resist underlayer film formation according to claim 1, wherein the tellurium-containing resin is a resin comprising a constitutional unit derived from a compound represented by the following formula (A-2) : 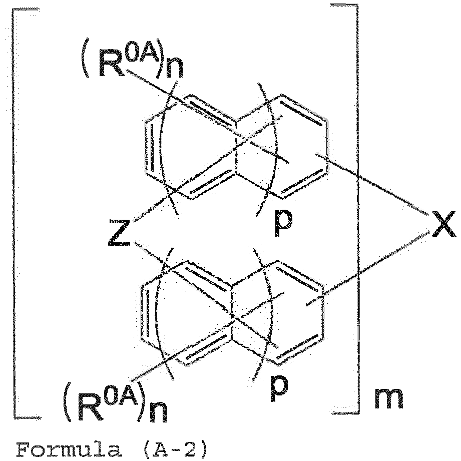 wherein X is a 2m-valent group of 0 to 60 carbon atoms containing tellurium; Z is an oxygen atom, a sulfur atom, a single bond, or a non-crosslinked state; each R^{0A} is independently selected from the group consisting of a hydrocarbon group, a halogen atom, a cyano group, a nitro group, an amino group, an alkyl group of 1 to 30 carbon atoms, an alkenyl group of 2 to 30 carbon atoms, an aryl group of 6 to 40 carbon atoms, a hydroxy group or a group in which a hydrogen atom of a hydroxy group is substituted with an acid crosslinking reactive group or an acid dissociation reactive group, and a combination thereof, wherein the alkyl group, the alkenyl group, and the aryl group each optionally have an ether bond, a ketone bond, or an ester bond; m is an integer of 1 to 4; each p is independently an integer of 0 to 2; and each n is independently an integer of 0 to (5 + 2 × p).

19. The composition for resist underlayer film formation according to claim 1, wherein the tellurium-containing resin is a resin comprising a constitutional unit derived from a compound represented by the following formula (A-3) : 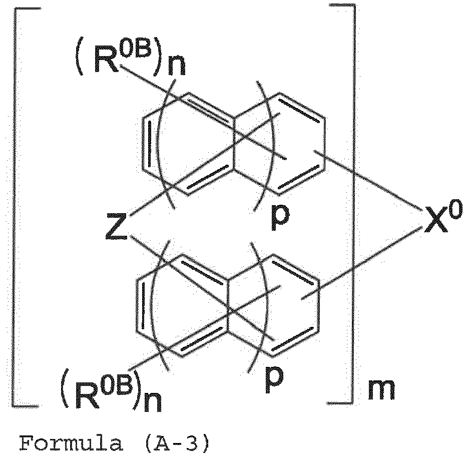 wherein X⁰ is a 2m-valent group of 0 to 30 carbon atoms containing tellurium; Z is an oxygen atom, a sulfur atom, or a non-crosslinked state; each R^{0B} is independently a monovalent group containing an oxygen atom, a monovalent group containing a sulfur atom, a monovalent group containing a nitrogen atom, a hydrocarbon group, or a halogen atom; m is an integer of 1 to 4; each p is independently an integer of 0 to 2; and each n is independently an integer of 0 to (5 + 2 × p).

20. The composition for resist underlayer film formation according to claim 1, wherein the tellurium-containing resin is a resin comprising a constitutional unit represented by the following formula (B1-M): 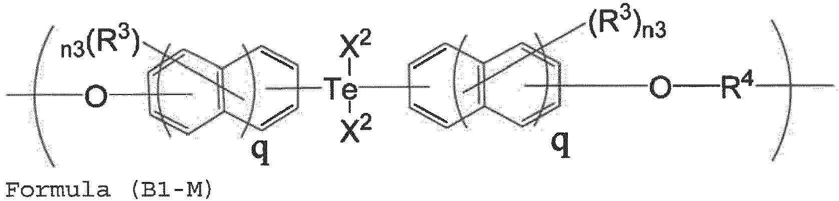 wherein each X² is independently a monovalent group containing an oxygen atom, a monovalent group containing a sulfur atom, a monovalent group containing a nitrogen atom, a hydrocarbon group, a hydrogen atom, or a halogen atom; each R³ is independently a monovalent group containing an oxygen atom, a monovalent group containing a sulfur atom, a monovalent group containing a nitrogen atom, a hydrocarbon group, or a halogen atom; q is an integer of 0 to 2; n³ is an integer of 0 to (4 + 2 × q); and R⁴ is a single bond or any structure represented by the following general formula (5): 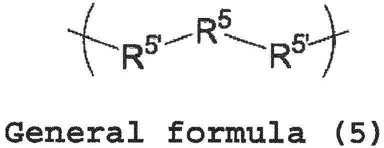 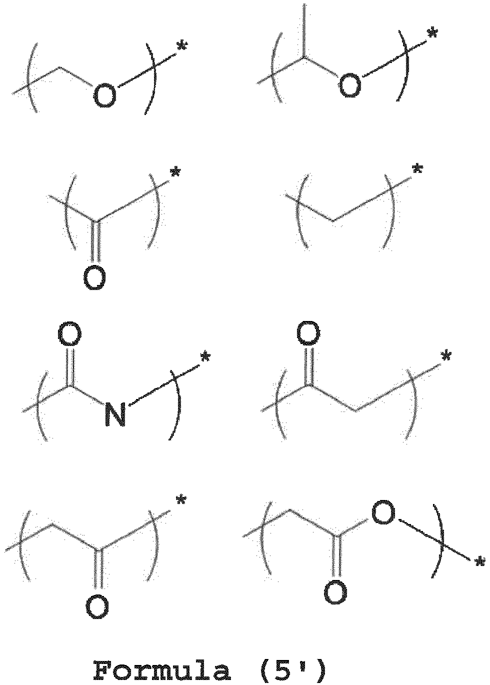 wherein R⁵ is a substituted or unsubstituted linear alkylene group of 1 to 20 carbon atoms, branched alkylene group of 3 to 20 carbon atoms, or cyclic alkylene group of 3 to 20 carbon atoms, or a substituted or unsubstituted arylene group of 6 to 20 carbon atoms; and each R^{5'} is independently any structure of the above formula (5') wherein * indicates that this portion is connected to R⁵.

21. The composition for resist underlayer film formation according to claim 20, wherein the R⁴ in the tellurium-containing resin is any structure represented by the above general formula (5).

22. The composition for resist underlayer film formation according to claim 20, wherein the tellurium-containing resin is a resin comprising a constitutional unit represented by the following formula (B2-M'): 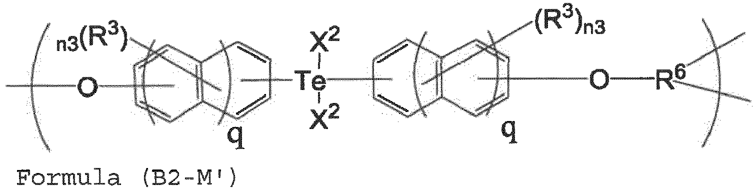 wherein X², R³, q, and n³ are as defined in the formula (B1-M); and R⁶ is any structure represented by the following general formula (6): 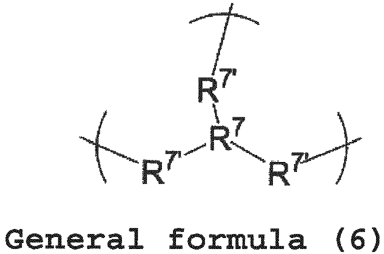 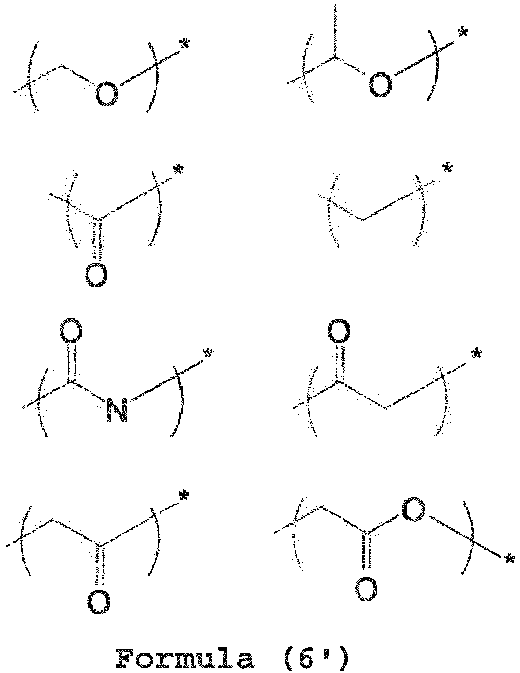 wherein R⁷ is a substituted or unsubstituted linear alkylene group of 1 to 20 carbon atoms, branched alkylene group of 3 to 20 carbon atoms, or cyclic alkylene group of 3 to 20 carbon atoms, or a substituted or unsubstituted arylene group of 6 to 20 carbon atoms; each R^{7'} is independently any structure of the above formula (6') wherein * indicates that this portion is connected to R⁷.

23. The composition for resist underlayer film formation according to claim 1, wherein the tellurium-containing resin is a resin comprising a constitutional unit represented by the following formula (Cl): 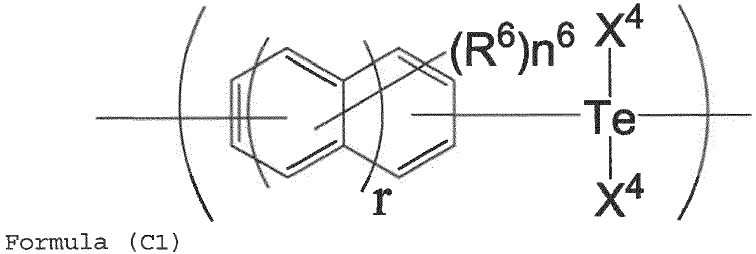 wherein each X⁴ is independently a monovalent group containing an oxygen atom, a monovalent group containing a sulfur atom, a monovalent group containing a nitrogen atom, a hydrocarbon group, a hydrogen atom, or a halogen atom; each R⁶ is independently a monovalent group containing an oxygen atom, a monovalent group containing a sulfur atom, a monovalent group containing a nitrogen atom, a hydrocarbon group, or a halogen atom; r is an integer of 0 to 2; and n⁶ is an integer of 2 to (4 + 2 × r) .

24. The composition for resist underlayer film formation according to claim 1, wherein the tellurium-containing resin is a resin comprising a constitutional unit represented by the following formula (B3-M): 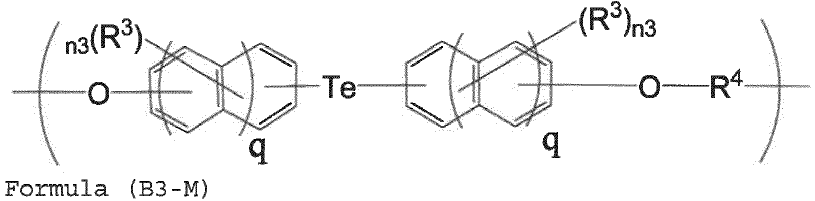 wherein each R³ is independently a monovalent group containing an oxygen atom, a monovalent group containing a sulfur atom, a monovalent group containing a nitrogen atom, a hydrocarbon group, or a halogen atom; q is an integer of 0 to 2; n³ is an integer of 0 to (4 + 2 × q); and R⁴ is a single bond or any structure represented by the following general formula (5): 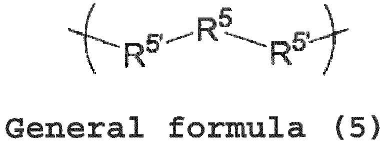 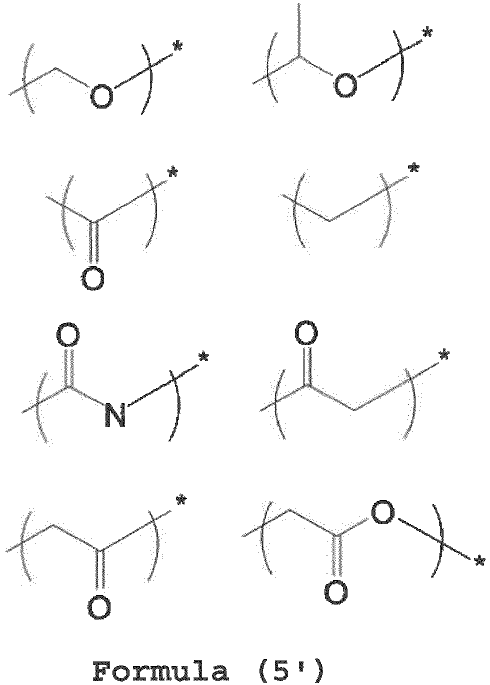 wherein R⁵ is a substituted or unsubstituted linear alkylene group of 1 to 20 carbon atoms, branched alkylene group of 3 to 20 carbon atoms, or cyclic alkylene group of 3 to 20 carbon atoms, or a substituted or unsubstituted arylene group of 6 to 20 carbon atoms; each R^{5'} is independently any structure of the above formula (5') wherein * indicates that this portion is connected to R⁵.

25. The composition for resist underlayer film formation according to claim 24, wherein the R⁴ in the tellurium-containing resin is any structure represented by the above general formula (5).

26. The composition for resist underlayer film formation according to claim 24, wherein the tellurium-containing resin is a resin comprising a constitutional unit represented by the following formula (B4-M'): 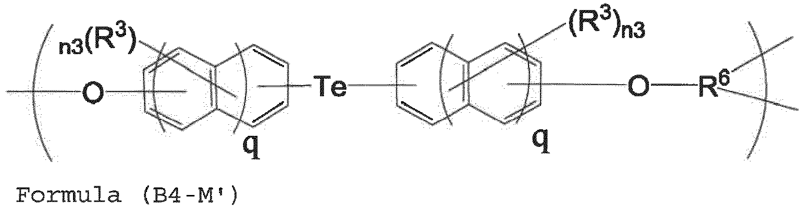 wherein R³, q, and n³ are as defined in the formula (B3-M) ; and R⁶ is any structure represented by the following general formula (6): 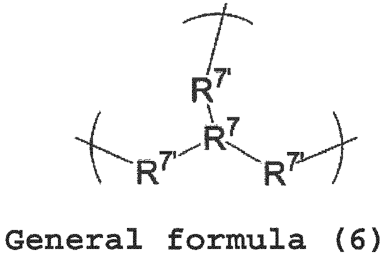 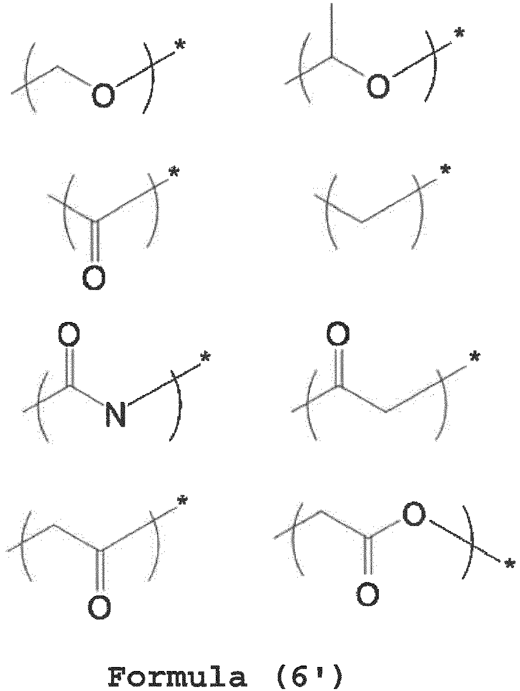 wherein R⁷ is a substituted or unsubstituted linear alkylene group of 1 to 20 carbon atoms, branched alkylene group of 3 to 20 carbon atoms, or cyclic alkylene group of 3 to 20 carbon atoms, or a substituted or unsubstituted arylene group of 6 to 20 carbon atoms; and each R^{7'} is independently any structure of the above formula (6') wherein * indicates that this portion is connected to R⁷.

27. The composition for resist underlayer film formation according to claim 1, wherein the tellurium-containing resin is a resin comprising a constitutional unit represented by the following formula (C2): 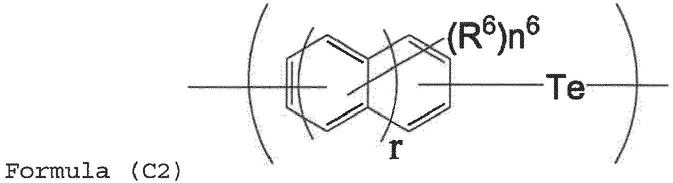 wherein each R⁶ is independently a monovalent group containing an oxygen atom, a monovalent group containing a sulfur atom, a monovalent group containing a nitrogen atom, a hydrocarbon group, or a halogen atom; r is an integer of 0 to 2; and n⁶ is an integer of 2 to (4 + 2 × r) .

28. A method for producing the composition for resist underlayer film formation according to any one of claims 1 to 27, comprising the step of reacting a tellurium halide with a substituted or unsubstituted phenol derivative in the presence of a basic catalyst to synthesize the tellurium-containing compound.

29. The composition for resist underlayer film formation according to any one of claims 1 to 28, further comprising a solvent.

30. The composition for resist underlayer film formation according to any one of claims 1 to 29, further comprising an acid generating agent.

31. The composition for resist underlayer film formation according to any one of claims 1 to 30, further comprising an acid crosslinking agent.

32. A resist underlayer film for lithography formed using the composition for resist underlayer film formation according to any one of claims 1 to 31.

33. A method for forming a pattern, comprising: forming a resist underlayer film on a substrate using the composition for resist underlayer film formation according to any one of claims 1 to 31; forming at least one photoresist layer on the resist underlayer film; and then irradiating a predetermined region of the photoresist layer with radiation for development.

34. A method for forming a pattern, comprising: forming a resist underlayer film on a substrate using the composition for resist underlayer film formation according to any one of claims 1 to 31; forming a resist intermediate layer film on the resist underlayer film using a resist intermediate layer film material; forming at least one photoresist layer on the resist intermediate layer film; then irradiating a predetermined region of the photoresist layer with radiation for development, thereby forming a resist pattern; then etching the resist intermediate layer film with the resist pattern as a mask; etching the resist underlayer film with the obtained intermediate layer film pattern as an etching mask; and etching the substrate with the obtained underlayer film pattern as an etching mask, thereby forming a pattern on the substrate.
